# EUROPEAN PATENT APPLICATION

(11) **EP 4 831 978 A1**
(43) Date of publication of application: **28.10.2026**
(21) Application number: 24955568.1
(22) Date of filing: 29.09.2024
(51) Int. Cl.: G09G 3/32, G11C 19/28

(54) **SHIFT REGISTER AND DRIVING METHOD THEREFOR, GATE DRIVING CIRCUIT, AND DISPLAY APPARATUS**

(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: ZHAO, Guowei, Beijing 100176 (CN); YAN, Zhuoran, Beijing 100176 (CN); GUO, Yonglin, Beijing 100176 (CN); WANG, Benlian, Beijing 100176 (CN); CHU, Xiaodong, Beijing 100176 (CN); ZHENG, Hai, Beijing 100176 (CN); LIU, Miao, Beijing 100176 (CN)
(74) Representative: Durán-Corretjer, S.L.P.
(86) International application number: PCT/CN2024/122391
(87) International publication number: WO 2026/065271

(57) **Abstract**

A shift register and a driving method therefor, a display substrate, and a display apparatus. The shift register comprises a shift sub-circuit and an output sub-circuit. The shift sub-circuit is configured to, under the control of at least one signal end of a signal input end (IN), a first clock signal end (CKl), a second clock signal end (CK2), and a third clock signal end (CK3), provide a signal of one signal end of a second power supply end (VGL) and the second clock signal end (CK2) to a second node (N2), and provide a signal of the signal input end (IN) to a third node (N3), and, under the control of signals of the second node (N2) and of the third node (N3), provide a signal of one signal end of a first power supply end (VGH) and the third clock signal end (CK3) to a cascade signal output end (Carry); and the output sub-circuit is configured to, under the control of a signal of at least one signal end of the second node (N2), the third node (N3), a first control signal end (Gl), a second control signal end (G2), the signal input end (IN), and a masking signal end (MS), provide a signal of one signal end of the first power supply end (VGH) and the third clock signal end (CK3) to a drive signal output end (GOUT).

## Description

### Technical Field

The present disclosure relates to, but is not limited to, the field of display technology, and more particularly, to a shift register, a drive method therefor, a gate drive circuit and a display apparatus.

### Background

An organic light emitting diode (OLED) and a quantum dot light emitting diode (QLED) are active light emitting display devices and have advantages of self-illumination, a wide viewing angle, a high contrast ratio, low power consumption, an extremely high reaction speed, lightness and thinness, flexibility, and a low cost, etc. With constant development of display technologies, a flexible display apparatus (Flexible Display) in which an OLED or a QLED is used as a light emitting device and signal control is performed through a Thin Film Transistor (TFT) has become a mainstream product in the field of display at present.

### Summary

The following is a summary of subject matter described in the present disclosure in detail. This summary is not intended to limit the protection scope of claims.

In a first aspect, the present disclosure provides a shift register including: a shift sub-circuit and an output sub-circuit;
the shift sub-circuit is electrically connected to a signal input terminal, a first clock signal terminal, a second clock signal terminal, a third clock signal terminal, a first power supply terminal, a second power supply terminal, a cascaded signal output terminal, a second node, and a third node, respectively, and is configured to provide a signal of one signal terminal of the second power supply terminal and the second clock signal terminal to the second node and a signal of the signal input terminal to the third node under the control of a signal of at least one signal terminal of the signal input terminal, the first clock signal terminal, the second clock signal terminal and the third clock signal terminal, and to provide a signal of one of the first power supply terminal and the third clock signal terminal to the cascaded signal output terminal under the control of signals from the second node and the third node;
the output sub-circuit is electrically connected to the second node, the third node, the signal input terminal, a first control signal terminal, a second control signal terminal, a masking signal terminal, the third clock signal terminal, the first power supply terminal, the second power supply terminal and a drive signal output terminal, respectively, and is configured to provide a signal of one signal terminal of the first power supply terminal and the third clock signal terminal to the drive signal output terminal under the control of a signal of at least one signal terminal of the second node, the third node, the first control signal terminal, the second control signal terminal, the signal input terminal and the masking signal terminal.

In an exemplary embodiment, the number of the shift registers is multiple, and multiple shift registers are cascaded;
a cascaded signal output terminal of at least one-stage shift register is electrically connected to a signal input terminal of the at least one-stage shift register and a first control signal terminal of the at least one-stage shift register, respectively;
the shift register where the signal input terminal connected to the cascaded signal output terminal of the at least one-stage shift register is located and the shift register where the connected first control signal terminal is located are shift registers of different stages.

In an exemplary embodiment, the shift sub-circuit includes: a first transistor to an eighth transistor and a first capacitor to a third capacitor, and at least one of the first capacitor to the third capacitor includes a first plate and a second plate;
a control electrode of the first transistor is electrically connected with the first clock signal terminal, a first electrode of the first transistor is electrically connected with the signal input terminal, and a second electrode of the first transistor is electrically connected with a first node;
a control electrode of the second transistor is electrically connected with the first node, a first electrode of the second transistor is electrically connected with the second clock signal terminal, and a second electrode of the second transistor is electrically connected with a second node;
a control electrode of the third transistor is electrically connected with the second clock signal terminal, a first electrode of the third transistor is electrically connected with the second power supply terminal, and a second electrode of the third transistor is electrically connected with the second node;
a control electrode of the fourth transistor is electrically connected with the second node, a first electrode of the fourth transistor is electrically connected with the first power supply terminal, and a second electrode of the fourth transistor is electrically connected with the cascaded signal output terminal;
a control electrode of the fifth transistor is electrically connected with the third node, a first electrode of the fifth transistor is electrically connected with the third clock signal terminal, and a second electrode of the fifth transistor is electrically connected with the cascaded signal output terminal;
a control electrode of the sixth transistor is electrically connected with the second node, a first electrode of the sixth transistor is electrically connected with the first power supply terminal, and a second electrode of the sixth transistor is electrically connected with the fourth node;
a control electrode of the seventh transistor is electrically connected with the third clock signal terminal, a first electrode of the seventh transistor is electrically connected with the fourth node, and a second electrode of the seventh transistor is electrically connected with the first node;
a control electrode of the eighth transistor is electrically connected with the second power supply terminal, a first electrode of the eighth transistor is electrically connected with the first node, and a second electrode of the eighth transistor is electrically connected with the third node;
a first plate of the first capacitor is electrically connected to the second node, and a second plate of the first capacitor is electrically connected to the first power supply terminal;
a first plate of the second capacitor is electrically connected with the third node, and a second plate of the second capacitor is electrically connected with the cascaded signal output terminal; and
a first plate of the third capacitor is electrically connected with the first power supply terminal, and a second plate of the third capacitor is electrically connected with the cascaded signal output terminal.

In an exemplary embodiment, the output sub-circuit includes a node control sub-circuit and an output control sub-circuit;
the node control sub-circuit is electrically connected to the second node, the third node, a fifth node, a sixth node, the signal input terminal, the masking signal terminal, the first control signal terminal, the second control signal terminal and the second power supply terminal, respectively, and is configured to provide a signal of the second node to the fifth node and a signal of the third node to the sixth node under the control of a signal of at least one signal terminal of the first control signal terminal, the second control signal terminal, the signal input terminal, the masking signal terminal and the second power supply terminal;
the output control sub-circuit is electrically connected to the fifth node, the sixth node, the first power supply terminal, the third clock signal terminal and the drive signal output terminal, respectively, and is configured to provide a signal of the first power supply terminal to the drive signal output terminal under the control of a signal of the fifth node, and provide a signal of the third clock signal terminal to the drive signal output terminal under the control of a signal of the sixth node.

In an exemplary embodiment, the output control sub-circuit includes: a ninth transistor, a tenth transistor, a fourth capacitor, a fifth capacitor, and a sixth capacitor, at least one of the fourth capacitor to the sixth capacitor including: a first plate and a second plate;
a control electrode of the ninth transistor is electrically connected with the fifth node, a first electrode of the ninth transistor is electrically connected with the first power supply terminal, and a second electrode of the ninth transistor is electrically connected with the drive signal output terminal;
a control electrode of the tenth transistor is electrically connected with the sixth node, a first electrode of the tenth transistor is electrically connected with the third clock signal terminal, and a second electrode of the tenth transistor is electrically connected with the drive signal output terminal;
a first plate of the fourth capacitor is electrically connected with the fifth node, and a second plate of the fourth capacitor is electrically connected with the first power supply terminal;
a first plate of the fifth capacitor is electrically connected with the sixth node, and a second plate of the fifth capacitor is electrically connected with the drive signal output terminal;
a first plate of a sixth capacitor is electrically connected with the sixth node, and a second plate of the sixth capacitor is electrically connected with the seventh node.

In an exemplary embodiment, the node control sub-circuit includes an eleventh transistor to a fifteenth transistor;
a control electrode of the eleventh transistor is electrically connected with the seventh node, a first electrode of the eleventh transistor is electrically connected with the second node, and a second electrode of the eleventh transistor is electrically connected with the fifth node;
a control electrode of the twelfth transistor is electrically connected with the seventh node, a first electrode of the twelfth transistor is electrically connected with the third node, and a second electrode of the twelfth transistor is electrically connected with the sixth node;
a control electrode of the thirteenth transistor is electrically connected with the first control signal terminal, a first electrode of the thirteenth transistor is electrically connected with the seventh node, and a second electrode of the thirteenth transistor is electrically connected with the eighth node;
a control electrode of the fourteenth transistor is electrically connected with the signal input terminal, a first electrode of the fourteenth transistor is electrically connected with the masking signal terminal, and a second electrode of the fourteenth transistor is electrically connected with the eighth node;
a control electrode of the fifteenth transistor is electrically connected with the second control signal terminal, a first electrode of the fifteenth transistor is electrically connected with the second power supply terminal, and a second electrode of the fifteenth transistor is electrically connected with the seventh node.

In a second aspect, the present disclosure further provides a display substrate including a display area and a non-display area surrounding at least one side of the display area, wherein the display substrate includes a first gate drive circuit located in the non-display area, and the first gate drive circuit includes a plurality of cascaded first shift registers, and the first shift registers are the above shift registers.

In an exemplary embodiment, at least one-stage first shift register of the plurality of cascaded first shift registers includes: a second capacitor and a third capacitor, the second capacitor and the third capacitor including: a first plate and a second plate;
the second plate of the second capacitor and the second plate of the third capacitor of the at least one-stage first shift register are a same plate.

In an exemplary embodiment, a cascaded signal output terminal of an nth stage first shift register is electrically connected to a signal input terminal of an (n+X)-th stage first shift register and a first control signal terminal of an (n+Y)-th stage first shift register, respectively, 1≤n≤N, N is a total number of stages of the first shift register, X<Y.

In an exemplary embodiment, the display substrate further includes: a plurality of cross-stage connection lines located in the non-display area;
one of the plurality of cross-stage connection lines is electrically connected to a cascaded signal output terminal of at least one-stage first shift register, a signal input terminal of at least one-stage first shift register, and a first control signal terminal of at least one-stage first shift register, respectively;
at least two shift registers among the shift register where the cascaded signal output terminal connected with the same cross-stage connection line is located, the shift register where the connected signal input terminal is located and the shift register where the connected first control signal terminal is located are shift registers of different stages.

In an exemplary embodiment, the cross-stage connection line includes: a first cross-stage connection portion, a second cross-stage connection portion, and a third cross-stage connection portion, wherein at least one connection portion of the first cross-stage connection portion, the second cross-stage connection portion, and the third cross-stage connection portion at least partially extends along a second direction;
the second cross-stage connection portion is electrically connected to the first cross-stage connection portion and the third cross-stage connection portion, respectively, and at least two of the first cross-stage connection portion, the second cross-stage connection portion, and the third cross-stage connection portion are disposed in different layers.

In an exemplary embodiment, at least one-stage first shift register includes: a first transistor, a thirteenth transistor, a fourteenth transistor, a second capacitor and a third capacitor, the second capacitor and the third capacitor including: a first plate and a second plate, wherein a first electrode of the first transistor and a control electrode of the fourteenth transistor are electrically connected with a signal input terminal of the first shift register, respectively, a control electrode of the thirteenth transistor is electrically connected with a first control signal terminal of the first shift register, and the second plate of the second capacitor and the second plate of the third capacitor are electrically connected with a cascaded signal output terminal of the first shift register, respectively;
for a cross-stage connection line electrically connected to the cascaded signal output terminal of the nth stage first shift register and the signal output terminal of the (n+X)-th stage first shift register and connected to the first control signal terminal of an (n+Y)-th stage first shift register, the first cross-stage connection portion is electrically connected to the second plate of the second capacitor and the second plate of the third capacitor of the nth stage first shift register, and the second cross-stage connection portion, respectively, and the third cross-stage connection portion is electrically connected to the first electrode of the first transistor and the control electrode of the fourteenth transistor of the (n+X)-th stage first shift register, the control electrode of the thirteenth transistor of the (n+Y)-th stage first shift register, and the second cross-stage connection portion, respectively.

In an exemplary embodiment, at least one-stage first shift register of the plurality of cascaded first shift registers includes: a second capacitor including a first plate and a second plate;
for the cross-stage connection line connected to the cascaded signal output terminal of the nth stage first shift register, the first cross-stage connection portion and the second plate of the second capacitor of the nth stage first shift register are of an integral structure.

In an exemplary embodiment, the display substrate further includes: a base substrate and a drive circuit layer disposed on the base substrate, wherein the first gate drive circuit is disposed on the drive circuit layer, the drive circuit layer including: a semiconductor layer, a first conductive layer, a second conductive layer, a third conductive layer and a fourth conductive layer sequentially stacked on the base substrate, the at least one-stage first shift register including: at least one transistor and at least one capacitor, the at least one transistor including: an active pattern, a control electrode, a first electrode and a second electrode, and the at least one capacitor including: a first plate and a second plate;
the semiconductor layer includes: the active pattern of the at least one transistor located in the at least one-stage first shift register;
the first conductive layer includes: the control electrode of the at least one transistor and the first plate of the at least one capacitor located in the at least one-stage first shift register;
the second conductive layer includes: the second plate of the at least one capacitor located in the at least one-stage first shift register and a first cross-stage connection portion of at least one of the plurality of cross-stage connection lines;
the third conductive layer includes: the first electrode and the second electrode of the at least one transistor located in the at least one-stage first shift register and a second cross-stage connection portion of at least one of the plurality of cross-stage connection lines;
the fourth conductive layer includes: a third cross-stage connection portion of at least one of the plurality of cross-stage connection lines.

In an exemplary embodiment, at least one first shift register includes: a first transistor, an eleventh transistor, a fourteenth transistor, and a fifteenth transistor;
an orthographic projection of the first cross-stage connection portion of the at least one of the plurality of cross-stage connection lines on the base substrate at least partially overlaps with an orthographic projection of the first electrode of the first transistor of the at least one-stage first shift register on the base substrate;
an orthographic projection of the second cross-stage connection portion of the at least one of the plurality of cross-stage connection lines on the base substrate at least partially overlaps with an orthographic projection of the control electrode of the eleventh transistor of the at least one-stage first shift register on the base substrate;
an orthographic projection of the third cross-stage connection portion of the at least one of the plurality of cross-stage connection lines on the base substrate at least partially overlaps with an orthographic projection of the control electrode of at least one of the thirteenth transistor and the fourteenth transistor of the at least one-stage first shift register on the base substrate.

In an exemplary embodiment, the display substrate further includes: a clock signal line group located in the non-display area, wherein the clock signal line group is disposed on the drive circuit layer and located in the fourth conductive layer;
the plurality of cross-stage connection lines are located on a side of the clock signal line group close to the display area;
the clock signal line group includes: a first clock signal line, a second clock signal line, a third clock signal line, and a fourth clock signal line arranged sequentially at a side close to the display area, and at least one signal line of the first clock signal line, the second clock signal line, the third clock signal line, and the fourth clock signal line at least partially extends along the second direction.

In an exemplary embodiment, a first clock signal terminal of a (4i-3)-th stage first shift register is electrically connected with the first clock signal line, a second clock signal terminal of the (4i-3)-th stage first shift register is electrically connected with the second clock signal line, and a third clock signal terminal of the (4i-3)-th stage first shift register is electrically connected with the third clock signal line. A first clock signal terminal of a (4i-2)-th stage first shift register is electrically connected with the second clock signal line, a second clock signal terminal of the (4i-2)-th stage first shift register is electrically connected with the third clock signal line, and a third clock signal terminal of the (4i-2)-th stage first shift register is electrically connected with the fourth clock signal line. A first clock signal terminal of a (4i-1)-th stage first shift register is electrically connected with the third clock signal line, a second clock signal terminal of the (4i-1)-th stage first shift register is electrically connected with the fourth clock signal line, and a third clock signal terminal of the (4i-1)-th stage first shift register is electrically connected with the first clock signal line. A first clock signal terminal of a 4i-th stage first shift register is electrically connected with the fourth clock signal line, a second clock signal terminal of the 4i-th stage first shift register is electrically connected with the first clock signal line, and a third clock signal terminal of the 4i-th stage first shift register is electrically connected with the second clock signal line.

In an exemplary embodiment, the at least one-stage first shift register includes: a first transistor, a second transistor, a sixth transistor, a seventh transistor, and an eighth transistor;
an orthographic projection of the clock signal line group on the base substrate at least partially overlaps with an orthographic projection of at least one of the first transistor, the second transistor, the sixth transistor, the seventh transistor, and the eighth transistor of the at least one-stage first shift register on the base substrate.

In an exemplary embodiment, the display substrate further includes: a power supply signal line group and a clock signal line group located in the non-display area, wherein the power supply signal line group and the clock signal line group are disposed on the drive circuit layer and located in the fourth conductive layer;
the power supply signal line group includes: two first power supply lines and two second power supply lines, the first power supply lines and the second power supply lines at least partially extending along the second direction;
a first second power supply line is located on a side of the clock signal line group away from the display area, a first first power supply line is located on a side of the clock signal line group close to the display area, a second second power supply line is located on a side of the first first power supply line close to the display area, a second first power supply line is located on a side of the second second power supply line close to the display area, and the plurality of cross-stage connection lines are located between the second second power supply line and the second first power supply line;
the first power supply lines are electrically connected to a first power supply terminal of at least one-stage first shift register, and the second power supply lines are electrically connected to a second power supply terminal of at least one-stage first shift register.

In an exemplary embodiment, the at least one-stage first shift register includes a third transistor, a fourth transistor, a fifth transistor, a ninth transistor, a tenth transistor, and a third capacitor;
an orthographic projection of the first first power supply line on the base substrate at least partially overlaps with orthographic projections of the fourth transistor and the fifth transistor of the at least one-stage first shift register on the base substrate, an orthographic projection of the first second power supply line on the base substrate at least partially overlaps with an orthographic projection of the third transistor of the at least one-stage first shift register on the base substrate, an orthographic projection of the second first power supply line on the base substrate at least partially overlaps with orthographic projections of the ninth transistor and the tenth transistor of the at least one-stage first shift register on the base substrate, and an orthographic projection of the second second power supply line on the base substrate at least partially overlaps with an orthographic projection of the third capacitor of the at least one-stage first shift register on the base substrate.

In an exemplary embodiment, the display substrate further includes: a scan initial signal line located in the non-display area, wherein the scan initial signal line is disposed on the drive circuit layer and located in the fourth conductive layer, the scan initial signal line at least partially extends along the second direction;
the scan initial signal line is located between the first second power supply line and the clock signal line group;
a signal input terminal of a first stage first shift register and a signal input terminal of a second stage first shift register are electrically connected with the scan initial signal line, respectively;
the at least one-stage first shift register comprises: a second transistor;
an orthographic projection of the scan initial signal line on the base substrate at least partially overlaps with an orthographic projection of the second transistor of the at least one-stage first shift register on the base substrate.

In an exemplary embodiment, the power supply signal line group further includes: a third power supply line at least partially extending along the second direction;
the third power supply line is located between the first first power supply line and the second second power supply line;
the display area is provided with a light-emitting device, and the third power supply line is electrically connected with a second electrode of at least one light-emitting device;
the at least one-stage first shift register includes: a first capacitor and a second capacitor;
an orthographic projection of the third power supply line on the base substrate at least partially overlaps with orthographic projections of the first capacitor and the second capacitor of the at least one-stage first shift register on the base substrate;
a length of the third power supply line along the first direction is greater than a length of at least one of the first power supply line and the second power supply line along the first direction.

In an exemplary embodiment, the display substrate includes: a masking signal line located in the non-display area, wherein the masking signal line is disposed on the drive circuit layer and located in the fourth conductive layer, the masking signal line at least partially extends along the second direction;
the masking signal line is located on a side of the power supply signal line group close to the display area;
the masking signal line is electrically connected with a masking signal terminal of the at least one-stage first shift register;
the at least one-stage first shift register includes: a fourth capacitor and a fifth capacitor;
an orthographic projection of the masking signal line on the base substrate at least partially overlaps with orthographic projections of the fourth capacitor and the fifth capacitor of the at least one-stage first shift register on the base substrate.

In an exemplary embodiment, the display substrate includes: a plurality of pixel initial signal lines located in the non-display area; at least one signal line of the plurality of pixel initial signal lines is disposed on the drive circuit layer and is located in the fourth conductive layer, and the at least one signal line of the plurality of pixel initial signal lines at least partially extends along the second direction;
the plurality of pixel initial signal lines are located on a side of the masking signal line close to the display area;
an orthographic projection of one of the plurality of pixel initial signal lines on the base substrate at least partially overlaps with orthographic projections of the fourth capacitor and the fifth capacitor of the at least one-stage first shift register on the base substrate;
a length of at least one signal line of the plurality of pixel initial signal lines along the first direction is greater than a length of the masking signal line along the first direction.

In an exemplary embodiment, the display substrate includes: a second gate drive circuit located in the non-display area, wherein the second gate drive circuit includes: a plurality of cascaded second shift registers, and the second shift register includes: a light-emitting signal output terminal;
the display area is provided with a plurality of pixel drive circuits, the pixel drive circuit including: a light-emitting transistor and a write transistor;
at least one-stage first shift register is electrically connected with the write transistor of at least one row of pixel drive circuits, and at least one-stage second shift register is electrically connected with the light-emitting transistor of at least one row of pixel drive circuits;
a second control signal terminal of at least one-stage first shift register is electrically connected with a signal output terminal of at least one-stage second shift register.

In a third aspect, the present disclosure further provides a display apparatus including the display substrate described above.

In a fourth aspect, the present disclosure further provides a drive method of a shift register, configured to drive the shift register described above.
the shift sub-circuit providing a signal of one of the second power supply terminal and the second clock signal terminal to the second node and a signal of the signal input terminal to the third node under the control of a signal of at least one signal terminal of the signal input terminal, the first clock signal terminal, the second clock signal terminal and the third clock signal terminal, and providing a signal of one of the first power supply terminal and the third clock signal terminal to the cascaded signal output terminal under the control of signals of the second node and the third node;
the output sub-circuit providing a signal of one of the first power supply terminal and the third clock signal terminal to the drive signal output terminal under the control of a signal of at least one signal terminal of the second node, the third node, the first control signal terminal, the second control signal terminal, the signal input terminal and the masking signal terminal.

After drawings and detailed description are read and understood, other aspects may be understood.

### Brief Description of Drawings

Accompanying drawings are used to provide an understanding of technical solutions of the present disclosure, and form a part of the specification. The accompanying drawings and embodiments of the present disclosure are adopted to explain the technical solutions of the present disclosure, and do not form limitations on the technical solutions of the present disclosure.
FIG. 1 is a schematic diagram of a structure of a display apparatus;
FIG. 2A is a first schematic diagram of a planar structure of a display substrate.
FIG. 2B is a second schematic diagram of a planar structure of a display substrate.
FIG. 2C is a third schematic diagram of a planar structure of a display substrate.
FIG. 3 is an equivalent circuit diagram of a pixel drive circuit;
FIG. 4 is an operational timing diagram of the pixel drive circuit provided in FIG. 3.
FIG. 5A is a schematic diagram of a structure of a shift register according to an embodiment of the present disclosure.
FIG. 5B is a schematic diagram of a structure of an output sub-circuit.
FIG. 6 is an equivalent circuit diagram of a shift register according to an exemplary embodiment.
FIG. 7 is an operational timing diagram of the shift sub-circuit in the shift register provided in FIG. 6;
FIG. 8 is an operational timing diagram of the output sub-circuit in the shift register provided in FIG. 6 in the refresh frame;
FIG. 9 is an operational timing diagram of the output sub-circuit in the shift register provided in FIG. 6 in a holding frame;
FIG. 10 is a schematic diagram of a structure of a display substrate provided by an embodiment of the present disclosure.
FIG. 11 is a schematic diagram of connection of a cross-stage connection line;
FIG. 12 is a schematic diagram of another structure of a display substrate.
FIG. 13 is a signal timing diagram of a clock signal line;
FIG. 14 is a schematic diagram after a pattern of a semiconductor layer is formed in FIG. 12.
FIG. 15 is a schematic diagram of a pattern of a first conductive layer in FIG. 12.
FIG. 16 is a schematic diagram after the pattern of the first conductive layer is formed in FIG. 12.
FIG. 17 is a schematic diagram of a pattern of a second conductive layer in FIG. 12.
FIG. 18 is a schematic diagram after the pattern of the second conductive layer is formed in FIG. 12.
FIG. 19 is a schematic diagram after a pattern of a third insulation layer is formed in FIG. 12;
FIG. 20 is a schematic diagram of a pattern of a third conductive layer in FIG. 12.
FIG. 21 is a schematic diagram after the pattern of the third conductive layer is formed in FIG. 12.
FIG. 22 is a schematic diagram after a pattern of a planarization layer is formed in FIG. 12.
FIG. 23 is a schematic diagram of a pattern of a fourth insulation layer in FIG. 12.
FIG. 24 is a schematic diagram after a pattern of a fourth insulation layer is formed in FIG. 12.

### Detailed Description

To make objectives, technical solutions, and advantages of the present disclosure clearer, the embodiments of the present disclosure will be described in detail below with reference to the accompanying drawings. It is to be noted that implementations may be implemented in multiple different forms. Those of ordinary skills in the art may easily understand such a fact that implementations and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict. In order to keep following description of the embodiments of the present disclosure clear and concise, detailed description of part of known functions and known components are omitted in the present disclosure. The drawings in the embodiments of the present disclosure relate only to the structures involved in the embodiments of the present disclosure, and other structures may be described with reference to conventional designs.

Scales of the drawings in the present disclosure may be used as a reference in actual processes, but are not limited thereto. For example, a width-length ratio of a channel, a thickness and spacing of various films, and a length and spacing of various signal lines along the first direction may be adjusted according to actual needs. A quantity of pixels in a display substrate and a quantity of sub-pixels in each pixel are not limited to numbers shown in the drawings. The drawings described in the present disclosure are schematic structural diagram only, and one implementation of the present disclosure is not limited to shapes, numerical values, or the like shown in the drawings.

Ordinal numerals "first", "second", "third" and the like in the specification are set not to form limits in numbers but only to avoid confusion between constituent elements.

In the specification, for convenience, expressions "central", "above", "below", "front", "back", "vertical", "horizontal", "top", "bottom", "inside", "outside" and the like for indicating directional or positional relationships are used to illustrate positional relationships between the constituent elements with reference to the accompanying drawings, not to indicate or imply that involved apparatus or elements are required to have specific orientations or are structured and operated in the specific orientations but only to easily describe the present specification and simplify the description, and thus should not be understood as limitations on the present disclosure. The positional relationships between the constituent elements may be changed as appropriate based on a direction according to which each constituent element is described. Therefore, appropriate replacements based on situations are allowed, which is not limited to the expressions in the specification.

In the specification, unless otherwise explicitly specified and defined, terms "mounting", "coupling", and "connection" should be understood in a broad sense. For example, a connection may be a fixed connection, or a detachable connection, or an integral connection; it may be a mechanical connection or an electrical connection; it may be a direct connection, or an indirect connection through a middleware, or an internal communication between two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode" are interchangeable in the specification.

In the specification, an "electrical connection" includes a case that constituent elements are connected together through an element with a certain electrical action. The "element with a certain electrical action" is not particularly limited as long as electrical signals between the connected constituent elements may be sent and received. Examples of the "element with a certain electrical action" not only include an electrode and a wiring, but also include a switching element such as a transistor, a resistor, an inductor, a capacitor, other elements with various functions, etc.

In the specification, "parallel" refers to a state in which an angle formed by two straight lines is above -10° and below 10°, and thus may include a state in which the angle is above -5° and below 5°. In addition, "perpendicular" refers to a state in which an angle formed by two straight lines is above 80° and below 100°, and thus may include a state in which the angle is above 85° and below 95°.

In the specification, a "film" and a "layer" are interchangeable. For example, a "conductive layer" may be replaced with a "conductive film" sometimes. Similarly, an "insulation film" may be replaced with an "insulating layer" sometimes.

In the specification, "disposed in a same layer" adopted refers to a structure formed by patterning two (or more than two) structures through a same patterning process, and their materials may be the same or different. For example, materials of precursors for forming multiple structures disposed in a same layer are the same, and materials finally formed may be the same or different.

A triangle, rectangle, trapezoid, pentagon, or hexagon, or the like in the specification is not strictly defined, and it may be an approximate triangle, rectangle, trapezoid, pentagon, or hexagon, or the like. There may be some small deformations caused by tolerance, and there may be a chamfer, an arc edge, deformation, etc.

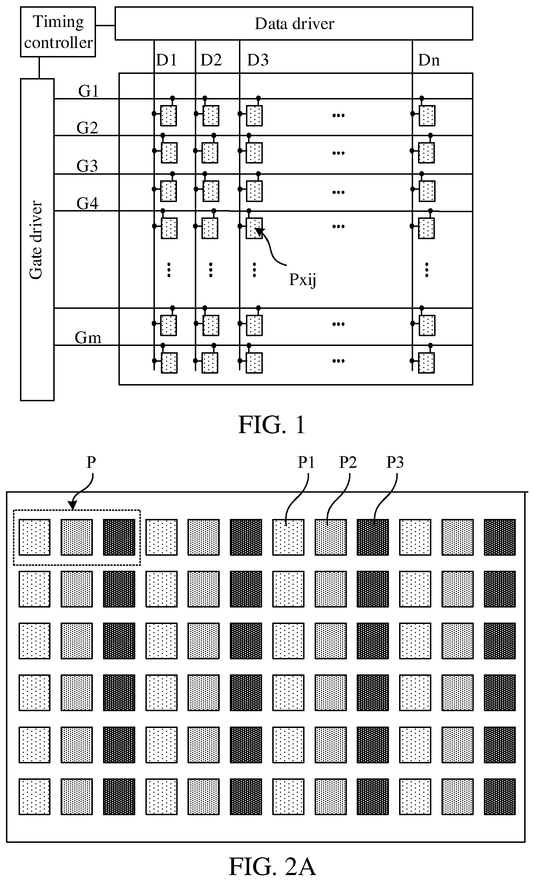

FIG. 1 is a schematic diagram of a structure of a display apparatus. As shown in FIG. 1, the display apparatus may include a timing controller, a data driver, a gate driver, and a pixel array. The timing controller is connected to the data driver and the gate driver respectively, the data driver is connected to multiple data signal lines (D1 to Dn) respectively, and the gate driver is connected to multiple gate lines (G1 to Gm) respectively. The pixel array may include a plurality of sub-pixels Pxij, wherein i and j may be natural numbers. At least one sub-pixel Pxij may include a circuit unit and a light emitting device connected with the circuit unit. The circuit unit may include a pixel drive circuit, and the pixel drive circuit may be connected with a gate line and a data signal line, respectively.

In an exemplary implementation, the timing controller may provide the data driver with a grayscale value and a control signal which are suitable for a specification of the data driver, provide the scanning driver with a clock signal and a scanning start signal and the like which are suitable for a specification of the scanning driver, and provide the light emitting driver with a clock signal and an emission stop signal and the like which are suitable for a specification of the light emitting driver. The data driver may generate data voltages to be provided to the data signal lines D1, D2, D3, ..., and Dn using the grayscale value and the control signal that are received from the timing controller. For example, the data driver may sample the grayscale value using the clock signal and apply a data voltage corresponding to the grayscale value to the data signal lines D1 to Dn by taking a pixel row as a unit, wherein n may be a natural number.

In an exemplary implementation, the gate driver may generate a scan signal to be provided to the gate lines G1, G2, G3, ..., to Gm by receiving the clock signal, a gate start signal, and the like from the timing controller. For example, the scan driver may sequentially provide a scan signal with an on-level pulse to the gate lines G1 to Gm. For example, the gate driver may be constructed in a form of a shift register and may generate a scan signal in a manner in which a scan start signal provided in a form of an on-level pulse is transmitted to a next-stage circuit sequentially under control of the clock signal, wherein m may be a natural number.

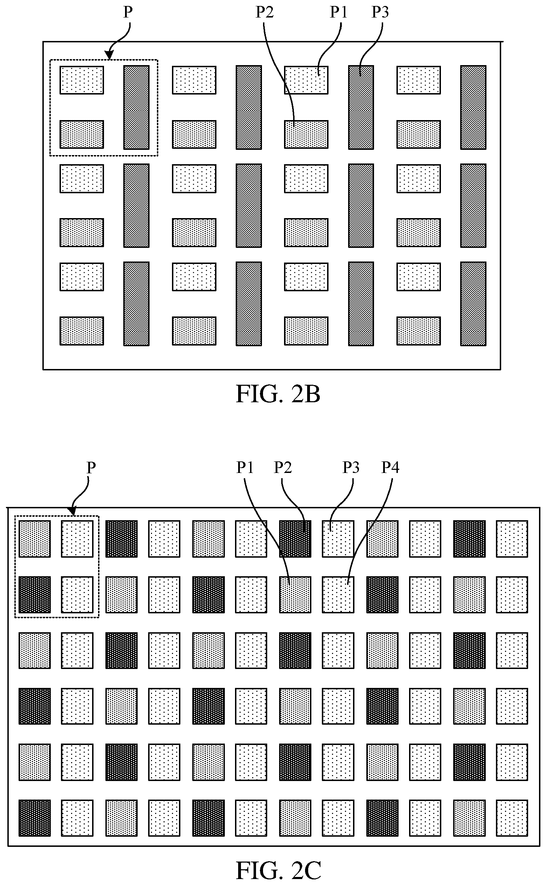

FIG. 2A is a first schematic diagram of a planar structure of a display substrate, FIG. 2B is a second schematic diagram of a planar structure of a display substrate, and FIG. 2C is a third schematic diagram of a planar structure of a display substrate. As shown in FIGS. 2A to 2C, the display substrate may include multiple pixel units P arranged in a matrix, at least one of the multiple pixel units P includes a first sub-pixel P1 emitting light of a first color, a second sub-pixel P2 emitting light of a second color, and a third sub-pixel P3 emitting light of a third color. The first sub-pixel P1, the second sub-pixel P2, and the third sub-pixel P3 each include a pixel drive circuit and a light emitting device. Pixel drive circuits in the first sub-pixel P1, the second sub-pixel P2, and the third sub-pixel P3 are connected with a gate line and a data signal line respectively, and a pixel drive circuit is configured to receive a data voltage transmitted by the data signal line and output a corresponding current to the light emitting device under control of the gate line. Light emitting devices in the first sub-pixel P1, the second sub-pixel P2, and the third sub-pixel P3 are respectively connected to a pixel drive circuit of a sub-pixel in which a light emitting device is located, and the light emitting device is configured to emit light with corresponding brightness in response to a current output by the pixel drive circuit of the sub-pixel in which the light emitting device is located.

In an exemplary implementation, the first sub-pixel P1 may be a red (R) sub-pixel emitting red light, the second sub-pixel P2 may be a blue (B) sub-pixel emitting blue light, and the third sub-pixel P3 may be a green (G) sub-pixel emitting green light.

In an exemplary implementation, a sub-pixel may be in a shape of a rectangle, a rhombus, a pentagon, or a hexagon. Three sub-pixels may be arranged side by side horizontally, side by side vertically, or in a shape of a delta, the present disclosure is not limited thereto.

In an exemplary implementation, a pixel unit may include three sub-pixels, and the three sub-pixels may be arranged side by side horizontally, side by side vertically, or in a delta shape, and the present disclosure is not limited thereto. FIG. 2A and FIG. 2B are illustrated by taking a pixel unit including three sub-pixels as an example. The three sub-pixels in FIG. 2A are arranged side by side horizontally, and the three sub-pixels in FIG. 2B are arranged in a delta-shaped arrangement.

In an exemplary implementation, a pixel unit may include four sub-pixels, and the four sub-pixels may be arranged in a manner to stand side by side horizontally, in a manner to stand side by side vertically, or in a manner of forming a square, etc., which is not limited here in the present disclosure. FIG. 2C is illustrated by taking a case in which a pixel unit includes four sub-pixels and the four sub-pixels are arranged in a manner of forming a square as an example.

In an exemplary implementation, the pixel drive circuit may have a structure of 3T1C, 4T1C, 5T1C, 5T2C, 6T1C, 7T1C, or 8T1C, which is not limited in the present disclosure.

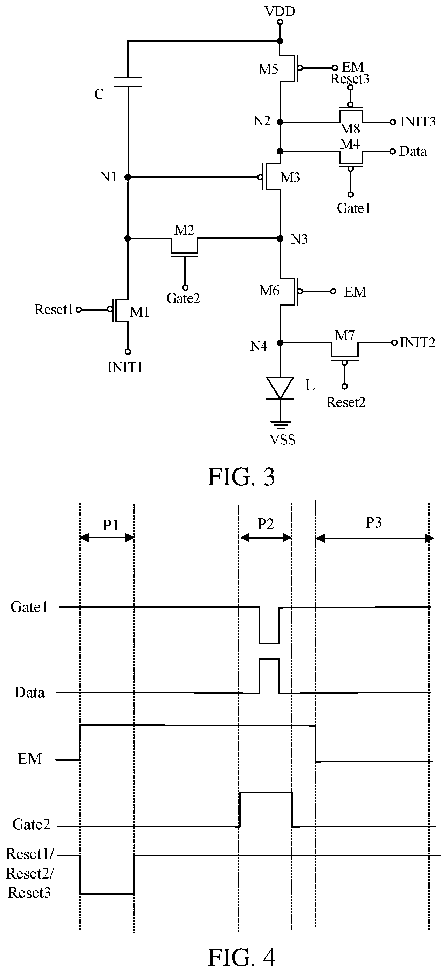

FIG. 3 is an equivalent circuit diagram of a pixel drive circuit. As shown in FIG. 3, the pixel drive circuit may include eight transistors (a first transistor M1 to an eighth transistor M8), and one capacitor C. Herein, a gate electrode of the first transistor M1 is electrically connected to a first reset signal line Reset1, a first electrode of the first transistor M1 is electrically connected to an initial signal line INIT1, and a second electrode of the first transistor M1 is electrically connected to a first node N1 or a third node N3; a gate electrode of the second transistor M2 is electrically connected to a second scan signal line Gate2, a first electrode of the second transistor M2 is electrically connected to the first node N1, and a second electrode of the second transistor M2 is electrically connected to the third node N3; a gate electrode of the third transistor M3 is electrically connected to the first node N1, a first electrode of the third transistor M3 is electrically connected to a second node N2, and a second electrode of the third transistor M3 is electrically connected to the third node N3; a gate electrode of the fourth transistor M4 is electrically connected to a first scan signal line Gate1, a first electrode of the fourth transistor M4 is electrically connected to the data signal line Data, and a second electrode of the fourth transistor M4 is electrically connected to the second node N2; a gate electrode of the fifth transistor M5 is electrically connected to a light emitting signal line EM, a first electrode of the fifth transistor M5 is electrically connected to a high-level power supply line VDD, and a second electrode of the fifth transistor M5 is electrically connected to the second node N2; a gate electrode of the sixth transistor M6 is electrically connected to the light emitting signal line EM, and a first electrode of the sixth transistor M6 is electrically connected to the third node N3, and a second electrode of the sixth transistor M6 is electrically connected to a fourth node N4; a gate electrode of the seventh transistor M7 is electrically connected to a second reset signal line Reset2, a first electrode of the seventh transistor M7 is electrically connected to a second initial signal line INIT2, and a second electrode of the seventh transistor M7 is electrically connected to the fourth node N4; a gate electrode of the eighth transistor M8 is electrically connected to a third reset signal line Reset3, a first electrode of the eighth transistor M8 is electrically connected to a third initial signal line INIT3, and a second electrode of the eighth transistor M8 is electrically connected to the second node N2; a first plate of a capacitor C is electrically connected to the first node N1, and a second plate of the capacitor C is electrically connected to the high-level power supply line VDD. Fig. 3 illustrates an example in which the second electrode of the first transistor M1 is electrically connected with the first node N1.

In an exemplary implementation, the first initial signal line INIT1 may receive a first initial signal. The first transistor M1 may be referred to as a first initial transistor. The first transistor M1 writes the first initial signal into the first node N1 or the third node N3 under the control of a signal of the first reset signal line Reset1.

In an exemplary implementation, the second initial signal line INIT2 may receive a second initial signal. The seventh transistor M7 may be referred to as a second initial transistor. The seventh transistor M7 writes the second initial signal into the first electrode of the light emitting device L under the control of a signal of the second reset signal line Reset 2.

In an exemplary implementation, the third initial signal line INIT3 may receive a third initial signal. The eighth transistor M8 may be referred to as a second initial transistor. The eighth transistor M8 writes the third initial signal into the second node N2 under the control of a signal of the third reset signal line Reset3.

In an exemplary implementation, the pixel drive circuit may include at least one transistor of the first transistor, the seventh transistor, and the eighth transistor, and FIG. 3 illustrates an example in which the pixel drive circuit may include the first transistor, the seventh transistor, and the eighth transistor.

In an exemplary implementation, the third transistor M3 may be referred to as a drive transistor. The connection mode of the third transistor in the present disclosure may improve the output saturation characteristic of the third transistor M3.

In an exemplary embodiment, the high-level power supply line VDD may receive a first power supply signal, the fifth transistor M5 may be referred to as a first light emitting transistor, and the fifth transistor M5 writes the first power supply signal into the second node N2 under the control of a signal of the light emitting signal line EM. The sixth transistor M6 may be referred to as a second light emitting transistor, and the sixth transistor M6 writes a drive signal output from the third node N3 into the fourth node N4 under the control of a signal of the light-emitting signal line EM.

In an exemplary implementation, the fifth transistor M5 and the sixth transistor M6 may be referred to as light emitting transistors.

In an exemplary embodiment, the signal received by the second reset signal line Reset2 may be the same as the signal received by the first scan signal line Gate1, or may be the same as the signal received by the first reset signal line Reset1, and the signal received by the third reset signal line Reset3 may be the same signal as the signal received by the second reset signal line Reset2.

In an exemplary implementation, for the first transistor M1 to the eighth transistors M8, low temperature poly-silicon thin film transistors may be used, or oxide thin film transistors may be used, or both of low temperature poly-silicon thin film transistors and oxide thin film transistors may be used. An active pattern of the low-temperature poly-silicon thin-film transistor is made of of Low-Temperature Poly-Silicon (LTPS for short), and an active pattern of the oxide thin-film transistor may be made of an oxide semiconductor (Oxide). The low-temperature poly silicon thin-film transistor has advantages such as high mobility and fast charging, and the oxide thin-film transistor has advantages such as a low leakage current. The low-temperature poly silicon thin-film transistor and the oxide thin-film transistor are integrated on one display substrate to form a LTPS + Oxide (LTPO) display substrate, and advantages of both the low-temperature poly silicon thin-film transistor and the oxide thin-film transistor may be utilized, which may achieve low frequency drive, reduce power consumption, and improve display quality.

In an exemplary embodiment, at least one transistor of the first transistor M1 and the second transistor M2 are of a transistor type opposite to at least one transistor of the third transistor M3 to the eighth transistor M8. For example, the first transistor M1 and the second transistor M2 may be N-type transistors, and the third transistor M3 to the eighth transistor M8 may be P-type transistors, or the second transistor M2 may be a N-type transistor, and the first transistor M1, and the third transistor M3 to the eighth transistor M8 may be P-type transistors.

In an exemplary embodiment, the N-type transistors may be oxide transistors, and the P-type transistors may be low temperature poly silicon transistors.

In an exemplary implementation, a voltage value of a signal of the first initial signal line INIT1 is constant and the signal is a Direct Current (DC) signal, and the voltage value of the signal of the first initial signal line INIT1 may be -3V.

In an exemplary implementation, a voltage value of a signal of the second initial signal line INIT2 is constant and the signal is a DC signal, and the voltage value of the signal of the second initial signal line INIT2 may be 0V.

In an exemplary implementation, a voltage value of a signal of the third initial signal line INIT3 is constant and the signal is a DC signal, and the voltage value of the signal of the third initial signal line INIT3 may be 0V.

In an exemplary implementation, the light emitting device L may be electrically connected with the fourth node N4 and the low-level power supply line VSS, respectively.

In an exemplary implementation, the high-level power line VDD continuously provides a high-level signal, and the low power line VSS continuously provides a low-level signal.

FIG. 4 is a working timing diagram of the pixel driving circuit provided in FIG. 3. Exemplary embodiments of the present disclosure are described below through an operation process of the pixel drive circuit illustrated in FIG. 3 in a display stage. Fig. 4 illustrates an example in which the second transistor M2 is a N-type transistor and the first transistor M1 and the third transistor M3 to the eighth transistor M8 are P-type transistors, and the signal received by the third reset signal line Reset3 and the signal received by the second reset signal line Reset 2 are the same as the signal received by the first reset signal line Reset1. The pixel drive circuit in Fig. 3 includes the first transistor M1 to the eighth transistors M8, one capacitor C, and eleventh signal lines (the data signal line Data, the first scan signal line Gate1, the second scan signal line Gate2, the first reset signal line Reset1, the second reset signal line Reset2, the third reset signal line Reset3, the first initial signal line INIT1, the second initial signal line INIT2, the third initial signal line INIT3, the light emitting signal line EM, and the high-level power supply line VDD).

As shown in conjunction with FIG. 3, and FIG. 4, the operation process of the pixel drive circuit may include following stages.

In a first stage P1, which is referred to as an initialization stage, the signals of the first reset signal line Reset1, the second reset signal line Reset2 and the third reset signal lineReset3 are high-level signals. The first transistor M1 is turned on, and then the signal of the first initial signal line INIT1 is written into the first node N1 or the third node N3 through the turned-on first transistor M1, to initialize (reset) the first node N1 or the third node N3, empty the pre-stored voltage inside it and complete the initialization. The seventh transistor M7 is turned on, and then the signal of the second initial signal line INIT2 is written into the fourth node N4 through the turned-on seventh transistor M7, to initialize (reset) the first electrode of the light-emitting device L, empty the pre-stored voltage inside it and complete the initialization. The eighth transistor M8 is turned on, and then the signal of the third initial signal line INIT3 is written into the second node N2 through the turned-on eighth transistor M8, to initialize (reset) the second node N2, empty the pre-stored voltage inside it and complete the initialization.

In a second stage P2, which is referred to as a data writing stage or a threshold compensation stage, the signal of the first scan signal line Gate1 is a low-level signal, the signal of the second scan signal line Gate2 is a high-level signal, and the data signal line Data outputs a data voltage. In this stage, because the first node N1 is a low-level signal, the third transistor M3 is turned on. The signal of the first scan signal line Gate1 is a low-level signal, and the fourth transistor M4 is turned on. The signal of the second scan signal line Gate2 is a high-level signal, and the second transistor M2 is turned on. The data voltage outputted from the data signal line Data is provided to the first node N1 through the turned-on fourth transistor M4, the second node N2, the turned-on third transistor M3, the third node N3, and the turned-on second transistor M2, and the difference between the data voltage outputted from the data signal line Data and the threshold voltage of the third transistor M3 is charged into the capacitor C until the voltage of the first node N1 is Vdata-|Vth|, wherein Vdata is the data voltage outputted from the data signal line Data and Vth is the threshold voltage of the third transistor M3.

In a third stage P3, which is referred to as a light emitting stage, the signal of the light emitting signal line EM is a low-level signal, and the fifth transistor M5 and the sixth transistor M6 are turned on. A power voltage output by the high-level power line VDD provides a driving voltage to the first electrode of the light emitting device L through the turned-on fifth transistor M5, the third transistor M3, and the sixth transistor M6, to drive the light emitting device L to emit light.

In a driving process of the pixel drive circuit, a driving current flowing through the third transistor M3 (drive transistor) is determined by a voltage difference between the gate electrode and the first electrode of the third transistor M3. Because a voltage of the first node N1 is Vdata-|Vth|, the drive current of the third transistor M3 is as follows. $I = K * {\left(Vgs-Vth\right)}^{2} = K * {\left[\left(Vdd-Vdata+\left|Vth\right|\right)-Vth\right]}^{2} = K * {\left(Vdd-Vdata\right)}^{2}$

Herein, I is the drive current flowing through the third transistor M3, that is, a drive current driving the light emitting device L, K is a constant, Vgs is the voltage difference between the gate electrode and the first electrode of the third transistor M3, and Vdd is the power supply voltage output by the high-level power supply line VDD.

In some exemplary implementation, the light emitting device L may include any one of an organic light emitting diode (OLED), a quantum dot light emitting diode, and an inorganic light emitting diode. For example, the light emitting device may be a micro-scale light emitting device, such as a Micro Light emitting Diode (Micro LED), a Mini Light emitting Diode (Mini LED), or a Micro Organic Light Emitting Diode (Micro OLED), which are not limited in the embodiments of the present disclosure. For example, taking a case in which the light emitting device L is an organic electroluminescent diode (OLED) as an example, the light emitting device may include a first electrode (for example, as an anode), an organic light emitting layer, and a second electrode (for example, as a cathode) which are stacked.

In an exemplary implementation, the organic emitting layer may include an Emitting Layer (EML), and any one or more of following: a Hole Injection Layer (HIL), a Hole Transport Layer (HTL), an Electron Block Layer (EBL), a Hole Block Layer (HBL), an Electron Transport Layer (ETL), and an Electron Injection Layer (EIL). In an exemplary implementation, one or more of hole injection layers, hole transport layers, electron block layers, hole block layers, electron transport layers and electron injection layers of all sub-pixels may be connected together to form a common connected layer. The light emitting layers of adjacent sub-pixels may overlap slightly with each other, or may be isolated from each other.

In an exemplary implementation, the gate driver includes at least one gate drive circuit. The quantity of gate drive circuits depends on the gate lines. Taking the display substrate of the pixel drive circuit provided in Fig. 3 as an example, the gate drive circuit includes a first scan drive circuit, a second scan drive circuit and a light emitting drive circuit. The first scan drive circuit is electrically connected to the first scan signal line, the first reset signal line, the second reset signal line and the third reset signal line. The second scan drive circuit is electrically connected to the second scan signal, and the light emitting drive circuit is electrically connected to the light emitting signal line.

In an exemplary implementation, any gate drive circuit in the gate driver may include a plurality of cascaded shift registers.

When the display product displays an image, the gate drive circuit generates a drive signal, and the pixel drive circuit initializes and writes data under the control of the drive signal, thus achieving display. When the display product perform displaying, it will refresh the screen in every frame, that is, the pixel drive circuit needs to initialize and write data in every display frame. However, for some special pictures (such as off-screen displayed picture, static picture, or infrequently updated picture, etc.), it is not necessary to initialize and write data by the pixel drive circuit in at least some display frames, and original brightness may be maintained through the pixel drive circuit with a low leakage current. A gate drive circuit of the display product generates a drive signal in every frame regardless of which picture is displayed, and repeatedly performing initialization and writing data by the pixel drive circuit, power consumption of the display product is relatively high.

For this, the present disclosure provides a shift register.

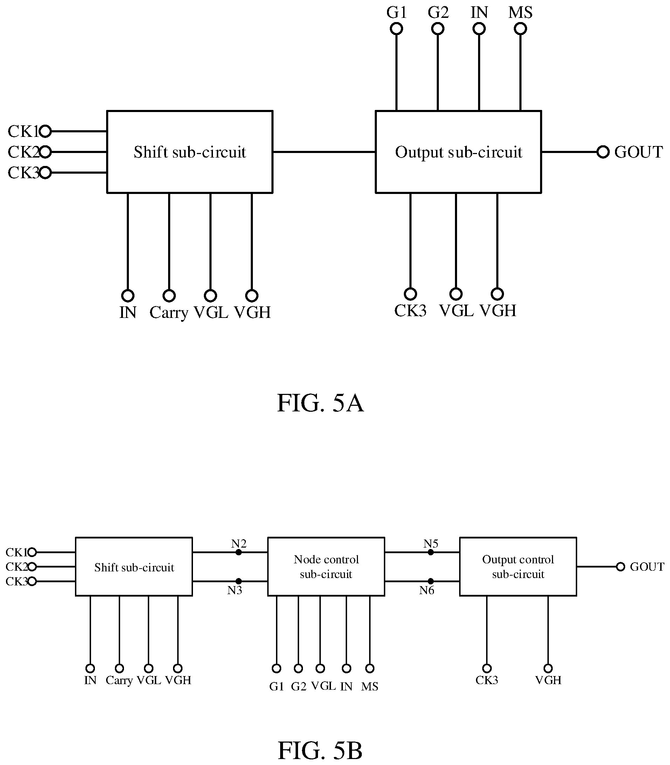

FIG. 5A is a schematic diagram of a structure of a shift register according to an embodiment of the present disclosure. As shown in FIG. 5A, the shift register provided by the embodiment of the present disclosure includes a shift sub-circuit and an output sub-circuit. The shift sub-circuit is electrically connected to a signal input terminal IN, a first clock signal terminal CK1, a second clock signal terminal CK2, a third clock signal terminal CK3, a first power supply terminal VGH, a second power supply terminal VGL, a cascaded signal output terminal Carry, the second node N2 and the third node N3, respectively, and is configured to provide a signal of one signal terminal of the second power supply terminal VGL and the second clock signal terminal CK2 to the second node N2 and provide a signal of the signal input terminal IN to the third node N3 under the control of a signal of at least one signal terminal of the signal input terminal IN, the first clock signal terminal CK1, the second clock signal terminal CK2 and the third clock signal terminal CK3, and to provide a signal of one signal terminal of the first power supply terminal VGH and the third clock signal terminal CK3 under the control of signals of the second node N2 and the third node N3;
the output sub-circuit is electrically connected to the second node N2, the third node N3, the signal input terminal IN, the first control signal terminal G1, the second control signal terminal G2, the masking signal terminal MS, the third clock signal terminal CK3, the first power supply terminal VGH, the second power supply terminal VGL, and the drive signal output terminal GOUT, respectively, and is configured to provide a signal of one signal terminal of the first power supply terminal VGH and the third clock signal terminal CK3 to the drive signal output terminal GOUT under the control of a signal of at least one signal terminal of the second node N2, the third node N3, the first control signal terminal G1, the second control signal terminal G1, the signal input terminal IN and the masking signal terminal MS.

By configuring a shift sub-circuit to output a cascaded signal provided for other stage shift registers to a cascaded signal output terminal, and configuring an output sub-circuit to output a drive signal provided for a pixel drive circuit to a drive signal output terminal, the present disclosure achieves that the cascaded signal and the drive signal are output by different sub-circuits, and may control whether to output a drive signal to the pixel drive circuit while ensuring normal output of the cascaded signal.

The shift register provided by an embodiment of the present disclosure, through cooperation of the shift sub-circuit and the output sub-circuit, can latch a control signal of a corresponding masking signal terminal in the output sub-circuit under the control of a signal of the first control signal terminal, the second control signal terminal and the signal input terminal according to a requirement of a refresh rate of the display area, which may achieve control of a signal output by the drive signal output terminal, and achieve different refresh rates in different regions, i.e., may achieve coexistence of high and low refresh rates in a same frame picture; and the embodiment of the present disclosure is not limited to achieving different refresh rates in a fixed region of the display panel, which can achieve dynamic refresh in any region, thereby reducing power consumption of the display panel.

In an exemplary embodiment, the quantity of shift registers is multiple, and multiple shift registers are cascaded. A cascaded signal output terminal Carry of at least one-stage shift register is electrically connected to the signal input terminal IN of at least one-stage shift register and the first control signal terminal G1 of at least one-stage shift register, respectively. Herein, the shift register where the signal input terminal IN connected to the cascaded signal output terminal Carry of at least one-stage shift register is located and the shift register where the connected first control signal terminal G1 is located are shift registers of different stages.

In an exemplary embodiment, FIG. 5B is a schematic diagram of a structure of an output sub-circuit. As shown in FIG. 5B, the output sub-circuit includes a node control sub-circuit and an output control sub-circuit. Herein, the node control sub-circuit is electrically connected to the second node N2, the third node N3, the fifth node N5, the sixth node N6, the signal input terminal IN, the masking signal terminal MS, the first control signal terminal G1, the second control signal terminal G2, and the second power supply terminal VGL, respectively, and is configured to provide a signal of the second node N2 to the fifth node N5 and a signal of the third node N3 to the sixth node N6 under the control of a signal of at least one signal terminal of the first control signal terminal G1, the second control signal terminal G2, the signal input terminal IN, the masking signal terminal MS, and the second power supply terminal VGL. The output control sub-circuit is electrically connected to the fifth node N5, the sixth node N6, the first power supply terminal VGH, the third clock signal terminal CK3, and the drive signal output terminal GOUT, respectively, and is configured to provide a signal of the first power supply terminal VGH to the drive signal output terminal GOUT under the control of a signal of the fifth node N5, and to provide a signal of the third clock signal terminal CK3 to the drive signal output terminal GOUT under the control of a signal of the sixth node N6.

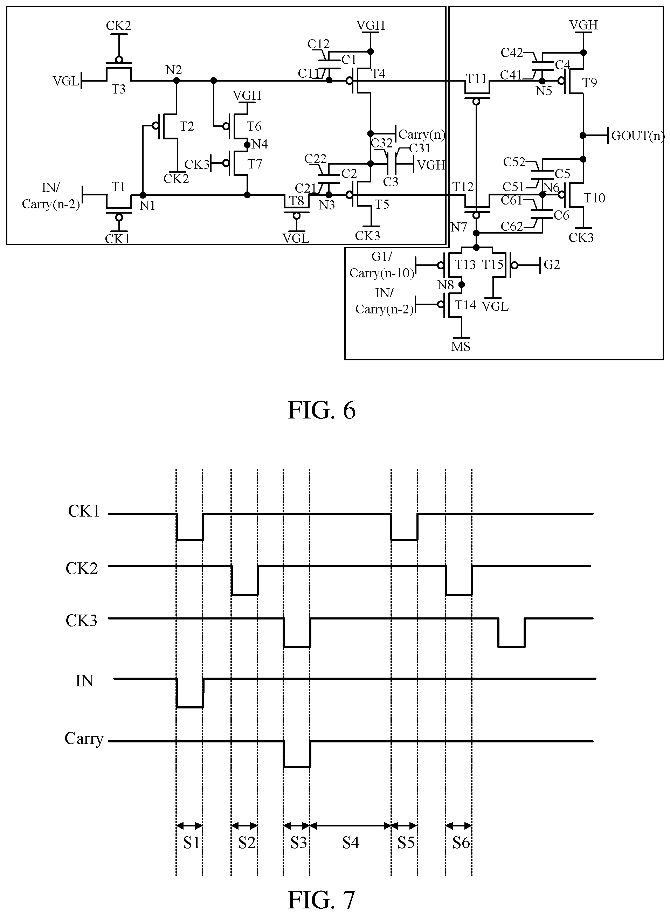

In an exemplary embodiment, FIG. 6 is an equivalent circuit diagram of a shift register according to an exemplary embodiment. As shown in FIG. 6, the shift sub-circuit may include a first transistor T1 to an eighth transistor T8 and a first capacitor C1 to a third capacitor C3, and at least one of the first capacitor C1 to the third capacitor C3 includes a first plate and a second plate.

As shown in FIG. 6, the control electrode of the first transistor T1 is electrically connected to the first clock signal terminal CK1, the first electrode of the first transistor T1 is electrically connected to the signal input terminal IN, and the second electrode of the first transistor T1 is electrically connected to the first node N1. The control electrode of the second transistor T2 is electrically connected to the first node N1, the first electrode of the second transistor T2 is electrically connected to the second clock signal terminal CK2, and the second electrode of the second transistor T2 is electrically connected to the second node N2. The control electrode of the third transistor T3 is electrically connected to the second clock signal terminal CK2, the first electrode of the third transistor T3 is electrically connected to the second power supply terminal VGL, and the second electrode of the third transistor T3 is electrically connected to the second node N2. The control electrode of the fourth transistor T4 is electrically connected to the second node N2, the first electrode of the fourth transistor T4 is electrically connected to the first power supply terminal VGH, and the second electrode of the fourth transistor T4 is electrically connected to the cascaded signal output terminal Carry. The control electrode of the fifth transistor T5 is electrically connected to the third node N3, the first electrode of the fifth transistor T5 is electrically connected to the third clock signal terminal CK3, and the second electrode of the fifth transistor T5 is electrically connected to the cascaded signal output terminal Carry. The control electrode of the sixth transistor T6 is electrically connected to the second node N2, the first electrode of the sixth transistor T6 is electrically connected to the first power supply terminal VGH, and the second electrode of the sixth transistor T6 is electrically connected to the fourth node N4. The control electrode of the seventh transistor T7 is electrically connected to the third clock signal terminal CK3, a first electrode of the seventh transistor T7 is electrically connected to the fourth node N4, and a second electrode of the seventh transistor T7 is electrically connected to the first node N1. The control electrode of the eighth transistor T8 is electrically connected to the second power supply terminal VGL, the first electrode of the eighth transistor T8 is electrically connected to the first node N1, and the second electrode of the eighth transistor T8 is electrically connected to the third node N3. The first plate C11 of the first capacitor C1 is electrically connected to the second node N2, and the second plate C12 of the first capacitor C1 is electrically connected to the first power supply terminal VGH. The first plate C21 of the second capacitor C2 is electrically connected to the third node N3, and the second plate C22 of the second capacitor C2 is electrically connected to the cascaded signal output terminal Carry. The first plate C31 of the third capacitor C3 is electrically connected to the first power supply terminal VGH, and the second plate C32 of the third capacitor C3 is electrically connected to the cascaded signal output terminal Carry.

In an exemplary implementation, the shift sub-circuit may have a circuit structure of 10T3C, 10T4C, 12T3C, 12T4C, 13T3C, 13T4C, 16T3C, or 16T4C, which is not limited in the present disclosure.

In an exemplary embodiment, the first capacitor C1 may ensure the stability of the signal of the second node N2, the second capacitor C2 may ensure the stability of the signal of the third node N3, and the third capacitor C3 may ensure the stability of the signal of the cascaded signal output terminal Carry.

In an exemplary embodiment, as shown in FIG. 6, the output control sub-circuit may include a ninth transistor T9, a tenth transistor T10, a fourth capacitor C4, a fifth capacitor C5, and a sixth capacitor C6, and at least one of the fourth capacitor C4 to the sixth capacitor C6 includes a first plate and a second plate. The control electrode of the ninth transistor T9 is electrically connected to the fifth node N5, the first electrode of the ninth transistor T9 is electrically connected to the first power supply terminal VGH, and the second electrode of the ninth transistor T9 is electrically connected to the drive signal output terminal GOUT. The control electrode of the tenth transistor T10 is electrically connected to the sixth node N6, the first electrode of the tenth transistor T10 is electrically connected to the third clock signal terminal CK3, and the second electrode of the tenth transistor T10 is electrically connected to the drive signal output terminal GOUT. The first plate C41 of the fourth capacitor C4 is electrically connected to the fifth node N5, and the second plate C42 of the fourth capacitor C4 is electrically connected to the first power supply terminal VGH. The first plate C51 of the fifth capacitor C5 is electrically connected to the sixth node N6, and the second plate C52 of the fifth capacitor C5 is electrically connected to the drive signal output terminal GOUT. The first plate C61 of the sixth capacitor C6 is electrically connected to the sixth node N6, and the second plate C62 of the sixth capacitor C6 is electrically connected to the seventh node N7.

In an exemplary embodiment, the fourth capacitor C4 may ensure the stability of the signal of the fifth node N5, and the fifth capacitor C5 and the sixth node C6 may ensure the stability of the signal of the sixth node N6.

In an exemplary embodiment, as shown in FIG. 6, the node control sub-circuit may include an eleventh transistor T11 to a fifteenth transistor T15. The control electrode of the eleventh transistor T11 is electrically connected to the seventh node N7, the first electrode of the eleventh transistor T11 is electrically connected to the second node N2, and the second electrode of the eleventh transistor T11 is electrically connected to the fifth node N5. The control electrode of the twelfth transistor T12 is electrically connected to the seventh node N7, the first electrode of the twelfth transistor T12 is electrically connected to the third node N3, and the second electrode of the twelfth transistor T12 is electrically connected to the sixth node N6. The control electrode of the thirteenth transistor T13 is electrically connected to the first control signal terminal G1, the first electrode of the thirteenth transistor T13 is electrically connected to the seventh node N7, and the second electrode of the thirteenth transistor T13 is electrically connected to the eighth node N8. The control electrode of the fourteenth transistor T14 is electrically connected to the signal input terminal IN, the first electrode of the fourteenth transistor T14 is electrically connected to the masking signal terminal MS, and the second electrode of the fourteenth transistor T14 is electrically connected to the eighth node N8. The control electrode of the fifteenth transistor T15 is electrically connected to the second control signal terminal G2, the first electrode of the fifteenth transistor T15 is electrically connected to the second power supply terminal VGL, and the second electrode of the fifteenth transistor T15 is electrically connected to the seventh node N7.

In an exemplary embodiment, the thirteenth transistor T13 and the fourteenth transistor T14 of the node control sub-circuit may be referred to as latch cells. When signals of the signal output terminal IN and the first control signal terminal G1 both are active level signals, the thirteenth transistor T13 and the fourteenth transistor T14 are turned on, and the signal of the masking signal terminal MS is written into the seventh node N7 and stored in the sixth capacitor C6, thereby controlling whether the eleventh transistor T11 and the twelfth transistor T12 are turned on. Whether the eleventh transistor T11 and the twelfth transistor T12 are turned on determines whether the signal of the second node N2 is written into the fifth node N5, and whether the signal of the third node N3 is written into the sixth node N6. Signals of the fifth node N5 and the sixth node N6 determine whether the signal of the first power supply terminal or the signal of the third clock signal terminal CK3 is written into the drive signal output terminal GOUT.

FIG. 6 shows an exemplary structure of a node control sub-circuit of an output control sub-circuit, and those skilled in the art readily appreciate that the implementation of the node control sub-circuit of the output control sub-circuit is not limited thereto.

In an exemplary implementation, transistors may be divided into N-type transistors and P-type transistors according to characteristics of the transistors. When a transistor is a P-type transistor, its turn-on voltage is a low-level voltage (e.g., 0V, -5V, -10V, or another suitable voltage), and its turn-off voltage is a high-level voltage (e.g., 5V, 10V, or another suitable voltage). When a transistor is an N-type transistor, its turn-on voltage is a high-level voltage (e.g., 5V, 10V, or another suitable voltage), and its turn-off voltage is a low-level voltage (e.g., 0V, -5V, -10V, or another suitable voltage).

In an exemplary implementation, at least one of the first transistor T1 to the eighth transistor T8 in the shift sub-circuit may be a P-type transistor.

In an exemplary implementation, at least one of the ninth transistor T9 to the fifteenth transistor T15 in the output sub-circuit may be a P-type transistor.

In an exemplary implementation, signals at any of the first clock signal terminal CK1 to the third clock signal terminal CK3 are square wave signals that repeat high and low voltages. Exemplarily, at least two of the first clock signal terminal CK1 to the third clock signal terminal CK3 may have a same cycle and may be configured as phase-shifted signals. A high voltage time period of a signal of any one of the first clock signal terminal CK1 to the third clock signal terminal CK3 in each cycle may be set to be longer than a low voltage time period.

In an exemplary implementation, the signal of the first power supply terminal VGH may be a high-level signal, for example, may be 5V to 10V; and the signal of the second power supply terminal VGL may be a low-level signal, for example, may be -10V to -5V.

In an exemplary implementation, the signal of the masking signal terminal MS may be a low-level signal or may be a high-level signal. When the signal of the masking signal terminal MS is a low-level signal, it may be -20V to -5V, and when the signal of the masking signal terminal MS is a high-level signal, it may be 5V to 20V.

In an exemplary implementation, any one of the first capacitor C1 to the sixth capacitor C6 may be a capacitance device made through a process, for example, the capacitance device may be achieved by making a special-purpose capacitance electrode, and a plurality of capacitance electrodes of a capacitor may be achieved through metal layers, semiconductor layers (e.g., doped polysilicon), or the like. Or, any one of the first capacitor C1 to the sixth capacitor C6 may be a parasitic capacitor between a plurality of devices, and may be achieved through a transistor itself and other devices or lines. A connection mode of any of the first capacitor C1 to the sixth capacitor C6 includes, but is not limited to, modes described above, and may be another suitable connection mode, as long as a level of a corresponding node may be stored. Here, exemplary implementations of the present disclosure are not limited thereto.

In an exemplary implementation, the drive signal output by the drive signal output terminal of the shift register is mainly used to control at least one transistor (for example, the fourth transistor M4) in the pixel drive circuit of the display area. When the display substrate is in a refresh frame, the drive signal output terminal outputs a high-level signal for a period of time, and outputs a low-level signal for the rest of the time period within one frame, and controls the fourth transistor M4 to be turned on, thereby achieving the refresh of the data voltage. When the display substrate is not in the refresh frame, the drive signal output terminal outputs a low-level signal all the time, and the fourth transistor M4 cannot be turned on.

In an exemplary embodiment, the first control signal terminal G1 of at least one-stage shift register is electrically connected to the cascaded signal output terminal of the previous K1 stage shift register, and the signal input terminal IN of at least one-stage shift register is electrically connected to the cascaded signal output terminal of the previous K2 stage shift register, wherein K1 is greater than K2. The connection mode between the first control signal terminal and the signal input terminal of the shift register of the present disclosure may enable the signal of the masking signal terminal MS to be pre-written, ensuring more thorough writing.

In an exemplary embodiment, FIG. 6 illustrates an example in which a signal received by the signal input terminal IN of the nth stage shift register and a signal output by the cascaded signal output terminal Carry(n-2) of the (n-2)-th stage shift register are a same signal, and a signal received by the first control signal terminal G1 of the nth stage shift register and a signal output by the cascaded signal output terminal Carry(n-10) of the (n-10)-th stage shift register are a same signal.

FIG. 7 is an operational timing diagram of the shift sub-circuit in the shift register provided in FIG. 6. FIG. 6 illustrates an example in which the first transistor T1 to the eighth transistor T8 all are P-type transistors. During operation of the shift register, the eighth transistor T8 is continuously turned on.

As shown in FIG. 7, the operation process of the shift sub-circuit provided by an exemplary embodiment may include the following stages:
In a first stage S1, that is, an input stage, signals at the signal input terminal IN and the first clock signal terminal CK1 are low-level signals, and signals at the second clock signal terminal CK2 and the third clock signal terminal CK3 are high-level signals. The first transistor T1 is turned on, and the third transistor T3 and the seventh transistor T7 are turned off.

The first transistor T1 is turned on, the low-level signal of the signal input terminal IN is written into the first node N1, and the low-level signal of the first node N1 is written into the third node N3 through the turned-on eighth transistor T8. The fifth transistor T5 is turned on, and the high-level signal of the third clock signal terminal CK3 is written into the cascaded signal output terminal Carry. The second transistor T2 is turned on, the high-level signal of the second clock signal terminal CK2 is written into the second node N2, and the fourth transistor T4 and the sixth transistor T6 are turned off.

In this stage, signals at the first node N1 and the third node N3 are low-level signals, a signal at the second node N2 is a high-level signal, and the cascaded signal output terminal Carry outputs a high-level signal.

In a second stage S2, a signal at the second clock signal terminal CK2 is a low-level signal, and signals at the signal input terminal IN, the first clock signal terminal CK1 and the third clock signal terminal CK3 are high-level signals. The third transistor T3 is turned on, and the first transistor T1 and the seventh transistor T7 are turned off.

The first transistor T1 is turned off, the high-level signal at the signal input terminal IN cannot be written into the first node N1, and under the action of the second capacitor C2, the first node N1 and the third node N3 maintain the low-level signal of the previous stage. The second transistor T2 is continuously turned on, and the low-level signal at the second clock signal terminal CK2 is written into the second node N2. The fifth transistor T5 is turned on, and the high-level signal at the third clock signal terminal CK3 is written into the cascaded signal output terminal Carry. The third transistor T3 is turned on, and the low-level signal at the second power supply terminal VGL is written into the second node N2. The fourth transistor T4 is turned on, and the high-level signal at the first power supply terminal VGH is written into the cascaded signal output terminal Carry. The sixth transistor T6 is turned on, and the high-level signal at the first power supply terminal VGH is written into the fourth node N4.

In this stage, signals at the first node N1, the second node N2 and the third node N3 are low-level signals, a signal at the fourth node N4 is a high-level signal, and the cascaded signal output terminal Carry outputs a high-level signal.

In a third stage S3, i.e., an output stage, a signal at the third clock signal terminal CK3 is a low-level signal, and signals at the signal input terminal IN, the first clock signal terminal CK1 and the second clock signal terminal CK2 are high-level signals. The seventh transistor T7 is turned on, and the first transistor T1 and the third transistor T3 are turned off.

The first transistor T1 is turned off, the high-level signal at the signal input terminal IN cannot be written into the first node N1, and under the action of the second capacitor C2, the first node N1 and the third node N3 maintain the low-level signal of the previous stage. The second transistor T2 is continuously turned on, and the high-level signal of the second clock signal terminal CK2 is written into the second node N2. The fifth transistor T5 is turned on, and the low-level signal of the third clock signal terminal CK3 is written into the cascaded signal output terminal Carry. The third transistor T3 is turned off, and the low-level signal of the second power supply terminal VGL cannot be written into the second node N2. The fourth transistor T4 and the sixth transistor T6 are turned off, and under the action of the second capacitor C2, a signal of the fourth node N4 is pulled down by the signal of the cascaded signal output terminal Carry, thereby making the signals of the first node N1 and the third node N3 be low-level signals.

In this stage, signals at the first node N1, the third node N3, and the fifth node N4 are low-level signals, a signal at the second node N2 is a high-level signal, and the cascaded signal output terminal Carry outputs a low-level signal.

In a fourth stage S4, signals at the signal input terminal IN, the first clock signal terminal CK1, the second clock signal terminal CK2 and the third clock signal terminal CK3 are high-level signals. The first transistor T1, the third transistor T3 and the seventh transistor T7 are turned off.

The first transistor T1 is turned off, the high-level signal at the signal input terminal IN cannot be written into the first node N1, and under the action of the second capacitor C2, the first node N1 and the third node N3 maintain the low-level signal of the previous stage. The second transistor T2 is continuously turned on, and the high-level signal of the second clock signal terminal CK2 is written into the second node N2. The fifth transistor T5 is turned on, and the high-level signal of the third clock signal terminal CK3 is written into the cascaded signal output terminal Carry. The third transistor T3 is turned off, the low-level signal of the second power supply terminal VGL cannot be written into the second node N2, and the fourth transistor T4 and the sixth transistor T6 are turned off.

In this stage, signals at the first node N1, the third node N3, and the fourth node N4 are low-level signals, a signal at the second node N2 is a high-level signal, and the cascaded signal output terminal Carry outputs a high-level signal.

In a fifth stage S5, a signal at the first clock signal terminal CK1 is a low-level signal, and signals at the signal input terminal IN, the second clock signal terminal CK2 and the third clock signal terminal CK3 are high-level signals. The first transistor T1 is turned on, and the third transistor T3 and the seventh transistor T7 are turned off.

The first transistor T1 is turned on, and the high-level signal of the signal input terminal IN is written into the first node N1. The second transistor T2 is turned off, the fifth transistor T5 is turned off, and under the action of the first capacitor C1, the second node N2 maintains the high-level signal of the previous stage, and the fourth transistor T4 and the sixth transistor T6 are turned off.

In this stage, signals at the first node N1, the second node N2 and the third node N3 are low-level signals, a signal at the fourth node N4 is a low-level signal, and the cascaded signal output terminal Carry outputs a high-level signal.

In a sixth stage S6, a signal at the second clock signal terminal CK2 is a low-level signal, and signals at the signal input terminal IN, the first clock signal terminal CK1 and the third clock signal terminal CK3 are high-level signals. The third transistor T3 is turned on, and the first transistor T1 and the seventh transistor T7 are turned off.

The third transistor T3 is turned on, and the high-level signal of the second power supply terminal VGL is written into the second node N2; the fourth transistor T4 is turned on, and the high-level signal of the first power supply terminal VGH is written into the cascaded signal output terminal Carry. The sixth transistor T6 is turned on, and the high-level signal of the first power supply terminal VGH is written into the fourth node N4. The signals of the first node N1 and the third node N3 maintain the high-level signals of the previous stage under the action of the second capacitor C2.

In this stage, signals at the first node N1, the third node N3, and the fourth node N4 are low-level signals, a signal at the second node N2 is a low-level signal, and the cascaded signal output terminal Carry outputs a high-level signal.

The fifth stage S5 and the sixth stage S6 of the shift register occur cyclically until the signal at the signal input terminal is a low-level signal.

In an exemplary embodiment, when the signal of the cascaded signal output terminal Carry of the shift register is a low-level signal, the signal of the third clock signal terminal CK3 is a low-level signal, the signal of the second node N2 is a high-level signal, and the signal of the third node N3 is a low-level signal.

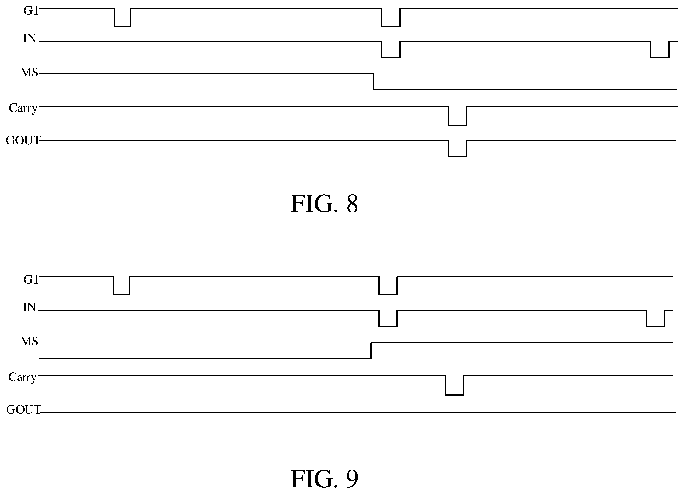

In an exemplary embodiment, FIG. 8 is an operational timing diagram of the output sub-circuit in the shift register provided in FIG. 6 in a refresh frame. As shown in FIG. 8, when the display substrate is in the refresh frame, the signal of the masking signal terminal MS is a low-level signal for the first time period. The first time period is a time period in which the signals of the first control signal terminal G1 and the signal input terminal IN are low-level signals.

The working process of the output sub-circuit of the shift register in a refresh frame includes:
signals at the first control signal terminal G1 and the signal input terminal IN are high-level signals, and a signal at the masking signal terminal MS is a low-level signal. The thirteenth transistor T13 and the fourteenth transistor T14 are turned on.

The thirteenth transistor T13 and the fourteenth transistor T14 are turned on, and the low-level signal of the masking signal terminal MS is written into the seventh node N7. The eleventh transistor T11 and the twelfth transistor T12 are turned on, and the signal of the second node N2 is the same as the signal of the fifth node N5, and the signal of the third node N3 is the same as the signal of the sixth node N6. Therefore, during the operation of the shift register, the operation state of the ninth transistor T9 is the same as that of the fourth transistor T4, the operation state of the tenth transistor T10 is the same as that of the fifth transistor T5, and the signal output by the drive signal output terminal GOUT is the same as the signal output by the cascaded signal output terminal Carry.

When the shift register provided by the present disclosure is in a refresh frame, the signal of the drive signal output terminal GOUT is the same as the signal output by the cascaded signal output terminal Carry, which can maintain a high refresh rate of the display substrate.

Therefore, when a high refresh rate is required in at least one region of the display substrate, a low-level signal is supplied by the masking signal terminal MS, and the drive signal output terminal outputs a same signal as the cascaded signal output terminal Carry, so that part of the transistors corresponding to the pixel drive circuit in the display substrate are turned off, and then the data voltage in the display substrate is charged, thereby achieving a high refresh rate in this area.

In an exemplary embodiment, FIG. 9 is an operational timing diagram of the output sub-circuit in the shift register provided in FIG. 6 in a holding frame. As shown in FIG. 9, when the display substrate is in the hold frame, the signal of the masking signal terminal MS is a high-level signal for the first time period.

The operation process of the output sub-circuit of the shift register in a holding frame includes:
signals at the first control signal terminal G1 and the signal input terminal IN are high-level signals, and a signal at the masking signal terminal MS is a high-level signal. The thirteenth transistor T13 and the fourteenth transistor T14 are turned on.

The thirteenth transistor T13 and the fourteenth transistor T14 are turned on, the high-level signal of the masking signal terminal MS is written into the seventh node N7, and the eleventh transistor T11 and the twelfth transistor T12 are turned off. The signal of the sixth node N6 is a high-level signal, and the tenth transistor T10 is turned off; the signal of the fifth node N5 is a low-level signal, and the ninth transistor T9 is turned on; and the high-level signal of the first power supply terminal VGH is written into the drive signal output terminal GOUT.

In an exemplary embodiment, the second control signal terminal G2 is a low-level signal in a partial time period after the signal of the cascaded signal output terminal is a low-level signal, that is, when the signal of the second control signal terminal G2 is a low-level signal, the signal of the cascaded signal output terminal GOUT is a high-level signal. The signal of the second control signal terminal G2 is a low-level signal, the fifteenth transistor T15 is turned on, the low-level signal of the second power supply terminal VGL is written into the seventh node N7, the eleventh transistor T11 and the twelfth transistor T12 are turned on, the signal of the second node N2 is the same as the signal of the fifth node N5, and the signal of the third node N3 is the same as the signal of the sixth node N6. Therefore, during the operation of the shift register, the operation state of the ninth transistor T9 is the same as that of the fourth transistor T4, the operation state of the tenth transistor T10 is the same as that of the fifth transistor T5, and the drive signal output terminal GOUT outputs a high-level signal. The arrangement of the fifteenth transistor T15 may ensure the reliability of the shift register.

When the shift register provided by the present disclosure in a holding frame, the drive signal output terminal GOUT continuously outputs a high-level signal, which can maintain the low refresh rate of the display substrate.

Therefore, when a low refresh rate is required in at least one region of the display substrate, a high-level signal is supplied by the masking signal terminal MS, and a high-level signal is continuously output by the drive signal output terminal so that part of the transistors corresponding to the pixel drive circuit in the display substrate are turned off, the data voltage in the display substrate is not charged, and the state of the previous frame is maintained, thereby achieving a low refresh rate in the region.

An embodiment of the present disclosure further provides a drive method for a shift register, configured to drive the shift register provided by any one of the above embodiments. The drive method for the shift register may include the following steps:
Step 100: The shift sub-circuit provides a signal of one signal terminal of the second power supply terminal and the second clock signal terminal to the second node and a signal of the signal input terminal to the third node under the control of a signal of at least one signal terminal of the signal input terminal, the first clock signal terminal, the second clock signal terminal and the third clock signal terminal, and provides a signal of one of the first power supply terminal and the third clock signal terminal to the cascaded signal output terminal under the control of signals of the second node and the third node.
Step 200: The output sub-circuit provides a signal of one signal terminal of the first power supply terminal and the third clock signal terminal to the drive signal output terminal under the control of a signal of at least one signal terminal of the second node, the third node, the first control signal terminal, the second control signal terminal, the signal input terminal, and the masking signal terminal.

An embodiment of the present disclosure further provides a display substrate, including a display area and a non-display area surrounding at least one side of the display area, wherein the display substrate includes a first gate drive circuit located in the non-display area, and the first gate drive circuit includes a plurality of cascaded first shift registers, and the first shift registers are the shift registers provided in any one of the foregoing embodiments.

In an exemplary embodiment, the cascaded signal output terminal of the nth stage first shift register is electrically connected to the signal input terminal of the (n+X)-th stage first shift register and the first control signal terminal of the (n+Y)-th stage first shift register, 1≤n≤N, N is a total quantity of stages of the first shift register, X<Y. Exemplarily, the cascaded signal output terminal of the n-th stage first shift register may be electrically connected to the signal input terminal of the (n+2)-th stage first shift register and the first control signal terminal of the (n+10)-th stage first shift register, respectively.

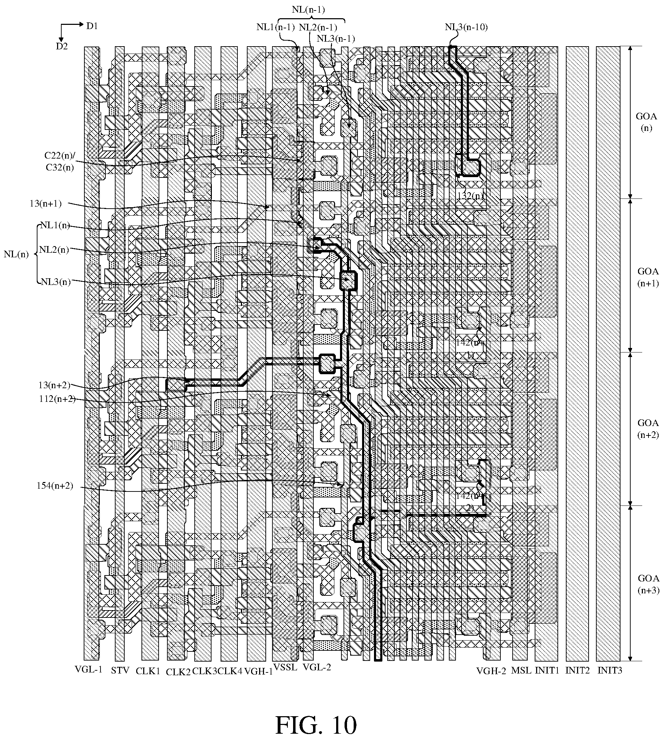

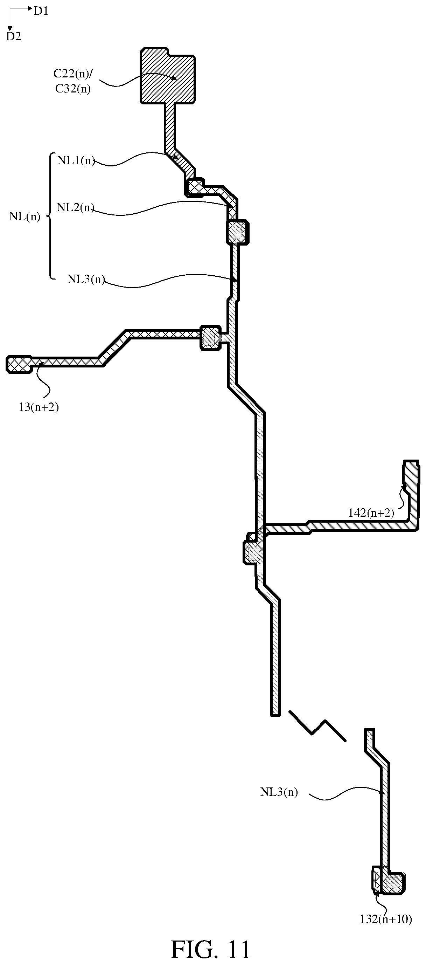

In an exemplary embodiment, FIG. 10 is a schematic diagram of a structure of a display substrate provided by an embodiment of the present disclosure, and FIG. 11 is a schematic diagram of connection of a cross-stage connection line. As illustrated in FIG. 10, the display substrate may further include a plurality of cross-stage connection lines NL located in the non-display area. FIG. 10 illustrates an example in which four-stage shift registers are an n-th stage first shift register GOA (n), an (n+1)-th stage first shift register GOA (n+1), an (n+2)-th stage first shift register GOA (n+2), and an (n+3)-th stage first shift register GOA (n+3), respectively.

As shown in FIGS. 10 and 11, one of the plurality of cross-stage connection lines NL is electrically connected to a cascaded signal output terminal of at least one-stage first shift register, a signal input terminal of at least one-stage first shift register, and a first control signal terminal of at least one-stage first shift register, respectively.

In an exemplary embodiment, at least two of the shift registers among the shift register where the cascaded signal output terminal connected to the same cross-stage connection line is located, the shift register where the connected signal input terminal is located, and the shift register where the connected first control signal terminal is located are shift registers of different stages.

In an exemplary embodiment, as shown in FIGS. 10 and 11, the cross-stage connection line includes a first cross-stage connection portion NL1, a second cross-stage connection portion NL2, and a third cross-stage connection portion NL3, and at least one connection portion of the first cross-stage connection portion NL1, the second cross-stage connection portion NL2, and the third cross-stage connection portion NL3 at least partially extends along the second direction D2.

In an exemplary embodiment, as shown in FIGS. 10 and 11, the second cross-stage connection portion NL2 is electrically connected to the first cross-stage connection portion NL1 and the third cross-stage connection portion NL3, respectively, and at least two of the first cross-stage connection portion NL1, the second cross-stage connection portion NL2, and the third cross-stage connection portion NL3 are disposed in different layers.

In an exemplary embodiment, at least one-stage first shift register includes a first transistor to a fifteenth transistor and a first capacitor to a sixth capacitor. The second capacitor and the third capacitor include a first plate and a second plate, wherein the first electrode of the first transistor and the control electrode of the fourteenth transistor are electrically connected to the signal input terminal of the first shift register, respectively, the control electrode of the thirteenth transistor is electrically connected to the first control signal terminal of the first shift register, and the second plate of the second capacitor and the second plate of the third capacitor are electrically connected to the cascaded signal output terminal of the first shift register, respectively.

As shown in FIGS. 10 and 11, taking X = 2 and Y = 10 as examples, for a cross-stage connection line NL (n) electrically connected to the cascaded signal input terminal of the nth stage first shift register, connected to the signal output terminal of the (n+2)-th first shift register and connected to the first control signal terminal of the (n+10)-th stage first shift register, the first cross-stage connection portion NL1 (n) is electrically connected to the second plate C22 (n) of the second capacitor and the second plate C32 (n) of the third capacitor of the nth stage first shift register and the second cross-stage connection portion NL2 (n), respectively, and the third cross-stage connection portion NL3 (n) is electrically connected to the first electrode 13 (n+2) of the first transistor and the control electrode 142 (n+2) of the fourteenth transistor of the (n+2)-th stage first shift register, the control electrode 132 (n+10) of the thirteenth transistor of the (n+10)-th stage first shift register and the second cross-stage connection portion NL2 (n) , respectively.

As shown in FIGS. 10 and 11, the first trace connecting the second plate C22 (n) of the second capacitor and the second plate C32 (n) of the third capacitor of the nth stage first shift register and the first electrode 13 (n+2) of the first transistor and the control electrode 142 (n+2) of the fourteenth transistor of the (n+2)-th stage first shift register includes: the first cross-stage connection line NL1 (n), the second cross-stage connection portion NL2 (n), and part of the third cross-stage connection portion NL3 (n) of the cross-stage connection line NL (n), while the second trace connecting the second plate C22 (n) of the second capacitor and the second plate C32 (n) of the third capacitor of the nth stage first shift register and the control electrode 132 (n+10) of the thirteenth capacitor of the (n+10)-th stage first shift register is a whole cross-stage connection line NL (n). The first cross-stage connection line NL1 (n), the second cross-stage connection portion NL2 (n), and part of the third cross-stage connection portion NL3 (n) in the first trace and the second trace are shared, achieving sharing partial trace in the shift register, which can save the space occupied by the shift register, thereby achieving a narrow bezel of the display substrate.

In an exemplary embodiment, the display substrate further includes: a base substrate and a drive circuit layer disposed on the base substrate; the first gate drive circuit is disposed on the drive circuit layer. The drive circuit layer includes a semiconductor layer, a first conductive layer, a second conductive layer, a third conductive layer, and a fourth conductive layer that are sequentially stacked on the base substrate. At least one-stage first shift register includes at least one transistor and at least one capacitor. The at least one transistor includes an active pattern, a control electrode, a first electrode and a second electrode, and the at least one capacitor includes a first plate and a second plate.

In an exemplary embodiment, the semiconductor layer includes the active pattern of the at least one transistor located in at least one-stage first shift register.

In an exemplary embodiment, the first conductive layer includes the control electrode of the at least one transistor located in at least one-stage first shift register and the first plate of the at least one capacitor.

In an exemplary embodiment, the second conductive layer includes the second plate of the at least one capacitor located in at least one-stage first shift register and the first cross-stage connection portion NL1 of at least one of the plurality of cross-stage connection lines.

In an exemplary embodiment, the third conductive layer includes the first electrode and the second electrode of the at least one transistor located in at least one-stage first shift register, and the second cross-stage connection portion NL2 of at least one of the plurality of cross-stage connection lines.

In an exemplary embodiment, the fourth conductive layer includes the third cross-stage connection portion NL3 of at least one of the plurality of cross-stage connection lines.

In an exemplary embodiment, as shown in FIG. 11, the second plate of the second capacitor and the second plate of the third capacitor in at least one-stage first shift register are the same plate. FIG. 11 illustrates an example in which the second plate C22 (n) of the second capacitor and the second plate C32 (n) of the third capacitor of the nth stage first shift register are the same plate. The second plate of the second capacitor and the second plate of the third capacitor of at least one-stage first shift register are the same plate, which can reduce the area occupied by the shift register and realize a narrow bezel.

In the exemplary embodiment, as shown in FIG. 11, for the cross-stage connection line NL (n) connected to the cascaded signal output terminal of the nth stage first shift register, the first cross-stage connection portion NL1 (n) and the second plate C22 (n) of the second capacitor of the nth stage first shift register are of an integral structure.

In an exemplary embodiment, as shown in FIG. 10, an orthographic projection of the first cross-stage connection portion NL1 in at least one of the plurality of cross-stage connection lines on the base substrate at least partially overlaps with an orthographic projection of the first electrode 13 of the first transistor of at least one-stage first shift register on the base substrate.

In an exemplary embodiment, as shown in FIG. 10, an orthographic projection of the second cross-stage connection portion NL2 of at least one of the plurality of cross-stage connection lines on the base substrate at least partially overlaps with an orthographic projection of the control electrode 112 of the eleventh transistor of at least one-stage first shift register on the base substrate.

In an exemplary embodiment, as shown in FIG. 10, an orthographic projection of the third cross-stage connection portion NL3 of at least one of the plurality of cross-stage connection lines on the base substrate at least partially overlaps with an orthographic projection of the control electrode of at least one of the thirteenth transistor and the fourteenth transistor of at least one-stage first shift register on the base substrate. FIG. 10 illustrates an example in which an orthographic projection of the third cross-stage connection portion NL3 of at least one of the plurality of cross-stage connection lines on the base substrate at least partially overlaps with orthographic projections of the control electrode 132 of the thirteenth transistor and the control electrode 142 of the fourteenth transistor of at least one-stage first shift register on the base substrate.

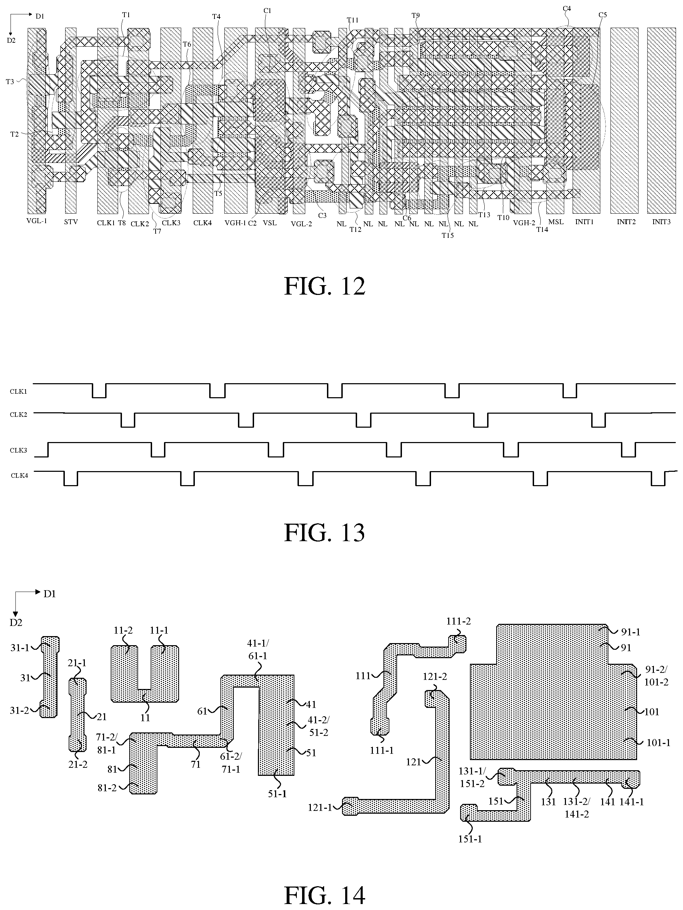

In an exemplary implementation, FIG. 12 is a schematic diagram of another structure of the display substrate. FIG. 12 is illustrated by taking one-stage first shift register as an example. The display substrate further includes a clock signal line group located in the non-display area, and the clock signal line group is disposed on the drive circuit layer and located in the fourth conductive layer. The plurality of cross-stage connection lines NL is located on the side of the clock signal line group close to the display area.

As shown in FIG. 12, the clock signal line group includes a first clock signal line CLK1, a second clock signal line CLK2, a third clock signal line CLK3, and a fourth clock signal line CLK4 that are sequentially arranged at the side close to the display area, and at least one signal line of the first clock signal line CLK1, the second clock signal line CLK2, the third clock signal line CLK3, and the fourth clock signal line CLK4 at least partially extends along the second direction D2.

The display substrate of the present disclosure includes the first clock signal line CLK1, the second clock signal line CLK2, the third clock signal line CLK3, and the fourth clock signal line CLK4, which can reduce the load of the clock signal line, thereby improving the reliability of the display substrate.

In an exemplary embodiment, the first clock signal terminal of the (4i-3)-th stage first shift register is electrically connected to the first clock signal line CLK1, the second clock signal terminal of the (4i-3)-th stage first shift register is electrically connected to the second clock signal line CLK2, the third clock signal terminal of the (4i-3)-th stage first shift register is electrically connected to the third clock signal line CLK3. The first clock signal terminal of the (4i-2)-th stage first shift register is electrically connected to the second clock signal line CLK2, the second clock signal terminal of the (4i-2)-th stage first shift register is electrically connected to the third clock signal line CLK3, and the third clock signal terminal of the (4i-2)-th stage first shift register is electrically connected to the fourth clock signal line CLK4. The first clock signal terminal of the (4i-1)-th stage first shift register is electrically connected to the third clock signal line CLK3, the second clock signal terminal of the (4i-1)-th stage first shift register is electrically connected to the fourth clock signal line CLK4, and the third clock signal terminal of the (4i-1)-th stage first shift register is electrically connected to the first clock signal line CLK1. The first clock signal terminal of the 4i-th stage first shift register is electrically connected to the fourth clock signal line CLK4, the second clock signal terminal of the 4i-th stage first shift register is electrically connected to the first clock signal line CLK1, and the third clock signal terminal of the 4i-th stage first shift register is electrically connected to the second clock signal line CLK2.

In an exemplary embodiment, as shown in FIG. 12, an orthographic projection of the clock signal line group on the base substrate at least partially overlaps with an orthographic projection of at least one of the first transistor T1, the second transistor T2, the sixth transistor T6, the seventh transistor T7, and the eighth transistor T8 in at least one-stage first shift register on the base substrate.

FIG. 13 is a signal timing diagram of a clock signal line. As shown in FIG. 13, the times when signals of at least two clock signal lines CLK1 of the first clock signal line CLK1, the second clock signal line CLK2, the third clock signal line CLK3, and the fourth clock signal line CLK4 are low-level signals do not overlap. The duration in which a signal of at least one signal line of the first clock signal line CLK1, the second clock signal line CLK2, the third clock signal line CLK3, and the fourth clock signal line CLK4 is a high-level signal within one cycle is greater than the duration in which it is a low-level signal.

In an exemplary embodiment, as shown in FIG. 12, the display substrate further includes a power supply signal line group and a clock signal line group located in the non-display area, and the power supply signal line group and the clock signal line group are disposed on the drive circuit layer and are located in the fourth conductive layer.

In an exemplary embodiment, as shown in FIG. 12, the power supply signal line group includes two first power supply lines and two second power supply lines, and the first power supply lines and the second power supply lines at least partially extend along the second direction D2. Herein, the first second power supply line VGL-1 is located on the side of the clock signal line group away from the display area, the first first power supply line VGH-1 is located on the side of the clock signal line group close to the display area, the second second power supply line VGL-2 is located on the side of the first first power supply line VGH-1 close to the display area, the second first power supply line VGH-2 is located on the side of the second second power supply line VGL-2 close to the display area, and the plurality of cross-stage connection lines NL are located between the second second power supply line VGL-2 and the second first power supply line VGH-2.

In an exemplary embodiment, the first power supply line is electrically connected to the first power supply terminal of at least one-stage first shift register, and the second power supply line is electrically connected to the second power supply terminal of at least one-stage first shift register.

In an exemplary embodiment, as shown in FIG. 12, an orthographic projection of the first first power supply line VGH-1 on the base substrate at least partially overlaps with orthographic projections of the fourth transistor T4 and the fifth transistor T5 of at least one-stage first shift register on the base substrate.

In an exemplary embodiment, as shown in FIG. 12, an orthographic projection of the first second power supply line VGL-1 on the base substrate at least partially overlaps with an orthographic projection of the third transistor T3 of at least one-stage first shift register on the base substrate.

In an exemplary embodiment, as shown in FIG. 12, an orthographic projection of the second first power supply line VGH-2 on the base substrate at least partially overlaps with orthographic projections of the ninth transistor T9 and the tenth transistor T10 of at least one-stage first shift register on the base substrate.

In an exemplary embodiment, as shown in FIG. 12, an orthographic projection of the second second power supply line VGL-2 on the base substrate at least partially overlaps with the orthographic projection of the third capacitor C3 of at least one-stage first shift register on the base substrate.

In an exemplary embodiment, as shown in FIG. 12, the display substrate further includes a scan initial signal line STV located in the non-display area, the scan initial signal line STV is provided in the drive circuit layer and located in the fourth conductive layer, and the scan initial signal line STV at least partially extends along the second direction D2.

In an exemplary embodiment, as shown in FIG. 12, the scan initial signal line STV is located between the first second power supply line VGL-1 and the clock signal line group.

In an exemplary embodiment, the signal input terminal of the first stage first shift register and the signal input terminal of the second stage first shift register are electrically connected to the scan initial signal line, respectively.

In an exemplary embodiment, an orthographic projection of the scan initial signal line STV on the base substrate at least partially overlaps with the orthographic projection of the second transistor T2 of at least one-stage first shift register on the base substrate.

In an exemplary embodiment, as shown in FIG. 12, the power supply signal line group may further include a third power supply line VSL extending at least partially along the second direction D2.

In an exemplary embodiment, the display area is provided with a light-emitting device, and the third power supply line VSL is electrically connected to a second electrode of at least one light-emitting device.

In an exemplary embodiment, as shown in FIG. 12, the third power supply line VSL is located between the first first power supply line VGH-1 and the second second power supply line VGL-2.

In an exemplary embodiment, as shown in FIG. 12, an orthographic projection of the third power supply line VSL on the base substrate at least partially overlaps with orthographic projections of the first capacitor C1 and the second capacitor C2 of at least one-stage first shift register on the base substrate.

In an exemplary embodiment, as shown in FIG. 12, the length of the third power supply line VSL along the first direction D1 is greater than the length of at least one of the first power supply line and the second power supply line along the first direction D1, and the first direction and the second direction intersect, for example, the first direction D1 and the second direction D2 may be perpendicular.

In an exemplary embodiment, as shown in FIG. 12, the display substrate may further include a masking signal line MSL located in the non-display area, the masking signal line MSL is provided in the drive circuit layer and located in the fourth conductive layer, and the masking signal line MSL at least partially extends along the second direction D2.

In the exemplary embodiment, as shown in FIG. 12, the masking signal line MSL is located on the side of the power supply signal line group close to the display area.

In an exemplary embodiment, the masking signal line MSL is electrically connected to the masking signal terminal of at least one-stage first shift register.

In an exemplary embodiment, as shown in FIG. 12, an orthographic projection of the masking signal line MSL on the base substrate at least partially overlaps with orthographic projections of the fourth capacitor C2 and the fifth capacitor C5 of at least one-stage first shift register on the base substrate.

In an exemplary embodiment, as shown in FIG. 12, the display substrate may further include a plurality of pixel initial signal lines located in the non-display area. At least one signal line of the plurality of pixel initial signal lines is provided in the drive circuit layer and is located in the fourth conductive layer, and at least one signal line of the plurality of pixel initial signal lines at least partially extends along the second direction D2. FIG. 12 illustrates an example in which three pixel initial signal lines include a first initial signal line INIT1, a second initial signal line INIT2, and a third initial signal line INIT3.

In the exemplary embodiment, as shown in FIG. 12, the plurality of pixel initial signal lines are located on the side of the masking signal line MSL close to the display area.

In an exemplary embodiment, as shown in FIG. 12, an orthographic projection of one of the plurality of pixel initial signal lines on the base substrate at least partially overlaps with orthographic projections of the fourth capacitor C4 and the fifth capacitor C5 of at least one-stage first shift register on the base substrate. FIG. 12 illustrates an example in which an orthographic projection of the first initial signal line INIT1 on the base substrate at least partially overlaps with the orthographic projections of the fourth capacitor C4 and the fifth capacitor C5 of at least one-stage first shift register on the base substrate.

In the present disclosure, the orthographic projection of one of the plurality of pixel initial signal lines on the base substrate at least partially overlaps with the orthographic projections of the fourth capacitor C4 and the fifth capacitor C5 of at least one-stage first shift register on the base substrate, which can reduce the area occupied by the shift register, and can realize the narrow bezel of the display substrate.

In an exemplary embodiment, as shown in FIG. 12, the length of at least one signal line of the plurality of pixel initial signal lines along the first direction D1 is greater than the length of the masking signal line MSL along the first direction D1. The length of at least one signal line of the plurality of pixel initial signal lines along the first direction D1 is greater than the length of the masking signal line MSL along the first direction D1, which can reduce the load of at least one signal line of the plurality of pixel initial signal lines.

In an exemplary embodiment, the display substrate further includes a second gate drive circuit located in the non-display area, the second gate drive circuit includes a plurality of cascaded second shift registers, and the second shift register includes a light emitting signal output terminal.

In an exemplary embodiment, at least one-stage first shift register is electrically connected to a write transistor of at least one row of pixel drive circuits, and at least one-stage second shift registers is electrically connected to a light emitting transistor in at least one row of pixel driving circuits.

In an exemplary embodiment, the second control signal terminal of at least one-stage first shift register is electrically connected to the signal output terminal of at least one-stage second shift register.

In an exemplary implementation, the display substrate further includes a light emitting structure layer located on a side of the drive circuit layer away from the base substrate. Among them, the light emitting structure layer may include an anode, a pixel definition layer, an organic emitting layer, and a cathode. The anode is connected with the pixel drive circuit through a via, the organic emitting layer is connected with the anode, the cathode is connected with the organic emitting layer, and the organic emitting layer emits light of a corresponding color under drive of the anode and the cathode.

In an exemplary implementation, the display substrate may further include an encapsulation structure layer located on a side of the light emitting structure layer away from the base substrate. Among them, the encapsulation structure layer may include a first encapsulation layer, a second encapsulation layer, and a third encapsulation layer that are stacked. The first encapsulation layer and the third encapsulation layer may be made of an inorganic material, the second encapsulation layer may be made of an organic material, and the second encapsulation layer is disposed between the first encapsulation layer and the third encapsulation layer, which may ensure that external moisture cannot enter the light emitting structure layer.

In an exemplary implementation, the display substrate may further include a touch structure layer located on a side of the encapsulation structure layer away from the base substrate. Among them, the touch structure layer may include a first touch insulation layer disposed on the encapsulation structure layer, a first touch metal layer disposed on the first touch insulation layer, a second touch insulation layer covering the first touch metal layer, a second touch metal layer disposed on the second touch insulation layer, and a touch protection layer covering the second touch metal layer. The first touch metal layer may include a plurality of bridge electrodes, the second touch metal layer may include a plurality of first touch electrodes and second touch electrodes, and the first touch electrodes or the second touch electrodes may be connected with the bridge electrodes through vias.

In an exemplary implementation, the display substrate according to the present disclosure may be applied to a display apparatus with a gate drive circuit, such as an OLED, a quantum dot display (QLED), a light emitting diode display (Micro LED or Mini LED), or a Quantum Dot Light Emitting Diode display (QDLED), etc., which is not limited here in the present disclosure.

Exemplary description is made below through a preparation process for a display substrate. A "patterning process" mentioned in the present disclosure includes photoresist coating, mask exposure, development, etching, photoresist stripping, and the like for a metal material, an inorganic material, or a transparent conductive material, and includes organic material coating, mask exposure, development, and the like for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a substrate using deposition, coating, or other processes. If the "thin film" does not need to be processed through a patterning process in the entire preparation process, the "thin film" may also be called a "layer". If the "thin film" need to be processed through the patterning process in the entire preparation process, the "thin film" is called a "thin film" before the patterning process is performed and is called a "layer" after the patterning process is performed. At least one "pattern" is contained in the "layer" which has been processed through the patterning process. "A and B are provided in a same layer" in the present disclosure means that A and B are formed simultaneously through a same patterning process, and a "thickness" of a film or a layer is a dimension of the film or the layer in a direction perpendicular to a display substrate. In an exemplary implementation of the present disclosure, "an orthographic projection of B is within a range of an orthographic projection of A" or "an orthographic projection of A contains an orthographic projection of B" refers to that a boundary of the orthographic projection of B falls within a range of a boundary of the orthographic projection of A, or the boundary of the orthographic projection of A coincides with the boundary of the orthographic projection of B.
(1) A pattern of a semiconductor layer is formed. In an exemplary implementation, forming the pattern of the semiconductor layer may include depositing a semiconductor thin film on the base substrate, and patterning the semiconductor thin film through a patterning process to form the pattern of the semiconductor layer. As shown in FIG. 14, FIG. 14 is a schematic diagram after the semiconductor layer patterns are formed in FIG. 12.

In an exemplary implementation, as shown in Fig. 14, the pattern of the semiconductor layer may at least include an active pattern 11 of a first transistor to an active pattern 151 of a fifteenth transistor located in at least one-stage first shift register.

In the exemplary embodiment, as shown in FIG. 14, an active pattern 41 of the fourth transistor, an active pattern 51 of the fifth transistor, an active pattern 61 of the sixth transistor, an active pattern 71 of the seventh transistor, and an active pattern 81 of the eighth transistor are of an integral structure. An active pattern 91 of the ninth transistor and an active pattern 101 of the tenth transistor are of an integral structure. An active pattern 131 of the thirteenth transistor, an active pattern 141 of the fourteenth transistor and an active pattern 151 of the fifteenth transistor are of an integral structure. The active pattern 11 of the first transistor, the active pattern 21 of the second transistor, the active pattern 31 of the third transistor, the active pattern 111 of the eleventh transistor, and the active pattern 121 of the twelfth transistor are provided separately.

In the exemplary embodiment, as shown in FIG. 14, the active pattern 21 of the second transistor is located on the side of the active pattern 31 of the third transistor close to the display area, the active pattern 11 of the first transistor is located on the side of the active pattern 21 of the second transistor close to the display area, the active pattern 71 of the seventh transistor and the active pattern 81 of the eighth transistor of at least one-stage first shift register are located on the side of the active pattern 11 of the first transistor close to a first shift register of the next stage, and the active pattern 41 of the fourth transistor, the active pattern 51 of the fifth transistor, and the active pattern 61 of the sixth transistor are located on the side of the active pattern 71 of the seventh transistor and the active pattern 11 of the first transistor close to the display area. The active pattern 111 of the eleventh transistor and the active pattern 121 of the twelfth transistor are located on a side of the integral structure of the active pattern 41 of the fourth transistor, the active pattern 51 of the fifth transistor, the active pattern 61 of the sixth transistor, the active pattern 71 of the seventh transistor, and the active pattern 81 of the eighth transistor close to the display area. The integral structure of the active pattern 91 of the ninth transistor and the active pattern 101 of the tenth transistor and the integral structure of the active pattern 131 of the thirteenth transistor, the active pattern 141 of the fourteenth transistor and the active pattern 151 of the fifteenth transistor are located on a side of the active pattern 121 of the twelfth transistor close to the display area, and the integral structure of the active pattern 131 of the thirteenth transistor, the active pattern 141 of the fourteenth transistor and the active pattern 151 of the fifteenth transistor of at least one-stage first shift register is located on a side of the integral structure of the active pattern 91 of the ninth transistor and the active pattern 101 of the tenth transistor close to the first shift register of the next stage.

In an exemplary embodiment, the shape of the active pattern 11 of the first transistor of at least one-stage first shift register is an "n" shape with an opening facing the first shift register of the previous stage.

In an exemplary embodiment, any one of the active pattern 21 of the second transistor, the active pattern 31 of the third transistor, the active pattern 41 of the fourth transistor, the active pattern 51 of the fifth transistor, the active pattern 61 of the sixth transistor, the active pattern 81 of the eighth transistor, the active pattern 91 of the ninth transistor, and the active pattern 101 of the tenth transistor has a strip shape and extends along the second direction D2.

In an exemplary embodiment, at least one active pattern of the active pattern 71 of the seventh transistor, the active pattern 131 of the thirteenth transistor, the active pattern 141 of the fourteenth transistor, and the active pattern 151 of the fifteenth transistor at least partially extends along the first direction D1.

In an exemplary embodiment, the active pattern 111 of the eleventh transistor includes a first active portion and a second active portion that are connected to each other. The first active portion extends along the first direction D1 and the second active portion extends along the second direction D2, and the first active portion and the second active portion are disposed at a right angle. The first active portion is located on a side of the second active portion close to the display area.

In an exemplary embodiment, the active pattern 121 of the twelfth transistor includes a third active portion and a fourth active portion connected to each other. The third active portion extends along the first direction D1 and the fourth active portion extends along the second direction D2, and the third active portion and the fourth active portion are disposed at a right angle. The third active portion is located on a side of the fourth active portion away from the display area. The fourth active portion is located on a side of the second active portion close to the display area, and a straight line passing through the fourth active portion and extending along the second direction passes through the first active portion, and a straight line passing through the second active portion and extending along the second direction passes through the third active portion.

In the exemplary embodiment, the length of at least one active pattern of the active pattern 91 of the ninth transistor and the active pattern 101 of the tenth transistor along the first direction D1 is greater than the length of at least one active pattern of the active pattern 41 of the fourth transistor and the active pattern 51 of the fifth transistor along the first direction D1, thus the ninth transistor and the tenth transistor have relatively strong driving capability.

In an exemplary implementation, an active pattern of each transistor may include a first region, a second region, and a channel region located between the first region and the second region.

As shown in FIG. 14, a first region 41-1 of the active pattern 41 of the fourth transistor may serve as a first region 61-1 of the active pattern 61 of the sixth transistor. A second region 41-2 of the active pattern 41 of the fourth transistor may serve as a second region 51-2 of the active pattern 51 of the fifth transistor. A second region 61-2 of the active pattern 61 of the sixth transistor may serve as a first region 71-1 of the active pattern 71 of the seventh transistor. A second region 71-2 of the active pattern 71 of the seventh transistor may serve as a first region 81-1 of the active pattern 81 of the eighth transistor. A second region 91-2 of the active pattern 91 of the ninth transistor may serve as a second region 101-2 of the active pattern 101 of the tenth transistor. A first region 131-1 of the active pattern 131 of the thirteenth transistor may serve as a second region 151-2 of the active pattern 151 of the fifteenth transistor. A second region 131-2 of the active pattern 131 of the thirteenth transistor may serve as a second region 141-2 of the active pattern 141 of the fourteenth transistor. A first region 11-1 and a second region 11-2 of the active pattern 11 of the first transistor, a first region 21-1 of the active pattern 21 of the second transistor, a first region 31-1 and a second region 31-2 of the active pattern 31 of the third transistor, a first region 51-1 of the active pattern 51 of the fifth transistor, a second region 81-2 of the active pattern 81 of the eighth transistor, a first region 91-1 of the active pattern 91 of the ninth transistor, a first region 101-1 of the active pattern 101 of the tenth transistor, a first region 111-1 and a second region 111-2 of the active pattern 111 of the eleventh transistor, a first region 121-1 and a second region 121-2 of the active pattern 121 of the twelfth transistor, a first region 141-1 of the active pattern 141 of the fourteenth transistor, and a first region 151-1 of the active pattern 151 of the fifteenth transistor are disposed separately.

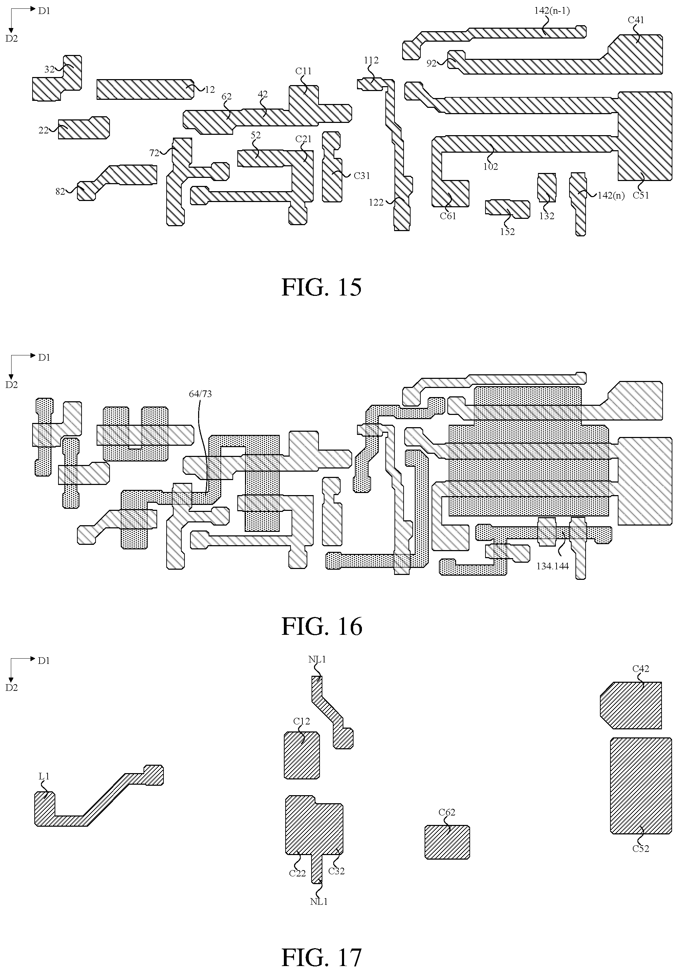

(2) A pattern of a first conductive layer is formed. In an exemplary implementation, forming the pattern of the first conductive layer may include: depositing a first insulation thin film and a first conductive thin film on the base substrate on which the aforementioned pattern is formed, and patterning the first conductive thin film by a patterning process to form a first insulation layer covering the pattern of the semiconductor layer, and the pattern of the first conductive layer disposed on the first insulation layer, as shown in Figs. 15 and 16. Fig. 15 is a schematic diagram of the pattern of the first conductive layer in Fig. 12 and Fig. 16 is a schematic diagram after the pattern of the first conductive layer is formed in Fig. 12. In an exemplary implementation, the first conductive layer may be referred to as a first gate metal (GATE1) layer.

In an exemplary embodiment, as shown in FIGS. 15 and 16, the pattern of the first conductive layer may at least include a control electrode 12 of the first transistor to a control electrode 152 of the fifteenth transistor, and a first plate C111 of the first capacitor to a first plate C61 of the sixth capacitor located in a first shift register of each stage.

In an exemplary embodiment, the control electrode 12 of the first transistor is provided separately. The control electrode 12 of the first transistor has a shape of a strip and extends in the first direction D1. Because there are two overlapping regions between the control electrode 12 of the first transistor and the active pattern of the first transistor, the first transistor has a double-gate structure.

In an exemplary embodiment, the control electrode 22 of the second transistor is provided separately. The control electrode 22 of the second transistor has a shape of a strip and extends in the first direction D1.

In an exemplary embodiment, the control electrode 32 of the third transistor is provided separately. The control electrode 32 of the third transistor has a bend line shape and extends at least partially in the second direction D2.

In an exemplary embodiment, the control electrode 42 of the fourth transistor, the control electrode 62 of the sixth transistor, and the first plate C11 of the first capacitor are of an integral structure. The control electrode 42 of the fourth transistor and the control electrode 62 of the sixth transistor have a shape of a strip and extend in the first direction D1. The main structure of the first plate C11 of the first capacitor has a rectangular shape. The control electrode 42 of the fourth transistor and the control electrode 62 of the sixth transistor are located on a side of the first plate C11 of the first capacitor away from the display area.

In an exemplary embodiment, the control electrode 52 of the fifth transistor and the first plate C21 of the second capacitor are of an integral structure. The control electrode 52 of the fifth transistor includes a plurality of gate lines along the second direction D2. At least one gate line extends along the first direction D1, the first plate C21 of the second capacitor is block-shaped, and the plurality of gate lines is electrically connected to the first plate C21 of the second capacitor. The control electrode 52 of the fifth transistor is located on a side of the first plate C21 of the second capacitor away from the display area.

In an exemplary embodiment, the control electrode 72 of the seventh transistor is provided separately, and the shape of the control electrode 72 of the seventh transistor is like"├" character.

In an exemplary embodiment, the control electrode 82 of the eighth transistor is disposed separately, and the control electrode 82 of the eighth transistor has a bend line shape and extends at least partially along the first direction D1.

In an exemplary embodiment, the control electrode 92 of the ninth transistor and the first plate C41 of the fourth capacitor are of an integral structure. The control electrode 92 of the ninth transistor has a shape of a strip and extends in the first direction D1, the first plate C41 of the fourth capacitor is block-shaped, and the control electrode 92 of the ninth transistor is located on a side of the first plate C41 of the fourth capacitor away from the display area.

In an exemplary embodiment, a control electrode 102 of the tenth transistor, the first plate C51 of the fifth capacitor, and the first plate C61 of the sixth capacitor are of an integral structure. The control electrode 102 of the tenth transistor includes a plurality of gate bars along the second direction D2, and at least one gate bar extends along the first direction D1. The first plate C51 of the fifth capacitor is block-shaped, and the plurality of gate bars is electrically connected to the first plate C51 of the fifth capacitor. The first plate C61 of the sixth capacitor is block-shaped, and is electrically connected to one of the plurality of gate bars. The control electrode 102 of the tenth transistor and the first plate C61 of the sixth capacitor are located on a side of the first plate C51 of the fifth capacitor away from the display area, and the first plate C61 of the sixth capacitor and the first plate C51 of the fifth capacitor are located on two sides of at least one gate bar.

In an exemplary embodiment, the control electrode 112 of the eleventh transistor and the control electrode 122 of the twelfth transistor are of an integral structure. The shape of the control electrode 112 of the eleventh transistor is a bend line shape with an included angle of 90 degrees, and at least partially extends in the second direction D2. The shape of the control electrode 122 of the twelfth transistor is a bend line shape with an included angle of 90 degrees, and at least partially extends in the first direction D1.

In an exemplary embodiment, the control electrode 132 of the thirteenth transistor is provided separately. The control electrode 132 of the thirteenth transistor is block-shaped.

In an exemplary embodiment, the control electrode 142 of the fourteenth transistor is provided separately. The shape of the control electrode 142 of the fourteenth transistor is a bend line shape and is like a "┘" character. FIG. 15 shows a first portion of the control electrode 142 (n) of the fourteenth transistor of the nth stage first shift register and a second portion of the control electrode 142 (n-1) of the fourteenth transistor of the (n-1)-th stage first shift register. The control electrode of the fourteenth transistor of one first shift register is a combination of the first portion and the second portion of FIG. 15.

In an exemplary implementation, the control electrode 152 of the fifteenth transistor is disposed separately. The control electrode 152 of the fifteenth transistor has a shape of a strip and extends in the first direction D1.

In an exemplary implementation, the first plate C31 of the third capacitor is disposed separately. The shape of the main body portion of the first plate 31 of the third capacitor may be rectangular.

In an exemplary embodiment, the control electrode 12 of the first transistor is provided across the active pattern of the first transistor, the control electrode 22 of the second transistor is provided across the active pattern of the second transistor, and the control electrode 32 of the third transistor is provided across the active pattern of the third transistor. The control electrode 42 of the fourth transistor (also the control electrode 62 of the sixth transistor and the first plate C11 of the first capacitor) is provided across the active pattern of the fourth transistor and the active pattern of the sixth transistor. The control electrode 52 of the fifth transistor (also the first plate C21 of the second capacitor) is provided across the active pattern of the fifth transistor. The control electrode 72 of the seventh transistor is provided across the active pattern of the seventh transistor. The control electrode 82 of the eighth transistor is provided across the active pattern of the eighth transistor. The control electrode 92 of the ninth transistor (also the first plate C41 of the fourth capacitor) is provided across the active pattern of the ninth transistor. The control electrode 102 of the tenth transistor (also the first plate C51 of the fifth capacitor and the first plate C61 of the sixth capacitor) is provided across the active pattern of the tenth transistor. The control electrode 112 of the eleventh transistor (also the control electrode 122 of the twelfth transistor) is provided across the active pattern of the eleventh transistor and the active pattern of the twelfth transistor. The control electrode 132 of the thirteenth transistor is provided across the active pattern of the thirteenth transistor. The control electrode 142 of the fourteenth transistor is provided across the active pattern of the fourteenth transistor. The control electrode 152 of the fifteenth transistor is provided across the active pattern of the fifteenth transistor.

In an exemplary implementation, after the pattern of the first conductive layer is formed, a conductive treatment may be performed on the semiconductor layer by using the first conductive layer as a shield. The semiconductor layer in a region which is shielded by the first conductive layer, forms channel regions of the first transistor to the twenty-sixth transistor, and the semiconductor layer in a region which is not shielded by the first conductive layer, is made to be conductive, that is, a first region and a second region of an active pattern of any of the first transistor to the fifteenth transistor are all made to be conductive. As shown in FIG. 16, the second region of the active pattern of the sixth transistor (also the first region of the active pattern of the seventh transistor) after the conductive treatment in the present disclosure is used as the second electrode 64 of the sixth transistor (also the first electrode 73 of the seventh transistor), and the second region of the active pattern of the thirteenth transistor (also the second region of the active pattern of the fourteenth transistor) is used as the second electrode 134 of the thirteenth transistor (also the second electrode 144 of the fourteenth transistor).

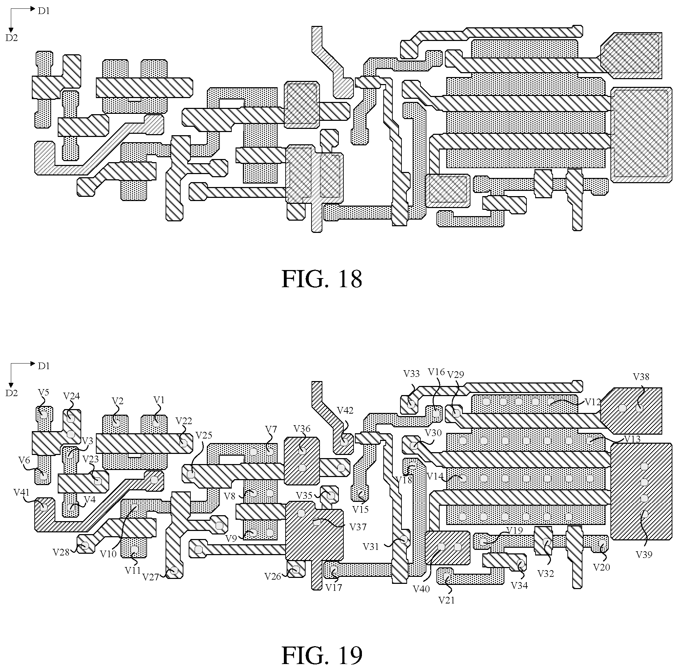

(3) Forming a pattern of a second conductive layer. In an exemplary embodiment, forming the pattern of the second conductive layer may include: depositing a second insulating thin film and a second conductive thin film on a base substrate on which the aforementioned pattern is formed, and patterning the second conductive thin film by a patterning process, to form a pattern of the second insulating layer covering the pattern of the first conductive layer and a pattern of the second conductive layer located on the pattern of the second insulating layer, as shown in FIGS. 17 and 18. FIG. 17 is a schematic diagram of the pattern of the second conductive layer in FIG. 12, and FIG. 18 is a schematic diagram after the pattern of the second conductive layer is formed in FIG. 12. In an exemplary implementation, the second conductive layer may be referred to as a second gate metal (GATE2) layer.

In an exemplary embodiment, as shown in FIGS. 17 and 18, the pattern of the second conductive layer may at least include the second plate C12 of the first capacitor to the second plate C62 of the sixth capacitor and a first connection electrode L1 located in the first shift register of each stage, and a first cross-stage connection portion NL1 of at least one of the plurality of cross-stage connection lines.

In an exemplary implementation, an orthographic projection of the second plate C12 of the first capacitor on the base substrate is at least partially overlapped with an orthographic projection of the first plate of the first capacitor on the base substrate. An area of the second plate C12 of the first capacitor is greater than an area of the first plate of the first capacitor. A shape of the second plate C12 of the first capacitor is the same as a shape of the first plate of the first capacitor.

In an exemplary embodiment, the second plate C22 of the second capacitor and the second plate C32 of the third capacitor are of an integral structure. An orthographic projection of the integral structure of the second plate C22 of the second capacitor and the second substrate C32 of the third capacitor on the base substrate at least partially overlaps with an orthographic projection of the first plate of the second capacitor on the base substrate, and is of an integral structure with the second plate C32 of the third capacitor and the second substrate C32 of the third capacitor. The shape of the integral structure of the second plate C22 of the second capacitor and the second substrate C32 of the third capacitor may be a block shape.

In an exemplary implementation, an orthographic projection of a second plate C42 of the fourth capacitor on the base substrate is at least partially overlapped with an orthographic projection of the first plate of the fourth capacitor on the base substrate. The second plate C42 of the fourth capacitor has a same shape as the first plate of the fourth capacitor, and an area of the second plate C42 of the fourth capacitor is greater than an area of the first plate of the fourth capacitor.

In an exemplary implementation, an orthographic projection of the second plate C52 of the fifth capacitor on the base substrate is at least partially overlapped with an orthographic projection of the first plate of the fifth capacitor on the base substrate. The second plate C52 of the fifth capacitor has a same shape as the first plate of the fifth capacitor, and an area of the second plate C52 of the fifth capacitor is greater than an area of the first plate of the fifth capacitor.

In an exemplary implementation, an orthographic projection of the second plate C62 of the sixth capacitor on the base substrate is at least partially overlapped with an orthographic projection of the first plate of the sixth capacitor on the base substrate. The second plate C62 of the sixth capacitor has a same shape as the first plate of the sixth capacitor, and an area of the second plate C62 of the sixth capacitor is greater than an area of the first plate of the sixth capacitor.

In an exemplary embodiment, the shape of the first connection line L1 is a bend line shape, and at least partially extends along the first direction D1.

In an exemplary embodiment, the shape of the first cross-stage connection portion NL1 of at least one connection line of the plurality of cross-stage connection lines is a strip shape, and at least partially extends in the second direction D2. The first cross-stage connection portion NL1 of at least one connection line of the plurality of cross-stage connection lines and the second plate C22 of the second capacitor of at least one-stage first shift register are of an integral structure.

(4) Forming a pattern of a third insulation layer. In an exemplary embodiment, forming the pattern of the third insulation layer may include: depositing a third insulating thin film on a base substrate on which the foregoing pattern is formed, and patterning the third insulating thin film by a patterning process to form the pattern of the third insulation layer covering the above structure, wherein the third insulation layer is provided with a plurality of via patterns, as shown in FIG. 19. FIG. 19 is a schematic diagram after the pattern of the third insulation layer is formed in FIG. 12.

In an exemplary implementation, as shown in Fig. 19, the pattern of the third insulation layer may at least include a first via V1 to a forty-second via V42 located in the shift register of each stage.

In an exemplary implementation, an orthographic projection of the first via V1 on the base substrate is located within a range of an orthographic projection of the first region of the active pattern of the first transistor on the base substrate. The first insulation layer and the second insulation layer in the first via V1 are etched away, exposing a surface of the first region of the active pattern of the first transistor. The first via V1 is configured such that a first electrode of the first transistor formed subsequently is connected with the first region of the active pattern of the first transistor through the via.

In an exemplary implementation, an orthographic projection of the second via V2 on the base substrate is located within a range of an orthographic projection of the second region of the active pattern of the first transistor on the base substrate. The first insulation layer and the second insulation layer within the second via V2 are etched away to expose a surface of the second region of the active pattern of the first transistor. The second via V2 is configured such that a second electrode of the first transistor formed subsequently (also a second electrode of the seventh transistor and a first electrode of the eighth transistor) is connected with the second region of the active pattern of the first transistor through the via.

In an exemplary implementation, an orthographic projection of the third via V3 on the base substrate is located within a range of an orthographic projection of a first region of the active pattern of the second transistor on the base substrate, the first insulation layer and the second insulation layer within the third via V3 are etched away to expose a surface of the first region of the active pattern of the second transistor, and the third via V3 is configured such that a first electrode of the second transistor formed subsequently is connected with the first region of the active pattern of the second transistor through the via.

In an exemplary embodiment, an orthographic projection of the fourth via V4 on the base substrate is located within a range of an orthographic projection of a second region of the active pattern of the second transistor on the base substrate. The first insulation layer and the second insulation layer within the fourth via V4 are etched away to expose a surface of the second region of the active pattern of the second transistor. The fourth via V4 is configured such that a second electrode of the second transistor formed subsequently (also the second electrode of the third transistor) is connected with the second region of the active pattern of the second transistor through the via.

In an exemplary implementation, an orthographic projection of the fifth via V5 on the base substrate is located within a range of an orthographic projection of a first region of the active pattern of the third transistor on the base substrate, the first insulation layer and the second insulation layer within the fifth via V5 are etched away to expose a surface of the first region of the active pattern of the third transistor, and the fifth via V5 is configured such that a first electrode of the third transistor formed subsequently is connected with the first region of the active pattern of the third transistor through the via.

In an exemplary embodiment, an orthographic projection of the sixth via V6 on the base substrate is located within a range of an orthographic projection of a second region of the active pattern of the third transistor on the base substrate. The first insulation layer and the second insulation layer within the sixth via V6 are etched away to expose a surface of the second region of the active pattern of the third transistor. The sixth via V6 is configured such that a second electrode of the second transistor formed subsequently (also the second electrode of the third transistor) is connected with the second region of the active pattern of the third transistor through the via.

In an exemplary embodiment, an orthographic projection of the seventh via V7 on the base substrate is located within a range of an orthographic projection of a first region of the active pattern of the fourth transistor (also the first region of the active pattern of the sixth transistor) on the base substrate. The first insulation layer and the second insulation layer within the seventh via V7 are etched away to expose a surface of the first region of the active pattern of the fourth transistor (also the first region of the active pattern of the sixth transistor). The seventh via V7 is configured such that a first electrode of the fourth transistor formed subsequently (also the first electrode of the sixth transistor) is connected with the first region of the active pattern of the fourth transistor (also the first region of the active pattern of the sixth transistor) through the via.

In an exemplary embodiment, an orthographic projection of the eighth via V8 on the base substrate is within a range of an orthographic projection of a second region of an active pattern of the fourth transistor (also a second region of an active pattern of the fifth transistor) on the base substrate. The first insulation layer and the second insulation layer within the eighth via V8 are etched away to expose a surface of the second region of the active pattern of the fourth transistor (also the second region of the active pattern of the fifth transistor). The eighth via V8 is configured such that a second electrode of the fourth transistor formed subsequently (also a second electrode of the fifth transistor) is connected with the second region of the active pattern of the fourth transistor (also the second region of the active pattern of the fifth transistor) through the via.

In an exemplary embodiment, an orthographic projection of the ninth via V9 on the base substrate is located within a range of an orthographic projection of a first region of the active pattern of the fifth transistor on the base substrate. The first insulation layer and the second insulation layer within the ninth via V9 are etched away to expose a surface of the second region of the active pattern of the fifth transistor. The ninth via V9 is configured such that a first electrode of the fifth transistor formed subsequently (also a first electrode of the tenth transistor) is connected with the first region of the active pattern of the fifth transistor through the via.

In an exemplary embodiment, an orthographic projection of the tenth via V10 on the base substrate is located within a range of an orthographic projection of the second region of the active pattern of the seventh transistor (also a first region of the active pattern of the eighth transistor) on the base substrate. The first insulation layer and the second insulation layer within the tenth via V10 are etched away to expose a surface of the second region of the active pattern of the seventh transistor (also the first region of the active pattern of the eighth transistor). The tenth via V10 is configured such that the second electrode of the first transistor formed subsequently (also a second electrode of the seventh transistor and a first electrode of the eighth transistor) is connected with the second region of the active pattern of the seventh transistor (also the first region of the active pattern of the eighth transistor) through the via.

In an exemplary embodiment, an orthographic projection of the eleventh via V11 on the base substrate is located within a range of an orthographic projection of the second region of the active pattern of the eighth transistor on the base substrate. The first insulation layer and the second insulation layer within the eleventh via V11 are etched away to expose a surface of the second region of the active pattern of the eighth transistor. The eleventh via V11 is configured such that a second electrode of the eighth transistor formed subsequently is connected with the second region of the active pattern of the eighth transistor through the via.

In an exemplary embodiment, an orthographic projection of the twelfth via V12 on the base substrate is located within a range of an orthographic projection of the first region of the active pattern of the ninth transistor on the base substrate. The first insulation layer and the second insulation layer within the twelfth via V12 are etched away to expose a surface of the first region of the active pattern of the ninth transistor. The twelfth via V12 is configured such that a first electrode of the ninth transistor formed subsequently is connected with the first region of the active pattern of the ninth transistor through the via.

In an exemplary embodiment, an orthographic projection of the thirteenth via V13 on the base substrate is located within a range of an orthographic projection of the second region of the active pattern of the ninth transistor (also a second region of the active pattern of the tenth transistor) on the base substrate. The first insulation layer and the second insulation layer within the thirteenth via V13 are etched away to expose a surface of the second region of the active pattern of the ninth transistor (also the second region of the active pattern of the tenth transistor). The thirteenth via V13 is configured such that a second electrode of the ninth transistor formed subsequently (also a second electrode of the tenth transistor) is connected with the second region of the active pattern of the ninth transistor (also the second region of the active pattern of the tenth transistor) through the via.

In an exemplary embodiment, an orthographic projection of the fourteenth via V14 on the base substrate is located within a range of an orthographic projection of the first region of the active pattern of the tenth transistor on the base substrate. The first insulation layer and the second insulation layer within the fourteenth via V14 are etched away to expose a surface of the first region of the active pattern of the tenth transistor. The fourteenth via V14 is configured such that a first electrode of the fifth transistor formed subsequently (also a first electrode of the tenth transistor) is connected with the first region of the active pattern of the tenth transistor through the via.

In an exemplary embodiment, an orthographic projection of the fifteenth via V15 on the base substrate is located within a range of an orthographic projection of the first region of the active pattern of the eleventh transistor on the base substrate. The first insulation layer and the second insulation layer within the fifteenth via V15 are etched away to expose a surface of the first region of the active pattern of the eleventh transistor. The fifteenth via V15 is configured such that a first electrode of the eleventh transistor subsequently formed is connected with the first region of the active pattern of the eleventh transistor through the via.

In an exemplary embodiment, an orthographic projection of the sixteenth via V16 on the base substrate is located within a range of an orthographic projection of the second region of the active pattern of the eleventh transistor on the base substrate. The first insulation layer and the second insulation layer within the sixteenth via V16 are etched away to expose a surface of the second region of the active pattern of the eleventh transistor. The sixteenth via V16 is configured such that a second electrode of the eleventh transistor formed subsequently is connected with a second region of the active pattern of the eleventh transistor through the via.

In an exemplary embodiment, an orthographic projection of the seventeenth via V17 on the base substrate is located within a range of an orthographic projection of the first region of the active pattern of the twelfth transistor on the base substrate. The first insulation layer and the second insulation layer within the seventeenth via V17 are etched away to expose a surface of the first region of the active pattern of the twelfth transistor. The seventeenth via V17 is configured such that a first electrode of the twelfth transistor formed subsequently is connected with the first region of the active pattern of the twelfth transistor through the via.

In an exemplary embodiment, an orthographic projection of the eighteenth via V18 on the base substrate is located within a range of an orthographic projection of the second region of the active pattern of the twelfth transistor on the base substrate. The first insulation layer and the second insulation layer within the eighteenth via V18 are etched away to expose a surface of the second region of the active pattern of the twelfth transistor. The eighteenth via V18 is configured such that a second electrode of the twelfth transistor formed subsequently is connected with the second region of the active pattern of the twelfth transistor through the via.

In an exemplary embodiment, an orthographic projection of the nineteenth via V19 on the base substrate is located within a range of an orthographic projection of the first region of the active pattern of the thirteenth transistor (also a second region of the active pattern of the fifteenth transistor) on the base substrate. The first insulation layer and the second insulation layer within the nineteenth via V19 are etched away to expose a surface of the first region of the active pattern of the thirteenth transistor (also the second region of the active pattern of the fifteenth transistor). The nineteenth via V19 is configured such that a first electrode of the thirteenth transistor formed subsequently (also a second electrode of the fifteenth transistor) is connected with the first region of the active pattern of the thirteenth transistor (also the second region of the active pattern of the fifteenth transistor) through the via.

In an exemplary embodiment, an orthographic projection of the twentieth via V20 on the base substrate is located within a range of an orthographic projection of the first region of the active pattern of the fourteenth transistor on the base substrate. The first insulation layer and the second insulation layer within the twentieth via V20 are etched away to expose a surface of the first region of the active pattern of the fourteenth transistor. The twentieth via V20 is configured such that the first electrode of the fourteenth transistor formed subsequently is connected with the first region of the active pattern of the fourteenth transistor through the via.

In an exemplary embodiment, an orthographic projection of the twenty-first via V21 on the base substrate is located within a range of an orthographic projection of the first region of the active pattern of the fifteenth transistor on the base substrate. The first insulation layer and the second insulation layer within the twenty-first via V21 are etched away to expose a surface of the first region of the active pattern of the fifteenth transistor. The twenty-first via V21 is configured such that the first electrode of the fifteenth transistor formed subsequently is connected with the first region of the active pattern of the fifteenth transistor through the via.

In an exemplary embodiment, an orthographic projection of the twenty-second via V22 on the base substrate is located within a range of an orthographic projection of the control electrode of the first transistor on the base substrate. The second insulation layer within the twenty-second via V22 is etched away to expose a surface of the control electrode of the first transistor. The twenty-second via V22 is configured such that a second connection electrode formed subsequently is connected with the control electrode of the first transistor through the via.

In an exemplary embodiment, an orthographic projection of the twenty-third via V23 on the base substrate is located within a range of an orthographic projection of the control electrode of the second transistor on the base substrate. The second insulation layer within the twenty-third via V23 is etched away to expose a surface of the control electrode of the second transistor. The twenty-third via V23 is configured such that a second electrode of the first transistor formed subsequently (also a second electrode of the seventh transistor and a first electrode of the eighth transistor) is connected with the control electrode of the second transistor through the via.

In an exemplary embodiment, an orthographic projection of the twenty-fourth via V24 on the base substrate is located within a range of an orthographic projection of the control electrode of the third transistor on the base substrate. The second insulation layer within the twenty-fourth via V24 is etched away to expose a surface of the control electrode of the third transistor. The twenty-fourth via V24 is configured such that the first electrode of the second transistor formed subsequently is connected with the control electrode of the third transistor through the via.

In an exemplary embodiment, an orthographic projection of the twenty-fifth via V25 on the base substrate is located within a range of an orthographic projection of the control electrode of the fourth transistor (also a control electrode of the sixth transistor and a first plate of the first capacitor) on the base substrate. The second insulation layer within the twenty-fifth via V25 is etched away to expose a surface of the control electrode of the fourth transistor (also the control electrode of the sixth transistor and the first plate of the first capacitor). The twenty-fifth via V25 is configured such that a third connection electrode and a first electrode of the eleventh transistor formed subsequently is connected with the control electrode of the fourth transistor (also a control electrode of the sixth transistor and a first plate of the first capacitor) through the via.

In an exemplary embodiment, an orthographic projection of the twenty-sixth via V26 on the base substrate is located within a range of an orthographic projection of the control electrode of the fifth transistor (a first plate of the second capacitor) on the base substrate. The second insulation layer within the twenty-sixth via V26 is etched away to expose a surface of the control electrode of the fifth transistor (the first plate of the second capacitor). The twenty-sixth via V26 is configured such that the second electrode of the eighth transistor and the first electrode of the twelfth transistor formed sequentially are connected with the control electrode (the first plate of the second capacitor) of the fifth transistor through the via.

In an exemplary embodiment, an orthographic projection of the twenty-seventh via V27 on the base substrate is located within a range of an orthographic projection of the control electrode of the seventh transistor on the base substrate. The second insulation layer within the twenty-seventh via V27 is etched away to expose a surface of the control electrode of the seventh transistor. The twenty-seventh via V27 is configured such that a fourth connection electrode and a first electrode of the fifth transistor are connected with the control electrode of the seventh transistor through the via.

In an exemplary embodiment, an orthographic projection of the twenty-eighth via V28 on the base substrate is located within a range of an orthographic projection of the control electrode of the eighth transistor on the base substrate. The second insulation layer within the twenty-eighth via V28 is etched away to expose a surface of the control electrode of the eighth transistor. The twenty-eighth via V28 is configured such that a fifth connection electrode formed subsequently is connected with the control electrode of the eighth transistor through the via.

In an exemplary embodiment, an orthographic projection of the twenty-ninth via V29 on the base substrate is located within a range of an orthographic projection of the control electrode of the ninth transistor (also the first plate of the fourth capacitor) on the base substrate, the second insulating layer within the twenty-ninth via V29 is etched away to expose a surface of the control electrode of the ninth transistor (also the first plate of the fourth capacitor), and the twenty-ninth via V29 is configured such that the second electrode of the eleventh transistor formed sequentially is connected with the control electrode of the ninth transistor (also the first plate of the fourth capacitor) through the via.

In an exemplary embodiment, an orthographic projection of the thirty via V30 on the base substrate is located within a range of an orthographic projection of the control electrode of the tenth transistor (also a first plate of the fifth capacitor and a first plate of the sixth capacitor) on the base substrate. The second insulation layer within the thirty via V30 is etched away to expose a surface of the control electrode of the tenth transistor (also the first plate of the fifth capacitor and the first plate of the sixth capacitor). The thirty via V30 is configured such that the second electrode of the twelfth transistor formed subsequently is connected with the control electrode of the tenth transistor (also a first plate of the fifth capacitor and a first plate of the sixth capacitor) through the via.

In an exemplary embodiment, an orthographic projection of the thirty-first via V31 on the base substrate is located within a range of an orthographic projection of the control electrode of the eleventh transistor (also a control electrode of the twelfth transistor) on the base substrate. The second insulation layer within the thirty-first via V31 is etched away to expose a surface of the control electrode of the eleventh transistor (also the control electrode of the twelfth transistor). The thirty-first via V31 is configured such that the first electrode of the thirteenth transistor (also the second electrode of the fifteenth transistor) formed subsequently is connected with the control electrode of the eleventh transistor (also a control electrode of the twelfth transistor) through the via.

In an exemplary embodiment, an orthographic projection of the thirty-second via V32 on the base substrate is located within a range of an orthographic projection of the control electrode of the thirteenth transistor on the base substrate. The second insulation layer within the thirty-second via V32 is etched away to expose a surface of the control electrode of the thirteenth transistor. The thirty-second via V32 is configured such that a sixth connection electrode formed subsequently is connected with the control electrode of the thirteenth through the via.

In the exemplary embodiment, an orthographic projection of the thirty-third via V33 on the base substrate is located within a range of an orthographic projection of the control electrode of the fourteenth transistor on the base substrate. The second insulation layer within the thirty-third via V33 is etched away to expose a surface of the control electrode of the fourteenth transistor. The thirty-third via V33 is configured such that a seventh connection electrode formed subsequently is connected with the control electrode of the fourteenth transistor through the via.

In an exemplary embodiment, an orthographic projection of the thirty-fourth via V34 on the base substrate is located within a range of an orthographic projection of the control electrode of the fifteenth transistor on the base substrate. The second insulation layer within the thirty-fourth via V34 is etched away to expose a surface of the control electrode of the fifteenth transistor. The thirty-fourth via V34 is configured such that a light-emitting connection line formed subsequently is connected with the control electrode of the fifteenth transistor through the via.

In an exemplary embodiment, an orthographic projection of the thirty-fifth via V35 on the base substrate is located within a range of an orthographic projection of the first plate of the third capacitor on the base substrate. The second insulation layer within the thirty-fifth via V35 is etched away to expose a surface of the first plate of the third transistor. The thirty-fifth via V35 is configured such that a first electrode of the fourth transistor (also a first electrode of the sixth transistor) formed subsequently is connected with the first plate of the third capacitor through the via.

In an exemplary embodiment, an orthographic projection of the thirty-sixth via V36 on the base substrate is located within a range of an orthographic projection of the second plate of the first capacitor on the base substrate. The thirty-sixth via V36 exposes a surface of the second plate of the first capacitor. The thirty-sixth via V36 is configured such that the first electrode of the fourth transistor formed subsequently (also the first electrode of the sixth transistor) is connected with the second plate of the first capacitor through the via.

In an exemplary embodiment, an orthographic projection of the thirty-seventh via V37 on the base substrate is located within a range of an orthographic projection of the second plate of the second capacitor (also a second plate of the third capacitor) on the base substrate. The thirty-seventh via V37 exposes a surface of the second plate of the second capacitor (also the second plate of the third capacitor). The thirty-seventh via V37 is configured such that the second electrode of the fourth transistor formed subsequently (also a second electrode of the fifth transistor) is connected with the second plate of the second capacitor (also the second plate of the third capacitor) through the via.

In an exemplary embodiment, an orthographic projection of the thirty-eighth via V38 on the base substrate is located within a range of an orthographic projection of the second plate of the fourth capacitor on the base substrate. The thirty-eighth via V38 exposes a surface of the second plate of the fourth capacitor. The thirty-eighth via V38 is configured such that the first electrode of the ninth transistor formed subsequently is connected with the second plate of the fourth capacitor through the via.

In an exemplary embodiment, an orthographic projection of the thirty-ninth via V39 on the base substrate is located within a range of an orthographic projection of the second plate of the fifth capacitor on the base substrate. The thirty-ninth via V39 exposes a surface of the second plate of the fifth capacitor. The thirty-ninth via V39 is configured such that the second electrode of the ninth transistor formed subsequently (also the second electrode of the tenth transistor) is connected with the second plate of the fifth capacitor through the via.

In an exemplary embodiment, an orthographic projection of the forty via V40 on the base substrate is located within a range of an orthographic projection of the second plate of the sixth capacitor on the base substrate. The forty via V40 exposes a surface of the second plate of the sixth capacitor. The forty via V40 is configured such that the first electrode of the thirteenth transistor formed subsequently (also the second electrode of the fifteenth transistor) is connected with the second plate of the sixth capacitor through the via.

In an exemplary embodiment, an orthographic projection of the forty-first via V41 on the base substrate is located within a range of an orthographic projection of the first connection electrode on the base substrate. The forty-first via V41 exposes a surface of the first connection electrode. The forty-first via V41 is configured such that a second electrode of the second transistor formed subsequently (also a second electrode of the third transistor) is connected with the first connection electrode through the via.

In an exemplary embodiment, an orthographic projection of the forty-second via V42 on the base substrate is located within a range of an orthographic projection of the first cross-stage connection portion of one of the plurality of cross-stage connection lines on the base substrate. The forty-second via V42 exposes a surface of the first cross-stage connection portion of one of the plurality of cross-stage connection lines. The forty-second via V42 is configured such that the second cross-stage connection portion of one of the plurality of cross-stage connection lines formed subsequently is connected with the first cross-stage connection portion of one of the plurality of cross-stage connection lines through the via.

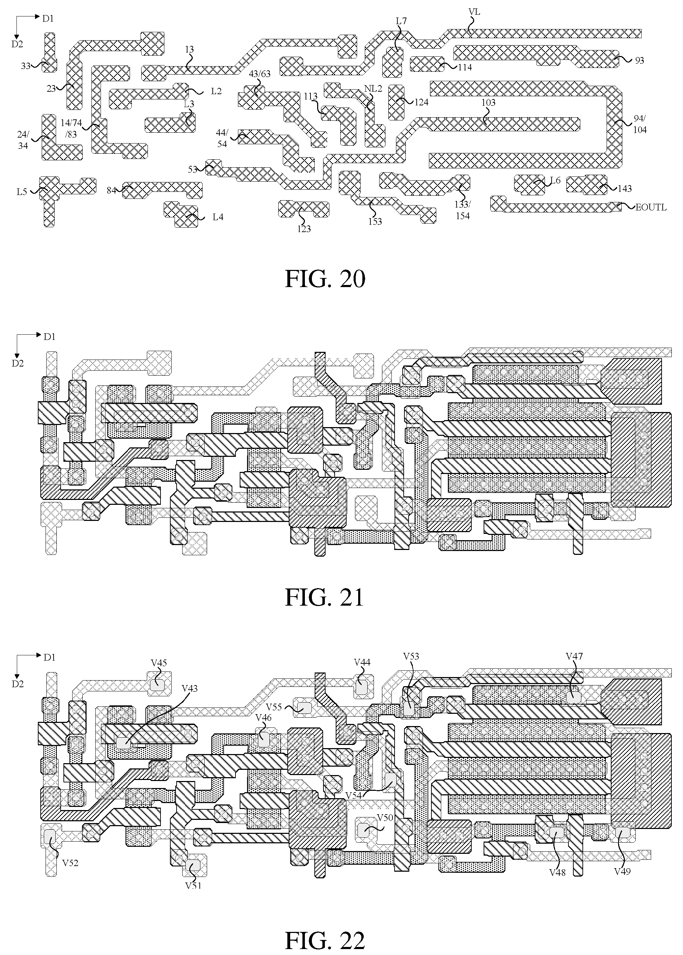

(5) Forming a pattern of a third conductive layer. In an exemplary embodiment, forming the pattern of the third conductive layer may include: depositing a third conductive thin film on the base substrate on which the aforementioned patterns are formed, and patterning the third conductive thin film by a patterning process to form the third conductive layer disposed on the fifth insulating layer, as shown in FIGS. 20 and 21. FIG. 20 is a schematic diagram of a pattern of a third conductive layer in FIG. 12, and FIG. 21 is a schematic diagram after the pattern of the third conductive layer is formed in FIG. 12. In an exemplary implementation, the third conductive layer may be referred to as a first source drain metal (SD1) layer.

In an exemplary embodiment, as shown in FIGS. 20 and 21, the pattern of the third conductive layer may at least include: a first electrode 13 and a second electrode 14 of the first transistor to a first electrode 153 and a second electrode 154 of the fifteenth transistor located in at least one-stage first shift register, a second connection electrode L2 to a sixth connection electrode L6, a power supply connection line VL, a light emitting connection line EOUTL, and the second cross-stage connection portion NL2 of at least one of the plurality of cross-stage connection lines.

In an exemplary embodiment, the first electrode 13 of the first transistor is disposed separately. The first electrode 13 of the first transistor has a shape of a strip and extends at least partially in the first direction D1. The first electrode 13 of the first transistor is connected with the first region of the active pattern of the first transistor through the first via V.

In an exemplary embodiment, the second electrode 14 of the first transistor, the second electrode 74 of the seventh transistor, and the first electrode 83 of the eighth transistor are of an integral structure, and the integral structure of the second electrode 14 of the first transistor, the second electrode 74 of the seventh transistor, and the first electrode 83 of the eighth transistor has an "n" shape with an opening facing the display area. The second electrode 14 of the first transistor (also the second electrode 74 of the seventh transistor and the first electrode 83 of the eighth transistor) is connected with the second region of the active pattern of the first transistor through the second via, is connected with the second region of the active pattern of the seventh transistor (also the first region of the active pattern of the eighth transistor) through the tenth via, and is connected with the control electrode of the second transistor through the twenty-third via.

In an exemplary implementation, the first electrode 23 of the second transistor is disposed separately. The first electrode 23 of the second transistor has a "┌" shape. The first electrode 23 of the second transistor is connected to the first region of the active pattern of the second transistor through the third via, and is connected with the control electrode of the third transistor through the twenty-fourth via.

In an exemplary embodiment, the second electrode 24 of the second transistor and the second electrode 34 of the third transistor are of integral structure. The integral structure of the second electrode 24 of the second transistor and the second electrode 34 of the third transistor has an "L" shape. The second electrode 24 of the second transistor (also the second electrode 34 of the third transistor) is connected with the second region of the active pattern of the second transistor through the fourth via, is connected with the second region of the active pattern of the third transistor through the sixth via, and is connected with the first connection electrode through the forty-first via.

In an exemplary implementation, the first electrode 33 of the third transistor is disposed separately. The first electrode 33 of the third transistor has a strip shape and extends along the second direction D2. The first electrode 33 of the third transistor is connected with the first region of the active pattern of the third transistor through the fifth via.

In an exemplary embodiment, the first electrode 43 of the fourth transistor and the first electrode 63 of the sixth transistor are of integral structure. The integral structure of the first electrode 43 of the fourth transistor and the first electrode 63 of the sixth transistor has a bend line shape and extends at least partially in the first direction D1. The first electrode 43 of the fourth transistor (also the first electrode 63 of the sixth transistor) is connected with the first region of the active pattern of the fourth transistor (also the first region of the active pattern of the sixth transistor) through the seventh via, is connected with the first plate of the third capacitor through the thirty-fifth via, and is connected with the second plate of the first capacitor through the thirty-sixth via.

In an exemplary embodiment, the second electrode 44 of the fourth transistor and the second electrode 54 of the fifth transistor are of an integral structure. The integral structure of the second electrode 44 of the fourth transistor and the second electrode 54 of the fifth transistor has a bend line shape and extends at least partially in the first direction D1. The second electrode 44 of the fourth transistor (also the second electrode 54 of the fifth transistor) is connected with the second region of the active pattern of the fourth transistor (also the second region of the active pattern of the fifth transistor) through the eighth via, and is connected with the second plate of the second capacitor (also the second plate of the third capacitor) through the thirty-seventh via.

In an exemplary embodiment, the first electrode 53 of the fifth transistor and the first electrode 103 of the tenth transistor are of integral structure. The integral structure of the first electrode 53 of the fifth transistor and the first electrode 103 of the tenth transistor has a bend line shape and extends at least partially in the first direction D1. The first electrode 53 of the fifth transistor (also the first electrode 103 of the tenth transistor) is connected with the first region of the active pattern of the fifth transistor through the ninth via, is connected with the first region of the active pattern of the tenth transistor through the fourteenth via, and is connected with the control electrode of the seventh transistor through the twenty-seventh via.

In an exemplary embodiment, the second electrode 84 of the eighth transistor is disposed separately. The second electrode 84 of the eighth transistor has a strip shape and extends along the first direction D1. The second electrode 84 of the eighth transistor is connected with the second region of the active pattern of the eighth transistor through the eleventh via, and is connected with the control electrode of the fifth transistor (the first plate of the second capacitor) through the twenty-sixth via.

In an exemplary embodiment, the first electrode 93 of the ninth transistor is disposed separately. The first electrode 93 of the ninth transistor has a strip shape and extends along the first direction D1. The first electrode 93 of the ninth transistor is connected with the first region of the active pattern of the ninth transistor through the twelfth via, and is connected with the second plate of the fourth capacitor through the thirty-eighth via.

In an exemplary implementation, the second electrode 94 of the ninth transistor and the first electrode 104 of the tenth transistor are of an integral structure. The integral structure of the second electrode 94 of the ninth transistor and the first electrode 104 of the tenth transistor has an "n" shape with an opening facing away from the display area. The second electrode 94 of the ninth transistor (also the second electrode 104 of the tenth transistor) is connected with the second region of the active pattern of the ninth transistor (also the second region of the active pattern of the tenth transistor) through the thirteenth via, and is connected with the second plate of the fifth transistor through the thirty-ninth via.

In an exemplary embodiment, the first electrode 113 of the eleventh transistor is disposed separately. The first electrode 113 of the eleventh transistor has a "┐" shape. The first electrode 113 of the eleventh transistor is connected with the first region of the active pattern of the eleventh transistor through the fifteenth via, and is connected with the control electrode of the fourth transistor (also the control electrode of the sixth transistor and the first plate of the first capacitor) through the twenty-fifth via.

In an exemplary embodiment, the second electrode 114 of the eleventh transistor is disposed separately. The second electrode 114 of the eleventh transistor has a strip shape and extends along the first direction D1. The second electrode 114 of the eleventh transistor is connected with the second region of the active pattern of the eleventh transistor through the sixteenth via.

In an exemplary embodiment, the first electrode 123 of the twelfth transistor is disposed separately. The first electrode 123 of the twelfth transistor has a strip shape and extends along the first direction D1. The first electrode 123 of the twelfth transistor is connected with the first region of the active pattern of the twelfth transistor through the seventeenth via, is connected with the control electrode of the fifth transistor (the first plate of the second capacitor) through the twenty-sixth via, and is connected with the control electrode of the ninth transistor (also the first plate of the fourth capacitor) through the twenty-ninth via.

In an exemplary embodiment, the second electrode 124 of the twelfth transistor is disposed separately. The second electrode 124 of the twelfth transistor has a strip shape and extends along the second direction D2. The second electrode 124 of the twelfth transistor is connected with the second region of the active pattern of the twelfth transistor through the eighteenth via, and is connected with the control electrode of the tenth transistor (also the first plate of the fifth capacitor and the first plate of the sixth capacitor) through the thirty via.

In an exemplary embodiment, the first electrode 133 of the thirteenth transistor and the second electrode 154 of the fifteenth transistor are of an integral structure. The integral structure of the first electrode 133 of the thirteenth transistor and the second electrode 154 of the fifteenth transistor has a strip shape and extends along the first direction D1. The first electrode 133 of the thirteenth transistor (also the second electrode 154 of the fifteenth transistor) is connected with the first region of the active pattern of the thirteenth transistor (also the second region of the active pattern of the fifteenth transistor) through the nineteenth via, is connected with the control electrode of the eleventh transistor (also the control electrode of the twelfth transistor) through the thirty-first via, and is connected with the second plate of the sixth capacitor through the fortieth via.

In an exemplary embodiment, the first electrode 143 of the fourteenth transistor is disposed separately. The first electrode 143 of the fourteenth transistor has a strip shape and extends along the first direction D1. The first electrode 143 of the fourteenth transistor is connected with the first region of the active pattern of the fourteenth transistor through the twentieth via.

In an exemplary embodiment, the first electrode 153 of the fifteenth transistor is disposed separately. The first electrode 153 of the fifteenth transistor has a strip shape and extends along the first direction D1. The first electrode 153 of the fifteenth transistor is connected with the first region of the active pattern of the fifteenth transistor through the twenty-first via.

In an exemplary embodiment, the second connection electrode L2 is provided separately. The second connection electrode L2 has a strip shape and extends along the first direction D1. The second connection electrode L2 is connected with the control electrode of the first transistor through the twenty-second via.

In an exemplary embodiment, the third connection electrode L3 is provided separately. The third connection electrode L3 has a strip shape and extends along the first direction D1. The third connection electrode L3 is connected with the control electrode of the fourth transistor (also the control electrode of the sixth transistor and the first plate of the first capacitor) through the twenty-fifth via, and is connected with the first connection electrode through the forty-first via.

In an exemplary embodiment, the fourth connection electrode L4 is provided separately. The fourth connection electrode L4 has a strip shape and extends along the first direction D1. The fourth connection electrode L4 is connected with the control electrode of the seventh transistor through the twenty-seventh via.

In an exemplary embodiment, the fifth connection electrode L5 is provided separately. The fifth connection electrode L5 has a "┌" shape. The fifth connection electrode L5 is connected with the control electrode of the eighth transistor through the twenty-eighth via.

In an exemplary embodiment, the sixth connection electrode L6 is provided separately. The sixth connection electrode L6 has a strip shape and extends along the first direction D1. The sixth connection electrode L6 is connected with the control electrode of the thirteenth transistor through the thirty-second via.

In an exemplary embodiment, the seventh connection electrode L7 is provided separately. The seventh connection electrode L7 has a strip shape and extends along the second direction D2. The seventh connection electrode L7 is connected with the control electrode of the fourteenth transistor through the thirty-third via.

In an exemplary embodiment, the light emitting connection line EOUTL at least partially extends along the first direction D1. The light emitting connection line EOUTL is connected with the control electrode of the fifteenth transistor through the thirty-fourth via.

In an exemplary embodiment, the second cross-stage connection portion NL2 of one of the plurality of cross-stage connection lines has a bend line shape, and is bent along a direction away from the display area. The second cross-stage connection portion NL2 of one of the plurality of cross-stage connection lines extends at least partially along the second direction D2. The second cross-stage connection portion NL2 of one of the plurality of cross-stage connection lines is connected with the first cross-stage connection portion through the forty-second via.

In an exemplary embodiment, the power supply connection line VL at least partially extends along the first direction D1.

(6) Forming a pattern of a fourth insulation layer. In an exemplary implementation, forming the pattern of the fourth insulation layer may include: depositing a fourth insulation thin film on the base substrate on which the aforementioned patterns are formed, coating a planar thin film, and patterning the fourth insulation thin film and the planar thin film by a patterning process to form the fourth insulation layer covering the aforementioned structure and a planarization layer disposed on the fourth insulation layer, wherein the planarization layer is provided with a plurality of via patterns, as shown in Fig. 22. Fig. 22 is a schematic diagram after the pattern of the planarization layer is formed in Fig. 12.

In an exemplary embodiment, as shown in Fig. 22, the pattern of the planarization layer may at least include the forty-third via V43 to the fifty-fifth via V55 located in at least one-stage first shift register.

In an exemplary embodiment, an orthographic projection of the forty-third via V43 on the base substrate is located within a range of an orthographic projection of the second connection electrode on the base substrate. The fourth insulation layer within the forty-third via V43 is etched away to expose a surface of the second connection electrode. The forty-third via V43 is configured such that one of the clock signal lines of the clock signal line group formed subsequently is connected with the second connection electrode through the via. One of the clock signal lines of the clock signal line group is connected with the control electrode of the first transistor through the second connection electrode.

In an exemplary embodiment, an orthographic projection of the forty-fourth via V44 on the base substrate is located within a range of an orthographic projection of the first electrode of the first transistor on the base substrate. The fourth insulation layer within the forty-fourth via V44 is etched away to expose a surface of the first electrode of the first transistor. The forty-fourth via V44 is configured such that the third cross-stage connection portion of one of the plurality of cross-stage connection lines formed subsequently is connected with the first electrode of the first transistor through the via.

In an exemplary embodiment, an orthographic projection of the forty-fifth via V45 on the base substrate is located within a range of an orthographic projection of the first electrode of the second transistor on the base substrate. The fourth insulation layer within the forty-fifth via V45 is etched away to expose a surface of the first electrode of the second transistor. The forty-fifth via V45 is configured such that one of the clock signal lines of the clock signal line group formed subsequently is connected with the first electrode of the second transistor through the via.

In an exemplary embodiment, an orthographic projection of the forty-sixth via V46 on the base substrate is located within a range of an orthographic projection of the first electrode of the fourth transistor (also the first electrode of the sixth transistor) on the base substrate. The fourth insulation layer within the forty-sixth via V46 is etched away to expose a surface of the first electrode of the fourth transistor (also the first electrode of the sixth transistor). The forty-sixth via V46 is configured such that the first first power supply line formed subsequently is connected with the first electrode of the fourth transistor (also the first electrode of the sixth transistor) through the via.

In an exemplary embodiment, an orthographic projection of the forty-seventh via V47 on the base substrate is located within a range of an orthographic projection of the first electrode of the ninth transistor on the base substrate. The fourth insulation layer within the forty-seventh via V47 is etched away to expose a surface of the first electrode of the ninth electrode. The forty-seventh via V47 is configured such that the second first power supply line formed subsequently is connected with the first electrode of the ninth transistor through the via.

In an exemplary embodiment, an orthographic projection of the forty-eighth via V48 on the base substrate is located within a range of an orthographic projection of the sixth connection electrode on the base substrate. The fourth insulation layer within the forty-eighth via V48 is etched away to expose a surface of the sixth connection electrode. The forty-eighth via V48 is configured such that the third cross-stage connection portion of at least one of the plurality of cross-stage connection lines is electrically connected with the sixth connection electrode through the via. The third cross-stage connection portion of at least one of the plurality of cross-stage connection lines is electrically connected with the control electrode of the thirteenth transistor through the sixth connection electrode.

In an exemplary embodiment, an orthographic projection of the forty-ninth via V49 on the base substrate is located within a range of an orthographic projection of the first electrode of the fourteenth transistor on the base substrate. The fourth insulation layer within the forty-ninth via V49 is etched away to expose a surface of the first electrode of the fourteenth transistor. The forty-ninth via V49 is configured such that the masking signal line formed subsequently is connected with the first electrode of the fourteenth transistor through the via.

In an exemplary embodiment, an orthographic projection of the fiftieth via V50 on the base substrate is located within a range of an orthographic projection of the first electrode of the fifteenth transistor on the base substrate. The fourth insulation layer within the fiftieth via V50 is etched away to expose a surface of the first electrode of the fifteenth transistor. The fiftieth via V50 is configured that the second second power supply line formed subsequently is connected with the first electrode of the fifteenth transistor through the via.

In an exemplary embodiment, an orthographic projection of the fifty-first via V51 on the base substrate is located within a range of an orthographic projection of the fourth connection electrode on the base substrate. The fourth insulation layer within the fifty-first via V51 is etched away to expose a surface of the fourth connection electrode. The fifty-first via V51 is configured such that one of the clock signal lines of the clock signal line group formed subsequently is connected with the fourth connection electrode through the via. One of the clock signal lines of the clock signal line group is connected with the control electrode of the seventh transistor through the fourth connection electrode.

In an exemplary embodiment, an orthographic projection of the fifty-second via V52 on the base substrate is located within a range of an orthographic projection of the fifth connection electrode on the base substrate. The fourth insulation layer within the fifty-second via V52 is etched away to expose a surface of the fifth connection electrode. The fifty-second via V52 is configured such that the first second power supply line formed subsequently is connected with the fifth connection electrode through the via. The first second power supply line is connected with the control electrode of the eighth transistor through the fifth connection electrode.

In an exemplary embodiment, the fifth connection electrode of the nth stage first shift register is the same electrode as the first electrode of the third transistor of the( n+1)-th stage first shift register.

In an exemplary embodiment, an orthographic projection of the fifty-third via V53 on the base substrate is located within a range of an orthographic projection of the seventh connection electrode on the base substrate. The fourth insulation layer within the fifty-third via V53 is etched away to expose a surface of the seventh connection electrode. The fifty-third via V53 is configured such that the third cross-stage connection portion of at least one of the plurality of cross-stage connection lines formed subsequently is connected with the seventh connection electrode through the via. The third cross-stage connection portion of at least one of the plurality of cross-stage connection lines is connected with the control electrode of the fourteenth transistor through the seventh connection electrode.

In an exemplary embodiment, an orthographic projection of the fifty-fourth via V54 on the base substrate is located within a range of an orthographic projection of the second cross-stage connection portion of at least one of the plurality of cross-stage connection lines on the base substrate. The fourth insulation layer within the fifty-fourth via V54 is etched away to expose a surface of the second cross-stage connection portion of the at least one of the plurality of cross-stage connection lines. The fifty-fourth via V54 is configured such that the third cross-stage connection portion of at least one of the plurality of cross-stage connection lines formed subsequently is connected with the second cross-stage connection portion of at least one of the plurality of cross-stage connection lines through the via.

In an exemplary embodiment, an orthographic projection of the forty-fifth via V55 on the base substrate is located within a range of an orthographic projection of the power supply connection line on the base substrate. The fourth insulation layer within the fifty-fifth via V55 is etched away to expose a surface of the power supply connection line. The fifty-fifth via V55 is configured such that the third power supply line formed subsequently is connected with the power supply connection line through the via.

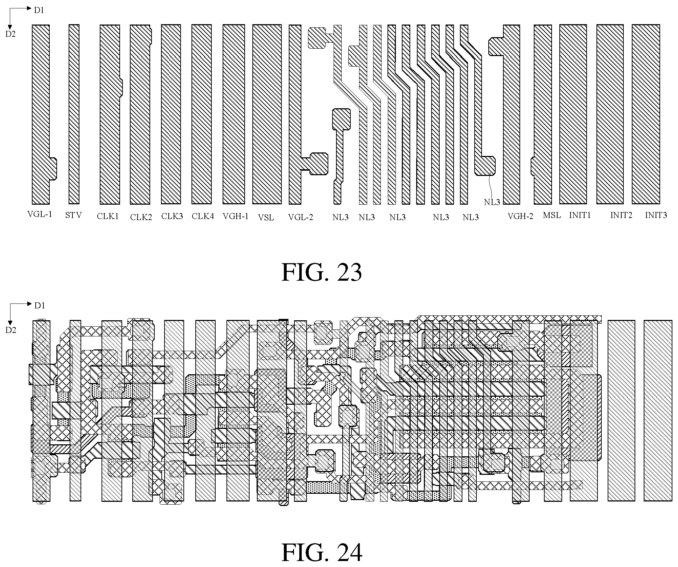

(7) Forming a pattern of a fourth conductive layer. In an exemplary embodiment, forming the pattern of the fourth conductive layer may include: depositing a fourth conductive thin film on the base substrate on which the aforementioned patterns are formed, and patterning the fourth conductive thin film by a patterning process to form the fourth conductive layer disposed on the fourth insulation layer, as shown in FIGS. 23 and 24. FIG. 23 is a schematic diagram of the pattern of the fourth insulation layer in FIG. 12, and FIG. 24 is a schematic diagram after the pattern of the fourth insulation layer is formed in FIG. 12. In an exemplary implementation, the fourth conductive layer may be referred to as a second source-drain metal (SD2) layer.

In an exemplary embodiment, as illustrated in FIGS. 22 to 24, the pattern of the fourth conductive layer may at least include: an initial signal line STV1, the masking signal line MSL, the first clock signal line CLK1, the second clock signal line CLK2, the third clock signal line CLK3, the fourth clock signal line CLK4, the first first power supply line VGH-1, the second first power supply line VGH-2, the first second power supply line VGL-1, the second second power supply line VGL-2, the third power supply line VSL, the third cross-stage connection portion NL3 of at least one of the plurality of cross-stage connection lines, the first initial signal line INIT1, the second initial signal line INIT2 and the third initial signal line INIT3.

In an exemplary embodiment, at least one signal line of the initial signal line STV1, the masking signal line MSL, the first clock signal line CLK1, the second clock signal line CLK2, the third clock signal line CLK3, the fourth clock signal line CLK4, the first first power supply line VGH-1, the second first power supply line VGH-2, the first second power supply line VGL-1, the second second power supply line VGL-2, the third power supply line VSL, the third cross-stage connection portion NL3 of at least one of the plurality of cross-stage connection lines, the first initial signal line INIT1, the second initial signal line INIT2, and the third initial signal line INIT3 extends at least partially along the second direction D2.

In an exemplary embodiment, the first second power supply line VGL-1, the initial signal line STV, the first clock signal line CLK1, the second clock signal line CLK2, the third clock signal line CLK3, the fourth clock signal line CLK4, the first first power supply line VGH-1, the third power supply line VSL, the second second power supply line VGL-2, the second first power supply line VGH-2, the masking signal line MSL, the first initial signal line INIT1, the second initial signal line INIT2, and the third initial signal line INIT3 are arranged sequentially along the direction close to the display area.

In an exemplary embodiment, the third cross-stage connection portion NL3 of at least one of the plurality of cross-stage connection lines is located between the second second power supply line VGL-2 and the second first power supply line VGH-2.

In an exemplary embodiment, one of the first clock signal line CLK1, the second clock signal line CLK2, the third clock signal line CLK3, and the fourth clock signal line CLK4 is connected with the second connection electrode through the forty-third via.

In an exemplary embodiment, one of the first clock signal line CLK1, the second clock signal line CLK2, the third clock signal line CLK3, and the fourth clock signal line CLK4 is connected with the first electrode of the second transistor through the forty-fifth via.

In an exemplary embodiment, one of the first clock signal line CLK1, the second clock signal line CLK2, the third clock signal line CLK3, and the fourth clock signal line CLK4 is connected with the control electrode of the seventh transistor through the fifty-first via.

In an exemplary embodiment, the third cross-stage connection portion NL3 of one of the plurality of cross-stage connection lines is connected with the first electrode of the first transistor through the forty-fourth via, is connected with the sixth connection electrode through the forty-eighth via, is connected with the seventh connection electrode through the fifty-third via, and is connected with the second cross-stage connection portion through the fifty-fourth via.

In an exemplary embodiment, the first first power supply line VGH-1 is connected with the first electrode of the fourth transistor (also the first electrode of the sixth transistor) through the forty-sixth via.

In an exemplary embodiment, the second first power supply line VGH-2 is connected with the first electrode of the ninth transistor through the forty-seventh via.

In an exemplary embodiment, the masking signal line MSL is connected with the first electrode of the fourteenth transistor through the forty-ninth via.

In an exemplary embodiment, the first second power supply line VGL-1 is connected with the fifth connection electrode through the fifty-second via.

In an exemplary embodiment, the second second power supply line VGL-2 is connected with the first electrode of the fifteenth transistor through the fiftieth via.

In an exemplary embodiment, the third power supply line VSL is connected with the power supply connection line through the fifty-fifth via.

In an exemplary embodiment, the arrangement of the first connection portion to the seventh connecting portion can reduce depths of vias in the display substrate, improving reliability of the display substrate.

In an exemplary embodiment, the initial signal line STV1, the masking signal line MSL, the first clock signal line CLK1, the second clock signal line CLK2, the third clock signal line CLK3, the fourth clock signal line CLK4, the first first power supply line VGH-1, the second first power supply line VGH-2, the first second power supply line VGL-1, the second second power supply line VGL-2, the third power supply line VSL, the third cross-stage connection portion NL3 of at least one of the plurality of cross-stage connection lines, the first initial signal line INIT1, the second initial signal line INIT2, and the first initial signal line INIT3 may be designed with an equal length along the first direction or with a non-equal length along the first direction, or may be a straight line, or may be a bend line, which not only can facilitate the layout of the shift register and also can reduce the parasitic capacitance between signal lines. The present disclosure is not limited thereto.

So far, a drive circuit layer has been manufactured on the substrate. In a plane parallel to the display substrate, the drive circuit layer may include a plurality of shift registers. In a plane perpendicular to the display substrate, the drive circuit layer may be disposed on the base substrate.

In a first display substrate, the drive circuit layer may include the semiconductor layer, the first insulation layer, the first conductive layer, the second insulation layer, the second conductive layer, the third insulation layer, the third conductive layer, the fourth insulation layer, the planarization layer, and the fourth conductive layer that are sequentially disposed on the base substrate.

In an exemplary implementation, the base substrate may be a rigid base substrate or a flexible base substrate, wherein the rigid base substrate may be, but is not limited to, one or more of glass and metal foil; the flexible base substrate may be, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fiber.

In an exemplary implementation, the flexible substrate may include a first flexible material layer, a first inorganic material layer, a semiconductor layer, a second flexible material layer, and a second inorganic material layer which are stacked. Materials of the first flexible material layer and the second flexible material layer may be Polyimide (PI), Polyethylene Terephthalate (PET), or a surface-treated polymer soft film, etc., and materials of the first inorganic material layer and the second inorganic material layer may be Silicon Nitride (SiNx), Silicon Oxide (SiOx), or the like, for improving water and oxygen resistance of the substrate. The first inorganic material layer and the second inorganic material layer may also be referred to as striprier layers, and a material of the semiconductor layer may be amorphous silicon (a-si). In an exemplary implementation, taking a stacked structure of PI1/Barrier1/a-si/PI2/Barrier2 as an example, its manufacturing process may include: first coating a layer of polyimide on a glass carrier board, after the layer of polyimide is cured to form a film, a first flexible (PI1) layer is formed; then depositing a layer of barrier thin film on the first flexible layer to form a first barrier (Barrier 1) layer overlaying the first flexible layer; then depositing a layer of amorphous silicon thin film on the first barrier layer to form an amorphous silicon (a-si) layer covering the first barrier layer; then coating another layer of polyimide on the amorphous silicon layer, after this layer of polyimide is cured to form a film, a second flexible (PI2) layer is formed; and then depositing a layer of barrier thin film on the second flexible layer to form a second barrier (Barrier 2) layer covering the second flexible layer, so as to complete manufacturing of the base substrate.

In an exemplary implementation, the semiconductor layer may be an amorphous silicon layer, a polysilicon layer, or may be a metal oxide layer. Here, the metal oxide layer may be an oxide including indium and tin, an oxide including tungsten and indium, an oxide including tungsten, indium, and zinc, an oxide including titanium and indium, an oxide including titanium, indium, and tin, an oxide including indium and zinc, an oxide including silicon, indium, and tin, or an oxide including indium or gallium and zinc. The metal oxide layer may be a single layer, a double-layer, or a multi-layer.

In an exemplary implementation, the first conductive layer, the second conductive layer, the third conductive layer, and the fourth conductive layer may be made of a metal material, such as any one or more of Argentum (Ag), Copper (Cu), Aluminum (Al), and Molybdenum (Mo), or an alloy material of the above metals, such as an Aluminum Neodymium alloy (AlNd) or a Molybdenum Niobium alloy (MoNb), and may be of a single-layer structure or a multi-layer composite structure, such as Mo/Cu/Mo.

In an exemplary implementation, the first insulation layer, the second insulation layer, the third insulation layer, and the fourth insulation layer may be made of any one or more of Silicon Oxide (SiOx), Silicon Nitride (SiNx), and Silicon Oxynitride (SiON), and may be a single layer, a multi-layer, or a composite layer.

In an exemplary implementation, after preparation of the driving circuit layer is completed, a light emitting structure layer is prepared on the driving circuit layer, and a preparation process of the light emitting structure layer may include following operations.

Depositing an anode conductive thin film on the base substrate on which the above-mentioned patterns are formed, patterning the anode conductive thin film through a patterning process to form a pattern of an anode conductive layer disposed on the second planarization layer, depositing a pixel definition thin film on the base substrate on which the above-mentioned patterns are formed, patterning the pixel definition thin film through a patterning process to form a pattern of a pixel definition layer exposing the pattern of the anode conductive layer, coating an organic light emitting material on the base substrate on which the pattern of the pixel definition layer is formed, patterning the organic light emitting material through a patterning process to form a pattern of an organic structure layer, depositing a cathode conductive thin film on the base substrate on which the pattern of the organic structure layer is formed, and patterning the cathode conductive thin film through a patterning process to form a cathode conductive layer.

So far, the light emitting structure layer has been manufactured on the base substrate.

In an exemplary implementation, the anode conductive layer includes, at least, patterns of a plurality of anodes. The patterns of the plurality of anodes may include an anode of a first light emitting device, an anode of a second light emitting device, an anode of a third light emitting device, and an anode of a fourth light emitting device, wherein the anode of the first light emitting device is located at a red sub-pixel emitting red light, the anode of the second light emitting device may be located at a blue sub-pixel emitting blue light, the anode of the third light emitting device may be located at a first green sub-pixel emitting green light, and the anode of the fourth light emitting device may be located at a second green sub-pixel emitting green light.

In an exemplary implementation, the anode of the first light emitting device and the anode of the second light emitting device may be alternately disposed in the first direction, and the anode of the third light emitting device and the anode of the fourth light emitting device may be alternately disposed in the first direction. Alternatively, the anode of the first light emitting device and the anode of the second light emitting device may be alternately disposed in the second direction, and the anode of the third light emitting device and the anode of the fourth light emitting device may be alternately disposed in the second direction.

In an exemplary implementation, four sub-pixels in one pixel unit may have a same anode shape and a same area, or may have different anode shapes and different areas.

In an exemplary implementation, the anode conductive layer may be of a single-layer structure, such as Indium Tin Oxide (ITO) or Indium Zinc Oxide (IZO), or may be of a multi-layer composite structure, such as ITO/Ag/ITO.

In an exemplary implementation, the organic structure layer may at least include: an organic emitting layer of a light emitting device.

In an exemplary implementation, the cathode conductive layer may include, at least, cathodes of a plurality of light emitting devices.

In an exemplary implementation, the cathode layer may be made of a metal material, such as any one or more of Argentum (Ag), Copper (Cu), Aluminum (Al), and Molybdenum (Mo), or alloy materials of the above conductive materials, such as an Aluminum Neodymium alloy (AlNd) or a Molybdenum Niobium alloy (MoNb), and may have a single-layer structure or a multi-layer composite structure, such as Mo/Cu/Mo. Exemplarily, the fourth conductive layer may be of a three-layer stacked structure formed of titanium, aluminum, and titanium.

The display substrate according to the embodiment of the present disclosure may be applied to a display product with any resolution.

In an exemplary implementation, a subsequent manufacturing process may include forming an encapsulation structure layer on the cathode conductive layer, and the encapsulation structure layer may include a first encapsulation layer, a second encapsulation layer, and a third encapsulation layer which are stacked. The first encapsulation layer and the third encapsulation layer may be made of an inorganic material, the second encapsulation layer may be made of an organic material, and the second encapsulation layer is disposed between the first encapsulation layer and the third encapsulation layer, which may ensure that external water vapor cannot enter the light emitting structure layer.

A display apparatus is further provided in an embodiment of the present disclosure, which may include a display substrate.

The display substrate is the display substrate according to any of the aforementioned embodiments, and has similar implementation principles and implementation effects, which will not be repeated here.

In an exemplary implementation, the display apparatus may be any product or component with a display function, such as a wearable device, a mobile phone, a tablet computer, a television, a display, a laptop computer, a digital photo frame, and a navigator.

The drawings of the embodiments of the present disclosure only involve structures involved in the embodiments of the present disclosure, and other structures may refer to a general design.

For the sake of clarity, a thickness and size of a layer or a micro structure are enlarged in the accompanying drawings used for describing the embodiments of the present disclosure. It may be understood that when an element such as a layer, film, region, or substrate is described as being "on" or "under" another element, the element may be "directly" located "on" or "under" the another element, or there may be an intermediate element.

Although implementations of the present disclosure are disclosed above, contents described are only implementations used for ease of understanding of the present disclosure, but not intended to limit the present disclosure. Any of those skilled in the art of the present disclosure can make any modifications and variations in the implementation and details without departing from the spirit and scope of the present disclosure. However, the protection scope of the present disclosure should be subject to the scope defined by the appended claims.

## Claims

1. A shift register, comprising: a shift sub-circuit and an output sub-circuit; wherein:
the shift sub-circuit is electrically connected to a signal input terminal, a first clock signal terminal, a second clock signal terminal, a third clock signal terminal, a first power supply terminal, a second power supply terminal, a cascaded signal output terminal, a second node and a third node, respectively, and is configured to provide a signal of one signal terminal of the second power supply terminal and the second clock signal terminal to the second node and to provide a signal of the signal input terminal to the third node under control of a signal of at least one signal terminal of the signal input terminal, the first clock signal terminal, the second clock signal terminal and the third clock signal terminal, and to provide a signal of one signal terminal of the first power supply terminal and the third clock signal terminal to the cascaded signal output terminal under control of signals of the second node and the third node; and
the output sub-circuit is electrically connected to the second node, the third node, the signal input terminal, a first control signal terminal, a second control signal terminal, a masking signal terminal, the third clock signal terminal, the first power supply terminal, the second power supply terminal and a drive signal output terminal, respectively, and is configured to provide a signal of one signal terminal of the first power supply terminal and the third clock signal terminal to the drive signal output terminal under control of a signal of at least one signal terminal of the second node, the third node, the first control signal terminal, the second control signal terminal, the signal input terminal and the masking signal terminal.

2. The shift register according to claim 1, wherein a quantity of the shift registers is multiple, and the multiple shift registers are cascaded;
the cascaded signal output terminal of at least one-stage shift register is electrically connected to the signal input terminal of at least one-stage shift register and the first control signal terminal of at least one-stage shift register, respectively; and
the shift register where the signal input terminal, connected to the cascaded signal output terminal of the at least one-stage shift register, is located and the shift register where the first control signal terminal, connected to the cascaded signal output terminal of the at least one-stage shift register, is located are shift registers of different stages.

3. The shift register according to claim 1 or 2, wherein the shift sub-circuit comprises: a first transistor to an eighth transistor and a first capacitor to a third capacitor, and at least one of the first capacitor to the third capacitor comprises: a first plate and a second plate;
a control electrode of the first transistor is electrically connected with the first clock signal terminal, a first electrode of the first transistor is electrically connected with the signal input terminal, and a second electrode of the first transistor is electrically connected with a first node;
a control electrode of the second transistor is electrically connected with the first node, a first electrode of the second transistor is electrically connected with the second clock signal terminal, and a second electrode of the second transistor is electrically connected with the second node;
a control electrode of the third transistor is electrically connected with the second clock signal terminal, a first electrode of the third transistor is electrically connected with the second power supply terminal, and a second electrode of the third transistor is electrically connected with the second node;
a control electrode of the fourth transistor is electrically connected with the second node, a first electrode of the fourth transistor is electrically connected with the first power supply terminal, and a second electrode of the fourth transistor is electrically connected with the cascaded signal output terminal;
a control electrode of the fifth transistor is electrically connected with the third node, a first electrode of the fifth transistor is electrically connected with the third clock signal terminal, and a second electrode of the fifth transistor is electrically connected with the cascaded signal output terminal;
a control electrode of the sixth transistor is electrically connected with the second node, a first electrode of the sixth transistor is electrically connected with the first power supply terminal, and a second electrode of the sixth transistor is electrically connected with a fourth node;
a control electrode of the seventh transistor is electrically connected with the third clock signal terminal, a first electrode of the seventh transistor is electrically connected with the fourth node, and a second electrode of the seventh transistor is electrically connected with the first node;
a control electrode of the eighth transistor is electrically connected with the second power supply terminal, a first electrode of the eighth transistor is electrically connected with the first node, and a second electrode of the eighth transistor is electrically connected with the third node;
the first plate of the first capacitor is electrically connected to the second node, and the second plate of the first capacitor is electrically connected to the first power supply terminal;
the first plate of the second capacitor is electrically connected with the third node, and the second plate of the second capacitor is electrically connected with the cascaded signal output terminal; and
the first plate of the third capacitor is electrically connected with the first power supply terminal, and the second plate of the third capacitor is electrically connected with the cascaded signal output terminal.

4. The shift register according to claim 1, wherein the output sub-circuit comprises: a node control sub-circuit and an output control sub-circuit, wherein
the node control sub-circuit is electrically connected to the second node, the third node, a fifth node, a sixth node, the signal input terminal, the masking signal terminal, the first control signal terminal, the second control signal terminal and the second power supply terminal, respectively, and is configured to provide a signal of the second node to the fifth node and a signal of the third node to the sixth node under control of a signal of at least one signal terminal of the first control signal terminal, the second control signal terminal, the signal input terminal, the masking signal terminal and the second power supply terminal; and
the output control sub-circuit is electrically connected to the fifth node, the sixth node, the first power supply terminal, the third clock signal terminal and the drive signal output terminal, respectively, and is configured to provide a signal of the first power supply terminal to the drive signal output terminal under control of a signal of the fifth node, and provide a signal of the third clock signal terminal to the drive signal output terminal under control of a signal of the sixth node.

5. The shift register according to claim 4, wherein
the output control sub-circuit comprises: a ninth transistor, a tenth transistor, a fourth capacitor, a fifth capacitor and a sixth capacitor, at least one of the fourth capacitor to the sixth capacitor comprising: a first plate and a second plate;
a control electrode of the ninth transistor is electrically connected with the fifth node, a first electrode of the ninth transistor is electrically connected with the first power supply terminal, and a second electrode of the ninth transistor is electrically connected with the drive signal output terminal;
a control electrode of the tenth transistor is electrically connected with the sixth node, a first electrode of the tenth transistor is electrically connected with the third clock signal terminal, and a second electrode of the tenth transistor is electrically connected with the drive signal output terminal;
the first plate of the fourth capacitor is electrically connected with the fifth node, and the second plate of the fourth capacitor is electrically connected with the first power supply terminal;
the first plate of the fifth capacitor is electrically connected with the sixth node, and the second plate of the fifth capacitor is electrically connected with the drive signal output terminal; and
the first plate of the sixth capacitor is electrically connected with the sixth node, and the second plate of the sixth capacitor is electrically connected with a seventh node.

6. The shift register according to claim 4, wherein the node control sub-circuit comprises: an eleventh transistor to a fifteenth transistor, wherein
a control electrode of the eleventh transistor is electrically connected with a seventh node, a first electrode of the eleventh transistor is electrically connected with the second node, and a second electrode of the eleventh transistor is electrically connected with the fifth node;
a control electrode of the twelfth transistor is electrically connected with the seventh node, a first electrode of the twelfth transistor is electrically connected with the third node, and a second electrode of the twelfth transistor is electrically connected with the sixth node;
a control electrode of the thirteenth transistor is electrically connected with the first control signal terminal, a first electrode of the thirteenth transistor is electrically connected with the seventh node, and a second electrode of the thirteenth transistor is electrically connected with a eighth node;
a control electrode of the fourteenth transistor is electrically connected with the signal input terminal, a first electrode of the fourteenth transistor is electrically connected with the masking signal terminal, and a second electrode of the fourteenth transistor is electrically connected with the eighth node; and
a control electrode of the fifteenth transistor is electrically connected with the second control signal terminal, a first electrode of the fifteenth transistor is electrically connected with the second power supply terminal, and a second electrode of the fifteenth transistor is electrically connected with the seventh node.

7. A display substrate, comprising: a display area and a non-display area surrounding at least one side of the display area, wherein the display substrate comprises: a first gate drive circuit located in the non-display area, the first gate drive circuit comprises: a plurality of cascaded first shift registers, and a first shift register is the shift register of any one of claims 1 to 6.

8. The display substrate according to claim 7, wherein at least one-stage first shift register of the plurality of cascaded first shift registers comprises: a second capacitor and a third capacitor, the second capacitor and the third capacitor respectively comprising: a first plate and a second plate; and
the second plate of the second capacitor and the second plate of the third capacitor of the at least one-stage first shift register are a same plate.

9. The display substrate according to claim 7, wherein the cascaded signal output terminal of an nth stage first shift register is electrically connected to the signal input terminal of an (n+X)-th stage first shift register and the first control signal terminal of an (n+Y)-th stage first shift register, respectively, 1≤n≤N, N is a total quantity of stages of the first shift registers, and X<Y.

10. The display substrate according to claim 9, further comprising: a plurality of cross-stage connection lines located in the non-display area, wherein
a cross-stage connection line of the plurality of cross-stage connection lines is electrically connected to the cascaded signal output terminal of at least one-stage first shift register, the signal input terminal of at least one-stage shift register, and the first control signal terminal of at least one-stage first shift register, respectively; and
at least two of the shift registers among the shift register where the cascaded signal output terminal connected with a same cross-stage connection line is located, the shift register where the signal input terminal connected with a same cross-stage connection line is located and the shift register where the first control signal terminal connected with a same cross-stage connection line is located are shift registers of different stages.

11. The display substrate according to claim 10, wherein the cross-stage connection line comprises: a first cross-stage connection portion, a second cross-stage connection portion, and a third cross-stage connection portion, wherein at least one of the first cross-stage connection portion, the second cross-stage connection portion and the third cross-stage connection portion at least partially extends along a second direction; and
the second cross-stage connection portion is electrically connected to the first cross-stage connection portion and the third cross-stage connection portion, respectively, and at least two of the first cross-stage connection portion, the second cross-stage connection portion, and the third cross-stage connection portion are disposed in different layers.

12. The display substrate according to claim 11, wherein at least one-stage first shift register comprises: a first transistor, a thirteenth transistor, a fourteenth transistor, a second capacitor and a third capacitor, the second capacitor and the third capacitor respectively comprising: a first plate and a second plate, wherein a first electrode of the first transistor and a control electrode of the fourteenth transistor are electrically connected with the signal input terminal of the first shift register, respectively, a control electrode of the thirteenth transistor is electrically connected with the first control signal terminal of the first shift register, and the second plate of the second capacitor and the second plate of the third capacitor are electrically connected with the cascaded signal output terminal of the first shift register, respectively; and
for the cross-stage connection line electrically connected to the cascaded signal output terminal of the nth stage first shift register and the signal output terminal of the (n+X)-th stage first shift register and connected to the first control signal terminal of an (n+Y)-th stage first shift register, the first cross-stage connection portion is electrically connected to the second plate of the second capacitor and the second plate of the third capacitor of the nth stage first shift register, and the second cross-stage connection portion, respectively, and the third cross-stage connection portion is electrically connected to a first electrode of the first transistor and a control electrode of the fourteenth transistor of the (n+X)-th stage first shift register, a control electrode of the thirteenth transistor of the (n+Y)-th stage first shift register, and the second cross-stage connection portion, respectively.

13. The display substrate according to claim 11 or 12, wherein at least one-stage first shift register of the plurality of cascaded first shift registers comprises: a second capacitor comprising a first plate and a second plate; and
for the cross-stage connection line connected to the cascaded signal output terminal of the nth stage first shift register, the first cross-stage connection portion and the second plate of the second capacitor of the nth stage first shift register are of an integral structure.

14. The display substrate according to claim 11, further comprising: a base substrate and a drive circuit layer disposed on the base substrate, wherein the first gate drive circuit is disposed on the drive circuit layer, the drive circuit layer comprising: a semiconductor layer, a first conductive layer, a second conductive layer, a third conductive layer and a fourth conductive layer sequentially stacked on the base substrate, the at least one-stage first shift register comprising: at least one transistor and at least one capacitor, the at least one transistor comprising: an active pattern, a control electrode, a first electrode and a second electrode, and the at least one capacitor comprising:
a first plate and a second plate;
the semiconductor layer comprises: the active pattern of the at least one transistor located in the at least one-stage first shift register;
the first conductive layer comprises: the control electrode of the at least one transistor and the first plate of the at least one capacitor located in the at least one-stage first shift register;
the second conductive layer comprises: the second plate of the at least one capacitor located in the at least one-stage first shift register and a first cross-stage connection portion of at least one of the plurality of cross-stage connection lines;
the third conductive layer comprises: the first electrode and the second electrode of the at least one transistor located in the at least one-stage first shift register and a second cross-stage connection portion of at least one of the plurality of cross-stage connection lines; and
the fourth conductive layer comprises: a third cross-stage connection portion of at least one of the plurality of cross-stage connection lines.

15. The display substrate according to claim 14, wherein at least one first shift register comprises: a first transistor, an eleventh transistor, a fourteenth transistor, and a fifteenth transistor;
an orthographic projection of the first cross-stage connection portion of the at least one of the plurality of cross-stage connection lines on the base substrate at least partially overlaps with an orthographic projection of the first electrode of the first transistor of the at least one-stage first shift register on the base substrate;
an orthographic projection of the second cross-stage connection portion of the at least one of the plurality of cross-stage connection lines on the base substrate at least partially overlaps with an orthographic projection of the control electrode of the eleventh transistor of the at least one-stage first shift register on the base substrate; and
an orthographic projection of the third cross-stage connection portion of the at least one of the plurality of cross-stage connection lines on the base substrate at least partially overlaps with an orthographic projection of the control electrode of at least one of the thirteenth transistor and the fourteenth transistor of the at least one-stage first shift register on the base substrate.

16. The display substrate according to claim 14, further comprising: a clock signal line group located in the non-display area, wherein the clock signal line group is disposed on the drive circuit layer and located in the fourth conductive layer;
the plurality of cross-stage connection lines are located on a side of the clock signal line group close to the display area; and
the clock signal line group comprises: a first clock signal line, a second clock signal line, a third clock signal line, and a fourth clock signal line arranged sequentially at a side close to the display area, and at least one signal line of the first clock signal line, the second clock signal line, the third clock signal line, and the fourth clock signal line at least partially extends along the second direction.

17. The display substrate according to claim 16, wherein a first clock signal terminal of a (4i-3)-th stage first shift register is electrically connected with the first clock signal line, a second clock signal terminal of the (4i-3)-th stage first shift register is electrically connected with the second clock signal line, a third clock signal terminal of the (4i-3)-th stage first shift register is electrically connected with the third clock signal line, a first clock signal terminal of a (4i-2)-th stage first shift register is electrically connected with the second clock signal line, a second clock signal terminal of the (4i-2)-th stage first shift register is electrically connected with the third clock signal line, and a third clock signal terminal of the (4i-2)-th stage first shift register is electrically connected with the fourth clock signal line, a first clock signal terminal of a (4i-1)-th stage first shift register is electrically connected with the third clock signal line, a second clock signal terminal of the (4i-1)-th stage first shift register is electrically connected with the fourth clock signal line, and a third clock signal terminal of the (4i-1)-th stage first shift register is electrically connected with the first clock signal line, a first clock signal terminal of a 4i-th stage first shift register is electrically connected with the fourth clock signal line, a second clock signal terminal of the 4i-th stage first shift register is electrically connected with the first clock signal line, and a third clock signal terminal of the 4i-th stage first shift register is electrically connected with the second clock signal line.

18. The display substrate according to claim 16, wherein the at least one-stage first shift register comprises: a first transistor, a second transistor, a sixth transistor, a seventh transistor, and an eighth transistor; and
an orthographic projection of the clock signal line group on the base substrate at least partially overlaps with an orthographic projection of at least one of the first transistor, the second transistor, the sixth transistor, the seventh transistor, and the eighth transistor of the at least one-stage first shift register on the base substrate.

19. The display substrate according to claim 14, further comprising: a power supply signal line group and a clock signal line group located in the non-display area, wherein the power supply signal line group and the clock signal line group are disposed on the drive circuit layer and located in the fourth conductive layer;
the power supply signal line group comprises: two first power supply lines and two second power supply lines, the first power supply lines and the second power supply lines at least partially extending along the second direction;
a first second power supply line is located on a side of the clock signal line group away from the display area, a first first power supply line is located on a side of the clock signal line group close to the display area, a second second power supply line is located on a side of the first first power supply line close to the display area, a second first power supply line is located on a side of the second second power supply line close to the display area, and the plurality of cross-stage connection lines are located between the second second power supply line and the second first power supply line; and
the first power supply lines are electrically connected to a first power supply terminal of at least one-stage first shift register, and the second power supply lines are electrically connected to a second power supply terminal of at least one-stage first shift register.

20. The display substrate according to claim 19, wherein the at least one-stage first shift register comprises: a third transistor, a fourth transistor, a fifth transistor, a ninth transistor, a tenth transistor, and a third capacitor; and
an orthographic projection of the first first power supply line on the base substrate at least partially overlaps with orthographic projections of the fourth transistor and the fifth transistor of the at least one-stage first shift register on the base substrate, an orthographic projection of the first second power supply line on the base substrate at least partially overlaps with an orthographic projection of the third transistor of the at least one-stage first shift register on the base substrate, an orthographic projection of the second first power supply line on the base substrate at least partially overlaps with orthographic projections of the ninth transistor and the tenth transistor of the at least one-stage first shift register on the base substrate, and an orthographic projection of the second second power supply line on the base substrate at least partially overlaps with an orthographic projection of the third capacitor of the at least one-stage first shift register on the base substrate.

21. The display substrate according to claim 19, further comprising: a scan initial signal line located in the non-display area, wherein the scan initial signal line is disposed on the drive circuit layer and located in the fourth conductive layer, the scan initial signal line at least partially extends along the second direction;
the scan initial signal line is located between the first second power supply line and the clock signal line group;
a signal input terminal of a first stage first shift register and a signal input terminal of a second stage first shift register are electrically connected with the scan initial signal line, respectively;
the at least one-stage first shift register comprises: a second transistor; and
an orthographic projection of the scan initial signal line on the base substrate at least partially overlaps with an orthographic projection of the second transistor of the at least one-stage first shift register on the base substrate.

22. The display substrate according to claim 19, wherein the power supply signal line group further comprises a third power supply line at least partially extending along the second direction;
the third power supply line is located between the first first power supply line and the second second power supply line;
the display area is provided with a light-emitting device, and the third power supply line is electrically connected with a second electrode of at least one light-emitting device;
the at least one-stage first shift register comprises: a first capacitor and a second capacitor;
an orthographic projection of the third power supply line on the base substrate at least partially overlaps with orthographic projections of the first capacitor and the second capacitor of the at least one-stage first shift register on the base substrate; and
a length of the third power supply line along a first direction is greater than a length of at least one of the first power supply line and the second power supply line along the first direction.

23. The display substrate according to claim 19, further comprising: a masking signal line located in the non-display area, wherein the masking signal line is disposed on the drive circuit layer and located in the fourth conductive layer, the masking signal line at least partially extends along the second direction;
the masking signal line is located on a side of the power supply signal line group close to the display area;
the masking signal line is electrically connected with the masking signal terminal of at least one-stage first shift register;
the at least one-stage first shift register comprises: a fourth capacitor and a fifth capacitor; and an orthographic projection of the masking signal line on the base substrate at least partially overlaps with orthographic projections of the fourth capacitor and the fifth capacitor of the at least one-stage first shift register on the base substrate.

24. The display substrate according to claim 23, further comprising: a plurality of pixel initial signal lines located in the non-display area; at least one signal line of the plurality of pixel initial signal lines is disposed on the drive circuit layer and is located in the fourth conductive layer, and the at least one signal line of the plurality of pixel initial signal lines at least partially extends along the second direction;
the plurality of pixel initial signal lines are located on a side of the masking signal line close to the display area;
an orthographic projection of one of the plurality of pixel initial signal lines on the base substrate at least partially overlaps with orthographic projections of the fourth capacitor and the fifth capacitor of the at least one-stage first shift register on the base substrate; and
a length of at least one signal line of the plurality of pixel initial signal lines along a first direction is greater than a length of the masking signal line along the first direction.

25. The display substrate according to claim 7, further comprising: a second gate drive circuit located in the non-display area, wherein the second gate drive circuit comprises: a plurality of cascaded second shift registers, and the second shift register comprises: a light-emitting signal output terminal;
the display area is provided with a plurality of pixel drive circuits, the pixel drive circuit comprising: a light-emitting transistor and a write transistor;
at least one-stage first shift register is electrically connected with the write transistor of at least one row of pixel drive circuits, and at least one-stage second shift register is electrically connected with the light-emitting transistor of at least one row of pixel drive circuits; and
a second control signal terminal of at least one-stage first shift register is electrically connected with a light-emitting signal output terminal of at least one-stage second shift register.

26. A display apparatus, comprising: the display substrate according to any one of claims 7 to 25.

27. A drive method of a shift register, configured to drive the shift register according to any one of claims 1 to 6, wherein the method comprises:
providing, by the shift sub-circuit, the signal of one signal terminal of the second power supply terminal and the second clock signal terminal to the second node and the signal of the signal input terminal to the third node under control of the signal of at least one signal terminal of the signal input terminal, the first clock signal terminal, the second clock signal terminal and the third clock signal terminal, and providing the signal of one signal terminal of the first power supply terminal and the third clock signal terminal to the cascaded signal output terminal under control of the signals of the second node and the third node; and
providing, by the output sub-circuit, the signal of one signal terminal of the first power supply terminal and the third clock signal terminal to the drive signal output terminal under control of the signal of at least one signal terminal of the second node, the third node, the first control signal terminal, the second control signal terminal, the signal input terminal and the masking signal terminal.
